# EUROPÄISCHE PATENTSCHRIFT

(11) **EP 1 716 597 B1**
(45) Veröffentlichungstag und Bekanntmachung des Hinweises auf die Patenterteilung: **04.04.2018**
(21) Anmeldenummer: 05706767.0
(22) Anmeldetag: 18.02.2005
(51) Int. Cl.: H01L 27/15, H01L 27/14, H01L 31/0224, H01L 33/00

(54) **OPTOELEKTRONISCHES BAUELEMENT, VORRICHTUNG MIT EINER MEHRZAHL OPTOELEKTRONISCHER BAUELEMENTE UND VERFAHREN ZUR HERSTELLUNG EINES OPTOELEKTRONISCHEN BAUELEMENTS**
OPTOELECTRONIC COMPONENT, DEVICE COMPRISING A PLURALITY OF OPTOELECTRONIC COMPONENTS, AND METHOD FOR THE PRODUCTION OF AN OPTOELECTRONIC COMPONENT
ELEMENT OPTOELECTRONIQUE, DISPOSITIF POURVU D'UNE PLURALITE D'ELEMENTS OPTOELECTRONIQUES ET PROCEDE POUR REALISER UN ELEMENT OPTOELECTRONIQUE

(30) Priorität: 20.02.2004 DE 102004008853
(43) Veröffentlichungstag der Anmeldung: 02.11.2006
(73) Patentinhaber: OSRAM Opto Semiconductors GmbH, 93055 Regensburg (DE)
(72) Erfinder: WIRTH, Ralf, 93186 Pettendorf-Adlersberg (DE); BRUNNER, Herbert, 93161 Sinzing (DE); ILLEK, Stefan, 93093 Donaustauf (DE); EISSLER, Dieter, 93152 Nittendorf/Etterzhausen (DE)
(74) Vertreter: Epping - Hermann - Fischer
(86) Internationale Anmeldenummer: PCT/DE2005/000281
(87) Internationale Veröffentlichungsnummer: WO 2005/081319

(56) Entgegenhaltungen:
- WO-A-03/044872
- JP-A- H03 177 080
- US-A1- 2004 012 958
- US-B1- 6 278 136
- US-E- R E36 747

## Beschreibung

Die Erfindung betrifft ein optoelektronisches Bauelement gemäß dem Oberbegriff des Patentanspruchs 1, eine Vorrichtung gemäß dem Oberbegriff des Patentanspruchs 16 und ein Verfahren gemäß dem Oberbegriff des Patentanspruchs 21.

Bei der Herstellung herkömmlicher optoelektronischer Bauelemente dieser Art sind in der Regel Einzelbearbeitungsschritte nötig, wie beispielsweise das Anordnen des Halbleiterfunktionsbereichs oder eines den Halbleiterfunktionsbereich umfassenden Halbleiterchips in einem Gehäuse, das Kontaktieren des Halbleiterchips mit externen Anschlüssen über Bonddrähte oder das Umspritzen des Halbleiterchips mit einer schützenden Umhüllung. Einzelbearbeitungsschritte sind in der Regel verglichen mit Bearbeitungsschritten, die gleichzeitig an einer Vielzahl von Elementen durchgeführt werden können, kostenintensiv.

Die Halbleiterfunktionsbereiche können beispielsweise im Waferverbund, der eine auf einer Trägerschicht angeordnete Halbleiterschichtenfolge umfasst, aus der Halbleiterschichtenfolge ausgebildet werden. Danach wird der Waferverbund gewöhnlich in Halbleiterchips vereinzelt, die in Einzelbearbeitungsschritten für optoelektronischen Bauelementen weiterverarbeitet werden können.

Weiterhin wird bei herkömmlichen Bauelementen die Ausbildung sehr flacher Strukturen oftmals durch die Kontaktierung des Halbleiterfunktionsbereichs mittels eines Bonddrahts erschwert. Der Bogen des Bonddrahts ist oftmals relativ hoch und kann die Höhe eines optoelektronischen Bauelements wesentlich mitbestimmen. Auch ein getrennt vom Halbleiterfunktionsbereich ausgebildetes Gehäuse, dessen räumliche Ausmaße oftmals wesentlich größer als die des Halbleiterfunktionsbereichs sind, kann die Ausbildung kleiner optoelektronischer Bauelemente erschweren.

Eine Aufgabe der Erfindung ist es, ein optoelektronisches Bauelement und eine Vorrichtung mit einer Mehrzahl optoelektronischer Bauelemente, die vereinfacht und kostengünstig herstellbar sind, sowie ein vereinfachtes Herstellungsverfahren für optoelektronische Bauelemente anzugeben.

Diese Aufgabe wird erfindungsgemäß durch ein optoelektronisches Bauelement mit den Merkmalen des Patentanspruchs 1, eine Vorrichtung mit den Merkmalen des Patentanspruchs 16, sowie ein Verfahren zur Herstellung eines optoelektronischen Bauelements mit den Merkmalen des Patentanspruchs 21 gelöst. Vorteilhafte Weiterbildungen der Erfindung sind Gegenstand der abhängigen Ansprüche.

Die Druckschrift WO 03/044872 A beschreibt ein lichtemittierendes Verbindungshalbleiter-Bauteil.

Die Druckschrift US 6278136 B1 beschreibt ein lichtemittierendes Element mit mehreren Halbleiterschichten, die auf einem Substrat angeordnet sind.

Die Druckschrift US R E36747 E beschreibt eine lichtemittierende Diode.

Die Druckschrift US 2004/0012958 A1 beschreibt ein lichtemittierendes Bauteil mit einem LED-Chip und einer elektrisch leitenden Platte.

Ein erfindungsgemäßes optoelektronisches Bauelement umfasst gemäß einer ersten Ausführungsform einen Halbleiterfunktionsbereich mit einer aktiven Zone und einer lateralen Haupterstreckungsrichtung, wobei der Halbleiterfunktionsbereich zumindest einen Durchbruch durch die aktive Zone aufweist und im Bereich des Durchbruchs ein Verbindungsleitermaterial angeordnet ist, das von der aktiven Zone zumindest in einem Teilbereich des Durchbruchs elektrisch isoliert ist.

Nach einer weiteren Ausführungsform der Erfindung umfasst das optoelektronische Bauelement einen Halbleiterfunktionsbereich mit einer aktiven Zone und einer lateralen Haupterstreckungsrichtung, wobei der Halbleiterfunktionsbereich eine laterale, die aktive Zone begrenzende Seitenfläche aufweist und der Seitenfläche in lateraler Richtung nachgeordnet ein Verbindungsleitermaterial angeordnet ist, das von der aktiven Zone zumindest in einem Teilbereich der Seitenfläche elektrisch isoliert ist. Die Seitenfläche kann gegebenenfalls den Halbleiterfunktionsbereich lateral begrenzen. Die Seitenfläche kann den Halbleiterfunktionsbereich insbesondere teilweise in lateraler Richtung begrenzen. Weiterhin kann die Seitenfläche eben, das heißt im wesentlichen frei von einer Ein- oder Ausbuchtung, insbesondere einer Vertiefung in lateraler Richtung, ausgeführt sein.

Vorzugsweise ist dem Halbleiterfunktionsbereich eine Schicht aus einer Formmasse nachgeordnet, die freitragend bzw. mechanisch tragfähig ausgebildet sein kann. Diese Formmassenschicht kann weitergehend in Form einer Umhüllung, eines Verkapselungselements oder einer Stabilisationsschicht ausgebildet sein, wie im folgenden noch genauer erläutert wird.

Ein erfindungsgemäßes Bauelement kann mit Vorteil weitestgehend oder vollständig im Waferverbund hergestellt werden. Die Anzahl vergleichsweise kostenintensiver und/oder aufwendiger Einzelbearbeitungsschritte kann bei einem erfindungsgemäßen optoelektronischen Bauelement mit Vorteil reduziert werden. Mit besonderem Vorteil können Einzelbearbeitungsschritte vermieden werden.

Als Waferverbund wird im Rahmen der Erfindung eine während der Herstellung des optoelektronischen Bauelements auf einer Trägerschicht angeordnete Halbleiterschichtenfolge angesehen, die für die Ausbildung einer Mehrzahl von Halbleiterfunktionsbereichen vorgesehen ist. Die Halbleiterfunktionsbereiche werden während der Herstellung des Bauelements zumindest teilweise im Verbund auf der Trägerschicht aus Bereichen der Halbleiterschichtenfolge gebildet. Die Trägerschicht kann durch ein Aufwachssubstrat, auf dem die Halbleiterschichtenfolge, beispielsweise epitaktisch hergestellt wurde, gebildet werden oder ein solches umfassen.

Es sei angemerkt, dass als Durchbruch im Rahmen der Erfindung auch ein während der Herstellung des optoelektronischen Bauelements im Waferverbund in der Halbleiterschichtenfolge erzeugter Durchbruch durch die aktive Zone angesehen werden kann.

Insbesondere eine Kontaktstruktur, die der elektrischen Kontaktierung des fertigen optoelektronischen Bauelements dient, kann zumindest teilweise, vorzugsweise vollständig, bereits im Waferverbund hergestellt werden. Die Kontaktierung des optoelektronischen Bauelements erfolgt mit Vorzug zumindest teilweise über das elektrisch leitende Verbindungsleitermaterial, das bereits im Waferverbund im Bereich des Durchbruchs durch die aktive Zone angeordnet werden kann. Das Verbindungsleitermaterial enthält beispielsweise ein Metall, wie Au, Al, Ag, Ti, Pt, Sn oder eine Legierung mit mindestens einem dieser Materialien.

In einer bevorzugten Ausgestaltung der Erfindung ist das Verbindungsleitermaterial in lateraler Richtung, insbesondere im Bereich der aktiven Zone, vom Halbleiterfunktionsbereich beabstandet, wodurch die Gefahr eines Kurzschlusses im Betrieb des Bauelements verringert wird. Das Verbindungsleitermaterial kann hierzu in einem, insbesondere lateralen, Randbereich des Halbleiterfunktionsbereichs angeordnet und/oder von der Seitenfläche beabstandet sein.

In einer weiteren bevorzugten Ausgestaltung der Erfindung weist der Halbleiterfunktionsbereich zumindest eine Vertiefung in lateraler Richtung auf, die besonders bevorzugt den Durchbruch durch die aktive Zone zumindest teilweise umschließt.

Der Durchbruch kann bei der Erfindung insbesondere in Form einer den Halbleiterfunktionsbereich nicht vollständig durchdringenden Ausnehmung oder den Halbleiterfunktionsbereich vollständig durchdringenden Aussparung ausgebildet sein, wobei die Ausnehmung oder die Aussparung den Durchbruch durch die aktive Zone zumindest teilweise, vorzugsweise vollständig, umschließen oder bilden können.

Der Durchbruch erstreckt sich bevorzugt im wesentlichen senkrecht zur lateralen Haupterstreckungsrichtung des Halbleiterfunktionsbereichs in vertikaler Richtung durch den gesamten Halbleiterfunktionsbereich. Beispielsweise ist der Durchbruch hierzu als Aussparung im Halbleiterfunktionsbereich ausgebildet.

Das Verbindungsleitermaterial ist bevorzugt zumindest teilweise durch ein Isolationsmaterial elektrisch von der aktiven Zone isoliert. Das Isolationsmaterial ist vorzugsweise im Bereich des Durchbruchs bzw. der Seitenfläche, insbesondere direkt, an der aktiven Zone angeordnet und enthält beispielsweise ein Siliziumnitrid, wie SiN oder Si₃N₄, ein Siliziumoxid, wie SiO oder SiO₂, oder ein Siliziumoxinitrid, wie SiON.

Das Isolationsmaterial kleidet den Durchbruch, insbesondere die Vertiefung, vorzugsweise derart aus bzw. das Isolationsmaterial ist vorzugsweise, insbesondere direkt, derart an der Seitenfläche angeordnet, dass die aktive Zone durch das Isolationsmaterial elektrisch von dem Verbindungsleitermaterial isoliert ist. Die Gefahr eines Kurzschlusses der aktiven Zone über das Verbindungsleitermaterial kann so verringert werden.

Besonders bevorzugt ist zumindest annähernd die gesamte Wand des Durchbruchs mit dem Isolationsmaterial ausgekleidet bzw. zumindest annähernd die gesamte Seitenfläche mit dem Isolationsmaterial überzogen, so dass die Gefahr eines Kurzschlusses im Betrieb des Bauelements weitergehend verringert wird.

Weiterhin ist das Verbindungsleitermaterial vorzugsweise wenigstens über annähernd den gesamten vertikalen Verlauf des Halbleiterfunktionsbereichs angeordnet, was die Ausbildung der Kontaktstruktur bei der Herstellung eines derartigen optoelektronischen Bauelements im Waferverbund vorteilhaft erleichtern kann.

Ein Verbindungsleitermaterial, das sich in vertikaler Richtung entlang des gesamten Halbleiterfunktionsbereich erstreckt, ermöglicht, insbesondere in Verbindung mit einem entsprechend angeordneten Isolationsmaterial, eine elektrische Kontaktierung des optoelektronischen Bauelements bzw. dessen Halbleiterfunktionsbereichs in vertikaler Richtung über den Bereich der aktiven Zone, ohne dass die Gefahr von Kurzschlüssen erhöht ist. Mit Vorteil kann dieser Teil der Kontaktstruktur des optoelektronischen Bauelements im Waferverbund hergestellt werden.

In einer weiteren bevorzugten Ausgestaltung der Erfindung weist der Halbleiterfunktionsbereich eine erste Hauptfläche und eine der ersten Hauptfläche bezüglich der aktiven Zone gegenüberliegende zweite Hauptfläche auf, wobei der Halbleiterfunktionsbereich mit Vorzug seitens der ersten Hauptfläche mit dem Verbindungsleitermaterial elektrisch leitend verbunden ist.

Dies kann beispielsweise über einen ersten Kontakt erreicht werden, der mit dem Halbleiterfunktionsbereich und mit dem Verbindungsleitermaterial seitens der ersten Hauptfläche des Halbleiterfunktionsbereichs leitend verbunden ist. Ein derartiger erster Kontakt, beispielsweise ein Metall, wie Au, Al, Ag, Pt, Ti, Sn oder eine Legierung mit mindestens einem dieser Materialien, etwa AuGe, enthaltend, kann ebenfalls mit Vorteil im Waferverbund hergestellt werden.

Eine leitende Verbindung zwischen dem Verbindungsleitermaterial, das sich im Bereich des Durchbruchs, in der Vertiefung des Halbleiterfunktionsbereichs, in vertikaler Richtung über den vertikalen Verlauf des Halbleiterfunktionsbereichs erstrecken kann, und dem ersten Kontakt auf der ersten Hauptfläche des Halbleiterfunktionsbereichs ermöglicht eine elektrische Anschließbarkeit der ersten Hauptfläche des Halbleiterfunktionsbereichs seitens der zweiten Hauptfläche.

Gegebenenfalls können ein aus dem Verbindungsleitermaterial gebildeter Verbindungsleiter und der erste Kontakt einstückig, insbesondere mit identischem Material, ausgeführt sein.

In einer vorteilhaften Weiterbildung der Erfindung ist das Verbindungsleitermaterial von der zweiten Hauptfläche des Halbleiterfunktionsbereichs elektrisch isoliert. Die Gefahr von Kurzschlüssen kann so weitergehend verringert werden.

In einer weiteren bevorzugten Ausgestaltung der Erfindung ist seitens der zweiten Hauptfläche ein zweiter Kontakt, beispielsweise ein Metall, wie Au, Al, Ag, Ti, Pt, Sn oder eine Legierung mit mindestens einem dieser Materialien, etwa AuGe, enthaltend, angeordnet, der mit dem Halbleiterfunktionsbereich, insbesondere zur Strominjektion, seitens der zweiten Hauptfläche elektrisch leitend verbunden ist.

Das optoelektronische Bauelement kann über den ersten und den zweiten Kontakt elektrisch angeschlossen werden. Insbesondere kann das optoelektronische Bauelement oberflächenmontierbar als SMD-Bauelement (SMD: Surface Mountable Device) ausgebildet sein. Weiterhin kann das Bauelement für ein Hybrid-Modul vorgesehen sein.

Eine leitende Verbindung zwischen dem ersten Kontakt und dem Verbindungsleitermaterial, das sich von der ersten bis zur zweiten Hauptfläche erstrecken kann, bildet zusammen mit dem zweiten Kontakt eine Kontaktstruktur, die eine Kontaktierung des optoelektronischen Bauelements von der zweiten Hauptfläche her erleichtert.

Auf Bonddrähte kann bei der elektrischen Kontaktierung eines derartigen Bauelements mittels des ersten und des zweiten Kontakts mit Vorteil verzichtet werden, wodurch die Höhe des Bauelements vorteilhaft reduziert und die Ausbildung kleiner Bauelemente erleichtert wird. Weiterhin kann eine derartige Kontaktstruktur mit Vorteil im Waferverbund ausgebildet werden.

Es sei angemerkt, dass die Anzahl der Kontakte selbstverständlich nicht auf zwei beschränkt ist, sondern gegebenenfalls auch eine Mehrzahl von Kontakten oder Kontaktpaaren vorgesehen sein kann.

Das optoelektronische Bauelement, insbesondere der Halbleiterfunktionsbereich mit der aktiven Zone, kann entsprechend einem strahlungsemittierenden oder strahlungsempfangenden Bauelement ausgebildet sein. Die aktive Zone kann dem gemäß zur elektrolumineszenten Strahlungserzeugung oder zur Signalerzeugung über aufgrund von einfallender Strahlung in der aktiven Zone erzeugte Ladungsträger ausgebildet sein. Der Halbleiterfunktionsbereich kann beispielsweise entsprechend einem LED-Chip, einem Laserdiodenchip mit lateraler oder vertikaler Emissionsrichtung oder einem Photodiodenchip ausgebildet sein. Der erste und der zweite Kontakt sind dann vorzugsweise gemäß den beiden Polen einer Dioden-Kontaktierung ausgeführt.

Der Halbleiterfunktionsbereich, insbesondere die aktive Zone, enthält vorzugsweise mindestens ein III-V-Halbleitermaterial, etwa ein Material aus einem III-V-Halbleitermaterialsystem, wie InₓGa_{y}Al_{1-x-y}P, InₓGa_{y}Al_{1-x-y}N oder InₓGa_{y}Al_{1-x-y}As, jeweils mit 0≤x≤1, 0≤y≤1 und x+y≤1.

Bevorzugt ist das optoelektronische Bauteil für Strahlung im ultravioletten, sichtbaren oder infraroten Spektralbereich ausgebildet.

Das Materialsystem InₓGa_{y}Al_{1-x-y}N zum Beispiel ist für Strahlung vom ultravioletten bis in den grünen Spektralbereich besonders geeignet, während InₓGayAl_{1-x-y}P beispielsweise für Strahlung vom grüngelben bis in den roten und InₓGa_{y}Al_{1-x-y}As für Strahlung im infraroten Spektralbereich besonders geeignet ist.

Das Bauelement kann auch auf anderen Materialien, die nicht in einem III-V-Materialsystem enthalten sind, basieren. Beispielsweise kann der Halbleiterfunktionsbereich Si, insbesondere für Photodioden, oder ein II-VI-Halbleitermaterial enthalten bzw. auf Si oder II-VI-Halbleitermaterialien basieren. Mit einem III-V-Halbleitermaterial können jedoch dem gegenüber vereinfacht vergleichsweise hohe interne Quanteneffizienzen des Bauelements erzielt werden.

Da die aktive Zone im Bereich des Durchbruchs keine Strahlung erzeugen oder empfangen kann, weist der Durchbruch im optoelektronischen Bauelement bevorzugt in lateraler Richtung derart geringe Ausmaße auf, dass die Fläche der aktiven Zone, die zur Strahlungserzeugung oder zum Strahlungsempfang zur Verfügung steht möglichst groß ist. Dies kann durch eine geeignete Ausbildung des Durchbruchs erreicht werden.

Der Durchbruch und/oder die Vertiefung im Halbleiterfunktionsbereich ist in lateraler Richtung bevorzugt so dimensioniert, dass das Verbindungsleitermaterial bzw. ein das Verbindungsleitermaterial umfassender Verbindungsleiter eine Leitfähigkeit aufweist, die der jeweiligen Ausbildung des Halbleiterfunktionsbereichs angepasst ist. Bauelemente mit hohen Leistungen bedingen oftmals höhere Leitfähigkeiten als Bauelemente mit vergleichsweise geringen Leistungen. Eine laterale Abmessungen des Durchbruchs bzw. der Vertiefung oder des Verbindungsleitermaterials kann vom Nanometer- bis in den Mikrometerbereich reichen. Beispielsweise beträgt eine laterale Abmessung 100 µm, vorzugsweise 50 µm oder weniger, z.B. 100 nm oder 10 µm.

Eine ausreichend hohe Leitfähigkeit kann gegebenenfalls auch über eine Mehrzahl von Durchbrüchen mit in den Durchbrüchen angeordnetem Verbindungsleitermaterial oder einer entsprechend abgestimmten Kombination der Dimensionierung und der Anzahl an Durchbrüchen erzielt werden.

In einer weiteren bevorzugten Ausgestaltung der Erfindung weist das optoelektronische Bauelement ein dem Halbleiterfunktionsbereich nachgeordnetes Fenster auf, das für die von der aktiven Zone zu empfangende oder zu erzeugende Strahlung vorzugsweise durchlässig ist und/oder im Strahlengang dieser Strahlung liegt. Das Fenster kann zur Strahlungseinkopplung in oder -auskopplung aus dem optoelektronischen Bauelement vorgesehen sein.

In einer weiteren bevorzugten Ausgestaltung der Erfindung weist das optoelektronische Bauelement eine Umhüllung auf, die den Halbleiterfunktionsbereich bevorzugt zumindest teilweise umformt oder umhüllt. Der Halbleiterfunktionsbereich kann insbesondere in die Umhüllung eingebettet sein. Die Umhüllung kann Teil des Fensters sein und/oder das Fenster bilden. Die Umhüllung schützt den Halbleiterfunktionsbereich mit Vorteil vor schädlichen äußeren Einflüssen, wie etwa Feuchtigkeit.

Bevorzugt ist die Umhüllung strahlungsdurchlässig für eine von der aktiven Zone zu erzeugende oder empfangenden Strahlung ausgebildet. Mit Vorteil wird so eine unerwünschte Absorption von Strahlung in der Umhüllung verringert.

Ferner ist das Material der Umhüllung bevorzugt gegenüber der von der aktiven Zone zu erzeugenden oder auf diese einfallenden Strahlung beständig. Die Gefahr effizienzmindernder Verfärbungen oder Aufweichungen der Umhüllung kann so verringert werden.

In einer weiteren vorteilhaften Weiterbildung ist der Halbleiterfunktionsbereich, insbesondere die aktive Zone, von einer Verkapselung umgeben, die bevorzugt - zumindest bei Inbetriebnahme und/oder im Betrieb des Bauelements - im wesentlichen dicht, insbesondere hermetisch dicht, gegenüber schädlichen äußeren Einflüssen, wie Feuchtigkeit, ist. Die Verkapselung, die die Umhüllung und gegebenenfalls eines oder mehrere weitere Verkapselungselemente umfassen kann, umgibt den Halbleiterfunktionsbereich bzw. die aktive Zone bevorzugt vollständig und erhöht mit Vorteil den Schutz des Halbleiterfunktionsbereichs bzw. der aktiven Zone gegenüber schädlichen äußeren Einflüssen.

Die Verkapselung ist weiterhin bevorzugt so ausgebildet, dass die Kontakte des optoelektronischen Bauelements, vorzugsweise durch die Verkapselung hindurch, anschließbar sind. Externe Anschlüsse oder externe Anschlussmittel können somit Teil der Verkapselung sein. Insbesondere kann das optoelektronische Bauelement mittels der externen Anschlüsse elektrisch leitend mit Leiterbahnen einer Leiterplatte verbunden werden. Vorzugsweise wird das Bauelement mit den Leiterbahnen über eine Lotverbindung verbunden.

Die Verkapselung bzw. die Verkapselungselemente sind bevorzugt zumindest teilweise so ausgebildet, dass der Bereich zwischen der Verkapselung bzw. dem Verkapselungselement und der aktiven Zone, insbesondere im Strahlengang der zu erzeugenden oder zu empfangenden Strahlung im wesentlichen frei von Hohlräumen ist. Die Gefahr von durch einen Hohlraum verursachten übermäßigen Brechungsindexsprüngen mit dementsprechend hohen Reflexionsverlusten an Grenzflächen bei der Strahlungsaus- oder -einkopplung in das Bauelement kann so verringert werden.

Mit Vorzug können an der Verkapselung beteiligte Elemente, wie beispielsweise die Umhüllung und/oder das Fenster, auch bereits im Waferverbund ausgebildet werden. Mit besonderem Vorzug kann die gesamte Verkapselung im Waferverbund hergestellt werden.

Die Verkapselung ist in einer bevorzugten Ausgestaltung der Erfindung mechanisch derart stabil, dass auf ein zusätzliches, den Halbleiterfunktionsbereich schützendes Gehäuse verzichtet und die Ausbildung sehr kleiner optoelektronischer Bauelemente mit schützender, vorzugsweise allseitiger, Verkapselung des Halbleiterfunktionsbereichs erleichtert werden kann.

Die Verkapselung bzw. die Elemente der Verkapselung, wie etwa die Umhüllung, sind bevorzugt zumindest teilweise so ausgebildet, dass sie zumindest kurzzeitig gegenüber hohen Temperaturen, etwa über 200 °C, vorzugsweise bis 300 °C, wie sie beim Löten der Anschlüsse des Bauelements auftreten können stabil sind, so dass die Gefahr einer Schädigung des Halbleiterfunktionsbereichs und/oder der Umhüllung aufgrund eines Lötprozesses nicht maßgeblich erhöht wird.

In einer weiteren bevorzugten Ausgestaltung der Erfindung ist dem Halbleiterfunktionsbereich zumindest ein Absorptionsstoff oder ein Leuchtstoff nachgeordnet. Der Leuchtstoff oder der Absorptionsstoff kann, vorzugsweise direkt, in, an oder auf dem Fenster, der Umhüllung oder dem Halbleiterfunktionsbereich vorgesehen oder angeordnet sein. Bevorzugt ist der Absorptionsstoff oder der Leuchtstoff als Pulver ausgeführt.

Ein Absorptionsstoff, wie ein organischer Farbstoff, kann beispielsweise in einem als strahlungsempfangendes Bauelement ausgebildeten Bauelement vorgesehen sein, um als Filterstoff die Empfindlichkeit, etwa die spektrale Empfindlichkeitsverteilung, des Strahlungsdetektors durch Absorption bei geeigneten, insbesondere vorgegebenen, Wellenlängen aus einer auf den Halbleiterfunktionsbereich einfallenden Strahlung zu beeinflussen. Mit Vorteil kann so beispielsweise die spektrale Empfindlichkeitsverteilung eines als Strahlungsdetektor ausgebildeten optoelektronischen Bauelements gezielt eingestellt werden.

Bei einem als Emitter ausgebildeten optoelektronischen Bauelement kann der Leuchtstoff vorzugsweise von der aktiven Zone erzeugte Strahlung einer Wellenlänge λ₁ absorbieren und als Strahlung einer Wellenlänge λ₂ reemittieren. Die Wellenlänge λ₂ ist bevorzugt größer als die Wellenlänge λ₁. Ein derartiges optoelektronisches Bauelement kann mischfarbiges Licht, insbesondere weißes Licht, erzeugen, an dessen Farbe eine Mischung aus Strahlungen der Wellenlängen λ₁ und λ₂ beteiligt ist. Ein derartiger Leuchtstoff konvertiert somit zumindest teilweise die Strahlung der Wellenlänge λ₁ in Strahlung der Wellenlänge λ₂ und wird deshalb oft auch als Konversionsstoff, insbesondere Lumineszenzkonversionsstoff, bezeichnet.

Als Lumineszenzkonversionsstoffe können dabei anorganische Phosphore, dotierte Granate, Ce- oder Tb-aktivierte Granate (wie beispielsweise YAG:Ce, TAG:Ce, TbYAG:Ce), Erdalkalisulfate oder organische Farbstoffe Verwendung finden. Geeignete Lumineszenzkonversionsstoffe sind beispielsweise in der Druckschrift WO98/12757 beschrieben, deren Inhalt insofern hiermit durch Rückbezug aufgenommen wird.

Zur Erzeugung weißen Lichts besonders geeignet ist ein Leuchtstoff, insbesondere ein YAG-basierender Leuchtstoff, der eine im Halbleiterfunktionsbereich erzeugte Strahlung, etwa im ultravioletten oder blauen, Spektralbereich in längerwellige Strahlung, etwa im gelben Spektralbereich konvertiert. Aus der Mischung des konvertierten und des nicht konvertierten Strahlungsanteils kann mischfarbiges, insbesondere weißes, Licht entstehen.

In einer bevorzugten Ausgestaltung beträgt die mittlere Korngröße des Lumineszenzkonversionsmaterials eines verwendeten Pulvers maximal 30 µm. Besonders vorteilhaft erweist sich dabei eine mittlere Korngröße, zwischen 2 und 6 µm. Es hat sich gezeigt, dass bei dieser Korngröße die Lumineszenzkonversion besonders effizient erfolgen kann.

Der Konversionsstoff ist bevorzugt möglichst nahe an der aktiven Zone angeordnet. Hierdurch kann die Effizienz der Konversion erhöht werden, da die Intensität der von der aktiven Zone erzeugten Strahlung mit wachsendem Abstand von der aktiven Zone quadratisch abnimmt. Weiterhin wird eine Optimierung der Etendue oder der Abhängigkeit des Farborts der mischfarbigen Strahlung vom Betrachtungswinkel erleichtert.

Eine Konversion der Strahlung nahe an der aktiven Zone in eine energieärmere Strahlung einer größeren Wellenlänge, kann sich auch schützend auf ein den Konversionsstoff umgebendes oder dem Konversionsstoff nachgeordnetes Element, wie die Umhüllung auswirken. Mit Vorteil kann die Gefahr von strahlungsbedingten Verfärbungen des Umhüllungsmaterials durch Konversion in der Nähe der aktiven Zone reduziert werden.

In einer weiteren bevorzugten Ausgestaltung ist der Leuchtstoff, insbesondere direkt, auf dem Halbleiterfunktionsbereich angeordnet. Der Leuchtstoff kann in Form einer Leuchtstoffschicht ausgebildet sein. Hierdurch wird eine besonders effiziente Lumineszenzkonversion nahe an der aktiven Zone erleichtert. Der Leuchtstoff wird bevorzugt im Waferverbund auf die Halbleiterschichtenfolge bzw. die aus der Halbleiterschichtenfolge hervorgehenden Halbleiterfunktionsbereiche aufgebracht. Der Leuchtstoff kann insbesondere mittels elektrostatischer Kräfte aufgebracht sein. Dies gilt mit Vorzug entsprechend für den Absorptionsstoff.

In einer weiteren vorteilhaften Ausgestaltung der Erfindung ist dem Halbleiterfunktionsbereich eines oder eine Mehrzahl von optischen Elementen nachgeordnet, das die Effizienz oder die Abstrahl- bzw. Empfangscharakteristik des Bauelements vorteilhaft beeinflusst. Dieses optische Element kann beispielsweise als Linse zur Strahlformung ausgeführt sein. Ferner kann das optische Element als Filterelement oder Streuelement ausgeführt sein.

Weiterhin kann das optische Element als Antireflexionsschicht bzw. -beschichtung ausgeführt sein. Über eine Antireflexionsbeschichtung können durch Brechungsindexsprünge bedingte Reflexionsverluste mit Vorteil verringert werden. Eine oder eine Mehrzahl von λ/4-Schichten sind hierfür besonders geeignet. Beispielsweise kann die Antireflexionsschicht die oben für das Isolationsmaterial angeführten Materialien enthalten. Insbesondere können diese Materialien identisch sein und/oder die Antireflexionsschicht und das Isolationsmaterial in einem Element integriert ausgebildet sein. Eine Antireflexionsschicht kann zwischen der Umhüllung und dem Halbleiterfunktionsbereich und/oder zwischen der Umhüllung und dem Fenster angeordnet sein.

In einer vorteilhaften Weiterbildung der Erfindung ist das optische Element in der Umhüllung oder dem Fenster ausgebildet, auf diese oder dieses aufgebracht oder mit dieser oder diesem direkt in Kontakt.

Das optische Element, insbesondere eine Linsen- oder eine Streustruktur, kann beispielsweise in das Umhüllungs- oder das Fenstermaterial einstrukturiert oder aus diesen ausgeformt werden. Dies kann beispielsweise durch Stempeln oder ein Ätzverfahren erfolgen.

Weiterhin kann das Streu- oder Filterelement, etwa in der Form von Streu- oder Filterpartikeln ,in der Umhüllung oder dem Fenster angeordnet sein.

Außerdem kann das optische Element auch auf das Umhüllungsmaterial oder den Halbleiterfunktionsbereich aufgeklebt, aufgedampft oder aufgesputtert werden. Kleben eignet sich besonders für optische Elemente zur Strahlformung, während Sputtern oder Aufdampfen für eine Antireflexionsbeschichtung besonders geeignet ist.

Bevorzugt wird das optische Element im Waferverbund ausgebildet.

Der Halbleiterfunktionsbereich ist auf einem Träger angeordnet. Der Träger kann hierbei aus einem Teilstück des Aufwachssubstrats der Halbleiterschichtenfolge, aus der der Halbleiterfunktionsbereich bei der Herstellung des Bauelements hervorgeht, oder einem Teilstück einer anderweitigen, vom Aufwachssubstrat verschiedenen, Trägerschicht, auf der die Halbleiterschichtenfolge während der Prozessierung oder der Herstellung, beispielsweise mittels eines Waferbondingverfahrens, angeordnet wird, gebildet sein oder ein solches umfassen. Im letzteren Fall ist das Aufwachssubstrat, vorzugsweise nach der Anordnung der Halbleiterschichtenfolge oder der Halbleiterfunktionsbereiche auf der Trägerschicht, abgelöst. Der Träger trägt und stabilisiert mit Vorzug den Halbleiterfunktionsbereich mechanisch. Insbesondere kann der Halbleiterfunktionsbereich auf einer Seite des Trägers angeordnet sein.

Bevorzugt erstreckt sich das Verbindungsleitermaterial zumindest bis zu einer dem Halbleiterfunktionsbereich gegenüberliegenden Seite des Trägers. Hierdurch kann die elektrische Anschließbarkeit des optoelektronischen Bauelements von der dem Halbleiterfunktionsbereich gegenüberliegenden Seite des Trägers her erleichtert werden.

Ist das Verbindungsleitermaterial zumindest teilweise im Durchbruch angeordnet, so erstreckt sich der Durchbruch, der z.B. als laterale Vertiefung ausgebildet ist, bevorzugt bis zu der dem Halbleiterfunktionsbereich gegenüberliegenden Seite des Trägers. Ist der Träger an der elektrischen Kontaktierung des Bauelements beteiligt, so ist dieser bevorzugt elektrisch leitend ausgeführt. Beispielsweise enthält der Träger ein geeignetes Halbleitermaterial, das zur Erhöhung seiner Leitfähigkeit dotiert sein kann.

In einer weiteren bevorzugten Ausgestaltung des optoelektronischen Bauelements ist der aktiven Zone und/oder dem Halbleiterfunktionsbereich eine Spiegelschicht nachgeordnet. Eine derartige Spiegelschicht kann beispielsweise als Bragg-Spiegel im Halbleiterfunktionsbereich integriert oder als metallhaltige, insbesondere metallische, Spiegelschicht, beispielsweise Au, Al, Ag, Pt, Ti oder Legierungen mit mindestens einem dieser Metalle, etwa AuGe, enthaltend, ausgebildet sein. Die Spiegelschicht ist zwischen dem Träger und der aktiven Zone und/oder auf dem Halbleiterfunktionsbereich angeordnet.

Die Spiegelschicht ist bevorzugt elektrisch leitend ausgeführt und kann an der Kontaktierung des Bauelements beteiligt sein. Hierzu ist die Spiegelschicht zweckmäßigerweise mit dem Halbleiterfunktionsbereich elektrisch leitend verbunden.

Die Spiegelschicht ist bezüglich einer von der aktiven Zone zu empfangenden oder zu erzeugenden Strahlung reflektierend ausgebildet. Mit Vorteil erhöht die Spiegelschicht die Effizienz des optoelektronischen Bauelements, beispielsweise durch Verminderung der Absorption von Strahlung in dem Träger oder eine vorteilhafte Einflussnahme auf die Abstrahl- oder Empfangscharakteristik des optoelektronischen Bauelements.

Die Spiegelschicht kann mit besonderem Vorteil bereits im Waferverbund, beispielsweise durch Aufwachsen, wie der Bragg-Spiegel, gemeinsam mit der Halbleiterschichtenfolge und in dieser integriert, oder durch nachträgliches Aufbringen, etwa mittels Aufdampfen oder Aufsputtern, wie eine metallhaltige Spiegelschicht, auf die Halbleiterschichtenfolge oder den Halbleiterfunktionsbereich hergestellt werden.

Gegebenenfalls kann die Spiegelschicht eine in der Halbleiterschichtenfolge oder dem Halbleiterfunktionsbereich monolithisch integrierte erste Teilspiegelschicht und eine seitens der integrierten Teilspiegelschicht auf der Halbleiterschichtenfolge bzw. den Halbleiterfunktionsbereichen angeordnete, insbesondere metallhaltige, zweite Teilspiegelschicht umfassen. Bevorzugt ist zwischen den Teilspiegelschichten eine Zwischenschicht angeordnet, die besonders bevorzugt elektrisch leitend mit den Teilschichten verbunden ist. Eine ein strahlungsdurchlässiges leitfähiges Oxid, insbesondere ein Metalloxid, wie ein Zinkoxid, ein Indiumzinnoxid oder ein Zinnoxid, enthaltende Zwischenschicht ist besonders geeignet. Die Zwischenschicht kann der Optimierung des elektrischen Kontaktes der metallhaltigen Teilspiegelschicht zur integrierten Teilspiegelschicht dienen.

Wird während der Herstellung des optoelektronischen Bauelements, insbesondere eines Bauelements mit einer metallhaltigen Spiegelschicht, das Aufwachssubstrat der Halbleiterschichtenfolge abgelöst, so werden derartige unter Ablösen des Aufwachssubstrats hergestellte Bauelemente auch als Dünnfilm-Bauelemente bezeichnet. Ein Dünnfilm-Bauelement mit metallhaltigem Spiegel kann insbesondere eine einem Lambertschen Strahler entsprechende, im wesentlichen kosinusförmige Abstrahlcharakteristik aufweisen.

In einer vorteilhaften Weiterbildung der Erfindung ist die Verkapselung bzw. mindestens ein Element der Verkapselung so ausgebildet, dass der Halbleiterfunktionsbereich mechanisch stabilisiert wird. Der Träger kann insbesondere abgedünnt sein.

Eine erfindungsgemäße Vorrichtung mit einer Mehrzahl von optoelektronischen Bauelementen weist eine Mehrzahl erfindungsgemäßer optoelektronischer Bauelemente der oben genannten Art auf, wobei die Halbleiterfunktionsbereiche mit Vorzug zumindest teilweise in lateraler Richtung nebeneinander angeordnet sind. Mit Vorteil entspricht die laterale Nebeneinanderanordnung der Anordnung der Halbleiterfunktionsbereiche, die aus einer entsprechenden Strukturierung einer Halbleiterschichtenfolge in Halbleiterfunktionsbereiche auf einer Trägerschicht im Waferverbund hervorgeht. Die Vorrichtung eignet sich insbesondere zur Herstellung im Waferverbund.

In einer bevorzugten Ausgestaltung weist die Vorrichtung eine Umhüllung auf, die die Halbleiterfunktionsbereiche zumindest teilweise umhüllt oder umformt. Die Umhüllung ist vorzugsweise einstückig ausgebildet. Mit Vorteil kann die Umhüllung ebenfalls im Waferverbund ausgebildet werden. Insbesondere kann die Umhüllung gemäß den obigen Ausführungen ausgebildet sein.

In einer weiteren bevorzugten Ausgestaltung werden die Halbleiterfunktionsbereiche von einer Stabilisationsschicht mechanisch stabilisiert. Vorzugsweise werden die Halbleiterfunktionsbereiche in einer Anordnung stabilisiert, die durch die Anordnung der Halbleiterfunktionsbereiche der Vorrichtung im Waferverbund, insbesondere auf einer ebenen Trägerschicht, gegeben ist.

In einer vorteilhaften Weiterbildung der Vorrichtung umfaßt die Stabilisationsschicht die Umhüllung und/oder das Fenster, und/oder ist die Stabilisationsschicht im wesentlichen identisch mit der Umhüllung, so dass die Umhüllung gleichzeitig schützende Wirkung bezüglich der Halbleiterfunktionsbereiche und stabilisierende Wirkung haben kann. Die Umhüllung kann somit als Stabilisationsschicht ausgebildet oder Teil der Stabilisationsschicht sein.

In einem erfindungsgemäßen Verfahren zur Herstellung eines optoelektronischen Bauelements wird zunächst ein Waferverbund mit einer auf einer Trägerschicht angeordneten Halbleiterschichtenfolge, die eine aktive Zone und eine laterale Haupterstreckungsrichtung aufweist, bereitgestellt. Nachfolgend wird die Halbleiterschichtenfolge derart strukturiert, dass zumindest ein Durchbruch durch die aktive Zone entsteht bzw. zumindest eine laterale, die aktive Zone in lateraler Richtung begrenzende Seitenfläche ausgebildet wird, wonach ein Verbindungsleitermaterial im Bereich des Durchbruchs bzw. der Seitenfläche derart angeordnet wird, dass die aktive Zone zumindest in einem Teilbereich des Durchbruchs bzw. der Seitenfläche elektrisch vom Verbindungsleitermaterial isoliert ist. Nachfolgend wird in optoelektronische Bauelemente vereinzelt, wobei deren elektrische Kontaktierung zumindest teilweise über das Verbindungsleitermaterial erfolgt.

Ein derartiges Verfahren hat den Vorteil, dass optoelektronische Bauelemente einschließlich deren Kontaktstruktur, zumindest teilweise, vorzugsweise vollständig, kostengünstig im Waferverbund hergestellt werden können. Dadurch, dass die aktive Zone elektrisch vom Verbindungsleitermaterial isoliert ist, beispielsweise durch geeignete Anordnung des Verbindungsleitermaterials relativ zur aktiven Zone, wie etwa in einem Abstand zur aktiven Zone, kann die Gefahr von Kurzschlüssen der aktiven Zone über das Verbindungsleitermaterial verringert werden. Mit Vorteil kann die Kontaktstruktur des Bauelements derart ausgebildet werden, dass das optoelektronische Bauelement frei von Drahtbondungen ist bzw. bonddrahtfrei kontaktierbar ist.

Die Trägerschicht kann das Aufwachssubstrat der Halbleiterschichtenfolge enthalten, auf dem die Halbleiterschichtenfolge, vorzugsweise epitaktisch, hergestellt wurde oder vom Aufwachssubstrat der Halbleiterschichtenfolge verschieden sein. Im letzteren Fall wird das Aufwachssubstrat, vorzugsweise nach dem Anordnen der Halbleiterschichtenfolge, insbesondere mit ihrer dem Aufwachssubstrat gegenüberliegenden Seite auf der Trägerschicht, abgelöst.

Bevorzugt wird die aktive Zone über ein Isolationsmaterial von dem Verbindungsleitermaterial elektrisch isoliert. Das Isolationsmaterial, beispielsweise SiN oder ein anderes der weiter oben genannten Materialien enthaltend, ist weiterhin bevorzugt zumindest teilweise im Bereich des Durchbruchs bzw. der Seitenfläche angeordnet. Besonders bevorzugt ist das Isolationsmaterial direkt an der aktiven Zone angeordnet und/oder das Verbindungsleitermaterial wird durch das zwischen der aktiven Zone und dem Verbindungsleitermaterial angeordnete Isolationsmaterial elektrisch von der aktiven Zone isoliert. Die Gefahr eines Kurzschlusses der aktiven Zone wird so weitergehend verringert. Das Isolationsmaterial wird mit Vorzug vor dem Verbindungsleitermaterial aufgebracht und/oder das Verbindungsleitermaterial grenzt direkt an das Isolationsmaterial. Das Isolationsmaterial kann beispielsweise mittels Aufdampfen, etwa in einem PVD-Verfahren, wie Sputtern, oder in einem CVD-Verfahren, wie PECVD, aufgebracht werden.

In einer bevorzugten Ausgestaltung des Verfahrens weist die Halbleiterschichtenfolge in lateraler Richtung zumindest eine Vertiefung auf, die vorzugsweise den Durchbruch durch die aktive Zone zumindest teilweise umschließt. Gegebenenfalls kann der Durchbruch als Vertiefung der Halbleiterschichtenfolge in lateraler Richtung ausgebildet sein.

Weiterhin bevorzugt ist eine Wand des Durchbruchs zumindest teilweise mit dem Isolationsmaterial ausgekleidet.

Das elektrisch leitende Verbindungsleitermaterial ist gemäß einer weiteren bevorzugten Ausgestaltung zumindest teilweise in dem Durchbruch, insbesondere in der Vertiefung, angeordnet. Der Durchbruch kann somit die Kontaktstruktur des optoelektronischen Bauelements bestimmen.

Weiterhin erstreckt sich der Durchbruch bevorzugt in vertikaler Richtung senkrecht zur lateralen Haupterstreckungsrichtung der Halbleiterschichtenfolge, insbesondere durch die gesamte Halbleiterschichtenfolge. Vorzugsweise erstreckt sich der Durchbruch bis an oder in die Trägerschicht. Besonders bevorzugt erstreckt sich der Durchbruch durch die komplette Trägerschicht. Der Durchbruch kann somit insbesondere als sich durch die Halbleiterschichtenfolge und/oder bis in oder durch die Trägerschicht erstreckende Aussparung ausgebildet sein bzw. als Aussparung der Halbleiterschichtenfolge ausgeführt sein. Insbesondere kann die Aussparung im Bereich der Halbleiterschichtenfolge in lateraler Richtung zumindest teilweise, vorzugsweise vollständig, durch die Halbleiterschichtenfolge begrenzt sein. Die Halbleiterschichtenfolge kann den Durchbruch somit in lateraler Richtung vollständig umschließen.

In einer weiteren bevorzugten Ausgestaltung des Verfahrens wird die Halbleiterschichtenfolge derart strukturiert, dass eine Mehrzahl von, insbesondere durch Zwischenräume in lateraler Richtung räumlich voneinander getrennten, Halbleiterfunktionsbereichen entsteht. Besonders bevorzugt erfolgt diese Strukturierung der Halbleiterschichtenfolge in einem Verfahrensschritt mit der Ausbildung des Durchbruchs bzw. der Seitenfläche, insbesondere vor der Anordnung des Verbindungsleitermaterials. Das Strukturieren in Halbleiterfunktionsbereiche kann vor oder nach dem Ausbilden des Durchbruchs bzw. der Seitenfläche erfolgen.

Die Halbleiterfunktionsbereiche weisen mit Vorzug zumindest teilweise einen Durchbruch durch die aktive Zone bzw. eine die aktive Zone in lateraler Richtung begrenzende Seitenfläche auf. Hierfür wird bei der Strukturierung der Halbleiterschichtenfolge zweckmäßigerweise eine Mehrzahl von Durchbrüchen für eine Mehrzahl von Halbleiterfunktionsbereichen erzeugt.
Insbesondere kann der Durchbruch als Aussparung des Halbleiterfunktionsbereichs ausgebildet sein, die mit Vorzug im Bereich des Halbleiterfunktionsbereichs in lateraler Richtung zumindest teilweise, vorzugsweise vollständig, durch den Halbleiterfunktionsbereich begrenzt ist. Der Halbleiterfunktionsbereich kann den Durchbruch somit in lateraler Richtung vollständig umschließen.

In einer bevorzugten Ausgestaltung wird eine Mehrzahl von Durchbrüchen durch die aktive Zone erzeugt, wobei eine Mehrzahl von Halbleiterfunktionsbereichen zumindest einen Durchbruch durch die aktive Zone aufweist.

In einer weiteren bevorzugten Ausgestaltung weist eine Mehrzahl von Halbleiterfunktionsbereichen jeweils zumindest eine Vertiefung in lateraler Richtung auf, die den Durchbruch zumindest teilweise umschließt bzw. ist bei einer Mehrzahl der Halbleiterfunktionsbereiche der Durchbruch als Vertiefung des jeweiligen Halbleiterfunktionsbereichs in lateraler Richtung ausgebildet.

In einer weiteren bevorzugten Ausgestaltung weist eine Mehrzahl der Halbleiterfunktionsbereichen jeweils zumindest eine laterale, die aktive Zone des jeweiligen Halbleiterfunktionsbereichs begrenzende Seitenfläche auf. Bevorzugt begrenzt die Seitenfläche den jeweiligen Halbleiterfunktionsbereich seitens der Seitenfläche in lateraler Richtung. Insbesondere kann der gesamte Halbleiterfunktionsbereich durch derartige Seitenflächen begrenzt sein.

Diese Seitenfläche(n) kann (können) beispielsweise bei der Strukturierung der Halbleiterschichtenfolge in Halbleiterfunktionsbereiche ausgebildet werden. Die Seitenfläche kann insbesondere an einen zwischen zwei Halbleiterfunktionsbereichen angeordneten Zwischenraum angrenzen.

Das Verbindungsleitermaterial ist der Seitenfläche bevorzugt in lateraler Richtung derart nachgeordnet, dass das Verbindungsleitermaterial von der aktiven Zone zumindest in einem Teilbereich der Seitenfläche elektrisch isoliert ist.

In einer weiteren bevorzugten Ausgestaltung der Erfindung ist das Isolationsmaterial, insbesondere direkt, an der Seitenfläche angeordnet.

Bevorzugt erstreckt sich das Verbindungsleitermaterial in vertikaler Richtung über den Bereich der aktiven Zone und/oder ist, etwa mittels des Isolationsmaterials, das zwischen dem Verbindungsleitermaterial und der Seitenfläche bzw. dem Halbleiterfunktionsbereich angeordnet sein kann, von der aktiven Zone beabstandet und/oder isoliert.

In einer weiteren bevorzugten Ausgestaltung wird ein erster elektrischer Kontakt auf die der Trägerschicht abgewandten Seite der Halbleiterschichtenfolge bzw. der Halbleiterfunktionsbereiche aufgebracht. Mit Vorteil erleichtert der erste elektrische Kontakt die Ausbildung der Kontaktstruktur des herzustellenden optoelektronischen Bauelements im Waferverbund. Der erste elektrische Kontakt kann hierbei vor oder nach dem Ausbilden des Durchbruchs bzw. der Seitenfläche vorgesehen werden. Es kann beispielsweise im wesentlichen jeder Halbleiterfunktionsbereich mit einem derartigen ersten Kontakt versehen werden.

Weiterhin kann gegebenenfalls auch eine Mehrzahl von ersten Kontakten auf der Halbleiterschichtenfolge vorgesehen oder ausgebildet werden. Mit Vorzug geschieht dies derart, dass im wesentlichen jedem zur Ausbildung eines Halbleiterfunktionsbereichs aus der Halbleiterschichtenfolge vorgesehenen Bereich der Halbleiterschichtenfolge zumindest ein derartiger erster Kontakt zugeordnet ist.

In einer weiteren bevorzugten Ausgestaltung wird das Verbindungsleitermaterial im Bereich des Durchbruchs bzw. der Seitenfläche derart angeordnet, dass eine, insbesondere direkte, elektrisch leitende Verbindung zwischen dem Verbindungsleitermaterial und dem ersten Kontakt ausgebildet wird. Insbesondere können das Verbindungsleitermaterial und der erste Kontakt in direktem mechanischen Kontakt stehen.

In einer weiteren bevorzugten Ausgestaltung wird der Durchbruch bzw. die Seitenfläche derart ausgebildet, dass der erste Kontakt von der dem ersten Kontakt gegenüberliegenden Seite der Halbleiterschichtenfolge bzw. des Halbleiterfunktionsbereichs her über den Bereich des Durchbruchs bzw. den Bereich der Seitenfläche elektrisch anschließbar ist oder dass der erste Kontakt zumindest teilweise freigelegt ist, d.h. dass der erste Kontakt, insbesondere in vertikaler Richtung, nicht mit der Halbleiterschichtenfolge bzw. dem Halbleiterfunktionsbereich bedeckt ist. Zweckmäßigerweise wird der erste Kontakt hierbei vor der Ausbildung des Durchbruchs bzw. der Seitenfläche vorgesehen. Zur Ausbildung des Durchbruchs bzw. der Seitenfläche kann dann gezielt ein Bereich der Halbleiterschichtenfolge entfernt werden, der den ersten Kontakt bedeckt, so dass der erste Kontakt freigelegt wird und der erste Kontakt von der dem ersten Kontakt gegenüberliegenden Seite der Halbleiterschichtenfolge bzw. des Halbleiterfunktionsbereichs her, insbesondere mittels des Verbindungsleitermaterials, elektrisch anschließbar ist. Insbesondere kann der erste Kontakt den Durchbruch in lateraler Richtung, insbesondere vollständig, überdecken. Hierzu weist der erste Kontakt mit Vorzug eine laterale Ausdehnung auf, die größer als die des Durchbruchs ist.

In einer weiteren bevorzugten Ausgestaltung des Verfahrens wird der unstrukturierten Halbleiterschichtenfolge bzw. den Halbleiterfunktionsbereichen von ihrer der Trägerschicht abgewandten Seite her eine Stabilisationsschicht nachgeordnet. Bevorzugt wird die Stabilisationsschicht auf die Halbleiterschichtenfolge bzw. die Halbleiterfunktionsbereiche aufgebracht. Weiterhin kann die Stabilisationsschicht, gegebenenfalls unter Verwendung einer geeigneten Haft- oder Zwischenschicht, der Halbleiterschichtenfolge bzw. den Halbleiterfunktionsbereichen nachgeordnet werden.

Die Stabilisationsschicht ist bevorzugt freitragend ausgebildet und stabilisiert die Halbleiterschichtenfolge bzw. die Halbleiterfunktionsbereiche mechanisch. Weiterhin kann die Stabilisationsschicht die Halbleiterfunktionsbereiche mechanisch stabil miteinander verbinden.

Eine derartige Stabilisationsschicht kann mit Vorteil den Waferverbund derart mechanisch stabilisieren, dass auf die Trägerschicht verzichtet oder die Trägerschicht abgedünnt werden kann. Die Trägerschicht kann, beispielsweise durch Ätzen oder Abschleifen, zumindest teilweise abgedünnt oder, insbesondere vollständig, entfernt werden.

Dies erleichtert die Herstellung sehr dünner optoelektronischer Bauelemente, deren Halbleiterfunktionsbereich im Extremfall im wesentlichen nur die aktive Zone umfasst.

Insbesondere kann die Halbleiterschichtenfolge nach dem teilweisen, insbesondere vollständigen, Entfernen oder nach dem Abdünnen der Trägerschicht in eine Mehrzahl von Halbleiterfunktionsbereichen strukturiert werden. Die mechanische Stabilität wird hierbei mit Vorzug durch die zuvor vorgesehene Stabilisationsschicht gewährleistet.

Weiterhin kann über eine eventuell mehrfache Aufbringung in Kombination mit eventuellem Entfernen verschiedener derartiger Stabilisationsschichten eine vielseitige, vorzugsweise allseitige, Strukturierbarkeit einer Halbleiterschichtenfolge auf einer Trägerschicht im Waferverbund erreicht werden.

Besonders bevorzugt ist die Stabilisationsschicht photostrukturierbar ausgebildet, was die weitere Prozessierung erleichtern kann. Bevorzugt enthält die Stabilisationsschicht hierzu einen photostrukturierbaren Lack.

In einer weiteren bevorzugten Ausgestaltung wird die Stabilisationsschicht der Halbleiterschichtenfolge bzw. den Halbleiterfunktionsbereichen vor dem Ausbilden des Durchbruchs bzw. der Seitenfläche nachgeordnet. Bevorzugt wird dann der Durchbruch bzw. die Seitenfläche von der der Stabilisationsschicht gegenüberliegenden Seite her in der Halbleiterschichtenfolge bzw. den Halbleiterfunktionsbereichen ausgebildet. Bevorzugt wird hierzu die Trägerschicht, insbesondere bereichsweise, entfernt oder der Durchbruch bzw. die Seitenfläche wird unter gleichzeitiger, geeigneter, insbesondere bereichsweiser, Entfernung der Trägerschicht ausgebildet.

Die Trägerschicht kann aufgrund der mechanisch stabilisierenden Wirkung der Stabilisationsschicht bereichsweise entfernt werden, ohne die Gefahr einer Schädigung der Halbleiterschichtenfolge oder der Halbleiterfunktionsbereiche zu erhöhen.

In einer vorteilhaften Weiterbildung wird die Trägerschicht zumindest in einem Teilbereich entfernt und der Durchbruch bzw. die Seitenfläche wird von der der Stabilisationsschicht abgewandten Seite her, insbesondere durch den Bereich, in dem die Trägerschicht entfernt ist, in der Halbleiterschichtenfolge bzw. den Halbleiterfunktionsbereichen ausgebildet.

In einer weiteren bevorzugten Ausgestaltung des Verfahrens umhüllt und/oder umformt die Stabilisationsschicht die Halbleiterfunktionsbereiche zumindest teilweise. Dadurch kann ein vorteilhafter Schutz der Halbleiterfunktionsbereiche, insbesondere in deren Randbereichen, gegenüber schädlichen äußeren Einflüssen schon während der Herstellung der optoelektronischen Bauelemente erreicht werden.

In einer weiteren bevorzugten Ausgestaltung wird der Durchbruch bzw. die Seitenfläche von der der Trägerschicht gegenüberliegenden Seite her in der Halbleiterschichtenfolge bzw. den Halbleiterfunktionsbereichen ausgebildet. Hierzu kann beispielsweise die Halbleiterschichtenfolge bzw. können die Halbleiterfunktionsbereiche von der der Trägerschicht gegenüberliegenden Seite mittels Ätzen geeignet strukturiert werden. Dies kann vor, nach oder gleichzeitig mit dem Ausbilden der Halbleiterfunktionsbereiche erfolgen. Hierbei wird die mechanische Stabilität des Verbundes mit Vorteil durch die Trägerschicht gewährleistet.

In einer vorteilhaften Weiterbildung wird die Stabilisationsschicht der Halbleiterschichtenfolge bzw. den Halbleiterfunktionsbereich nach dem Ausbilden des Durchbruchs bzw. der Seitenfläche nachgeordnet.

Weiterhin ist die Stabilisationsschicht bevorzugt für eine von der aktiven Zone zu erzeugende oder zu empfangende Strahlung durchlässig. Dadurch kann die Stabilisationsschicht auch Teil einer späteren Umhüllung oder Verkapselung des optoelektronischen Bauelements sein, ohne dass die Effizienz dieses Bauelements durch Absorption der einfallenden oder emittierten Strahlung im Material der Stabilisationsschicht nachteilig verringert wird.

Die Stabilisationsschicht kann der Halbleiterschichtenfolge oder den Halbleiterfunktionsbereichen mittels verschiedener Verfahren nachgeordnet werden. Beispielsweise kann die Stabilisationsschicht durch ein Aufdampfverfahren, wie etwa durch einen CVD- oder PVD-Prozess, oder Spincoating vorgesehen werden. Für Spincoating besonders geeignetes Material sind beispielsweise BCB (BenzoCycloButene), ein Siloxan, ein Silikon, ein Spin-on-Oxid, wie ein Aluminiumoxid, etwa Al₂O₃, oder ein Lack, für Aufdampfen, beispielsweise im CVD-Verfahren, ist ein Glas besonders geeignet.

Nach dem Aufbringen der Stabilisationsschicht auf die Halbleiterfunktionsbereiche oder die Halbleiterschichtenfolge wird die Stabilisationsschicht gegebenenfalls ausgehärtet, wobei das Aushärten bevorzugt bei Temperaturen, z.B. kleiner 400°C oder kleiner 300°C, erfolgen kann, die für die Halbleiterstruktur, insbesondere bei einer vergleichsweise kurzen Härtezeit, im wesentlichen unschädlich sind. Dies ist besonders zweckmäßig, falls das Material der Stabilisationsschicht aus der flüssigen Phase aufgebracht wird.

Weiterhin kann die Stabilisationsschicht auch auf die Halbleiterschichtenfolge oder die Halbleiterfunktionsbereiche aufgebondet werden, beispielsweise über ein Waferbondingverfahren oder anodisches Bonden oder direktes Bonden. Insbesondere kann die Stabilisationsschicht mittels van der Waals-Kräften auf der Halbleiterschichtenfolge beziehungsweise den Halbleiterfunktionsbereichen befestigt sein. Hierzu kann die Stabilisationsschicht an den Waferverbund angesprengt werden. Die Stabilisationsschicht kann in diesem Fall insbesondere eben ausgebildet sein und beispielsweise eine Glasplatte umfassen.

Die Stabilisationsschicht kann der Halbleiterschichtenfolge oder den Halbleiterfunktionsbereichen ferner mittels einer Haftvermittlungsschicht nachgeordnet werden, wobei die Haftvermittlungsschicht vorzugsweise zwischen den Halbleiterfunktionsbereichen und der Stabilisationsschicht angeordnet ist und/oder die Halbleiterschichtenfolge bzw. die Halbleiterfunktionsbereiche vorzugsweise mechanisch stabil mit der Stabilisationsschicht verbindet. Die Stabilisationsschicht kann in diesem Fall insbesondere eben ausgebildet sein und beispielsweise eine Glasplatte umfassen.

Weiterhin kann die Stabilisationsschicht als Fensterschicht zur Strahlungsauskopplung ausgebildet sein.

Die Haftvermittlungsschicht kann die Halbleiterfunktionsbereiche umformen und Teil einer späteren Umhüllung und/oder Verkapselung des optoelektronischen Bauelements sein.

Als Haftvermittlungsmaterial kann beispielsweise ein Silikon, wie ein Siloxan, oder ein BCB verwendet werden. Diese Materialien können sich abgesehen von einer guten haftvermittelnden Wirkung auch durch hohe Stabilität gegenüber kurzwelliger, etwa ultravioletter, Strahlung, hohe Temperaturbeständigkeit und/oder hohe

Strahlungsdurchlässigkeit auszeichnen. Die Haftvermittlungsschicht kann gegebenenfalls, etwa temperaturgestützt, an- oder ausgehärtet werden.

Ferner kann die Stabilisationsschicht als Stabilisationsfolie ausgeführt sein, die auf den Waferverbund, insbesondere auf die Halbleiterschichtenfolge bzw. die Halbleiterfunktionsbereiche, aufgebracht, insbesondere auflaminiert, werden kann. Nach dem Aufbringen kann die Stabilisationsfolie gegebenenfalls gehärtet, insbesondere photogehärtet oder temperaturgehärtet, werden. Nach dem Härten bildet die Stabilisationsfolie mit Vorzug eine mechanisch stabile, vorzugsweise freitragende, Schicht aus. Mit Vorzug ist diese gehärtete Schicht und/oder die Folie strahlungsdurchlässig.

In einer bevorzugten Ausgestaltung der Erfindung wird die Halbleiterschichtenfolge bzw. werden die Halbleiterfunktionsbereiche über die Stabilisationsschicht derart mechanisch stabilisiert, dass die Trägerschicht, vorzugsweise von ihrer der Stabilisationsschicht abgewandten Seite her, strukturiert werden kann. Diese Strukturierung kann beispielsweise über eine Maskierungs- in Kombination mit einem Ätzprozessen oder mechanische Methoden, wie Abschleifen oder Sägen, erfolgen.

Aus dieser Strukturierung gehen bevorzugt Trägerschichtbereiche aus der Trägerschicht hervor, die in den späteren optoelektronischen Bauelementen die Träger der Halbleiterfunktionsbereiche bilden. Hierzu wird die Trägerschicht besonders bevorzugt gemäß der Anordnung der Halbleiterfunktionsbereiche auf der Trägerschicht strukturiert, wobei mit Vorzug auf im wesentlichen jedem Trägerschichtbereich zumindest ein Halbleiterfunktionsbereich angeordnet ist. Die mechanische Stabilität des Verbundes aus Stabilisationsschicht, Halbleiterfunktionsbereich und den strukturierten Trägerschichtbereichen wird vorteilhaft durch die Stabilisationsschicht gewährleistet.
Im oben beschriebenen Verfahren können beispielsweise Bauelemente mit einer Kantenlänge der Halbleiterfunktionsbereiche von 10 µm bis 100 µm, bis 1000 µm oder bis 10 mm hergestellt werden. Eine Kantenlänge von ungefähr 1000 µm hat sich als besonders geeignet erwiesen. Nach unten ist die Kantenlänge bzw. die Dimensionierung der Halbleiterfunktionsbereiche in lateraler Richtung im Prinzip nur durch die Auflösung der im Herstellungsverfahren verwendeten Strukturierungsmethoden, insbesondere den für die Strukturierung der Halbleiterschichtenfolge in Halbleiterfunktionsbereiche oder des Durchbruchs verwendeten Methoden, begrenzt.

Es kann hierbei beispielsweise eine lithographische, insbesondere photolithographische, Methode, mit einer geeignet ausgebildeten Maske in Kombination mit einem Nass- oder Trockenätzverfahren, eine Laserstrukturierungsmethode oder eine mechanische Strukturierungsmethode, wie Sägen, angewandt werden.

Mit besonderem Vorteil kann das komplette Verfahren im Waferverbund durchgeführt werden, so dass kostenintensive Einzelbearbeitungsschritte vermieden werden können. Das Verfahren ermöglicht insbesondere die kostengünstige Herstellung kompletter und gebrauchsfertiger Bauelemente im Waferverbund. Ein derartig hergestelltes optoelektronisches Bauelemente kann, insbesondere unmittelbar nach dem Vereinzeln, beispielsweise mittels eines "Pick and Place"-Prozesses auf einer Leiterplatte positioniert und nachfolgend elektrisch angeschlossen werden. Gegebenenfalls kann das Bauelement in einem zusätzlichen Gehäuse angeordnet werden, wodurch der Schutz des Bauelements weitergehend erhöht werden kann.

In einer weiteren vorteilhaften Ausgestaltung des Verfahrens weist das optoelektronische Bauelement eine Verkapselung auf, die den Halbleiterfunktionsbereich, insbesondere die aktive Zone, im wesentlichen hermetisch dicht umgibt. Bevorzugt umfasst die Verkapselung die Umhüllung des Halbleiterfunktionsbereichs und mindestens ein weiteres Verkapselungselement. Das Verkapselungselement kann mit Vorteil im Waferverbund vorgesehen werden und umhüllt oder umformt den Halbleiterfunktionsbereich vorzugsweise von der der Umhüllung und/oder der Stabilisationsschicht gegenüberliegenden Seite her. Mit Vorteil kann so vereinfacht auf ein zusätzliches Gehäuse bei ausreichendem Schutz des Bauelements verzichtet werden. Die Ausbildung kleiner Bauelemente ohne zusätzliches Gehäuse wird in der Folge erleichtert. Das Verkapselungselement, insbesondere eine Verkapselungsschicht, kann, beispielsweise mittels Spincoating, auf den Waferverbund aufgebracht werden und gegebenenfalls, etwa temperaturgestützt, an- oder ausgehärtet werden. Beispielsweise enthält das Verkapselungselement ein BCB.

Die Umhüllung des Bauelements kann beispielsweise beim Vereinzeln des Verbundes in Bauelemente aus der Stabilisationsschicht hervorgehen und/oder einen Teil der Haftvermittlungsschicht umfassen, die die Halbleiterfunktionsbereiche zumindest teilweise umformen oder umhüllen können.

Insbesondere kann beim oben beschriebenen Verfahren der Verbund durch die Stabilisationsschicht, insbesondere die Umhüllung und/oder das Fenster, das Isolationsmaterial und/oder die Haftvermittlungsschicht hindurch in optoelektronische Bauelemente vereinzelt werden.

In einer bevorzugten Ausgestaltung des Verfahrens werden vor dem Vereinzeln Trennfugen ausgebildet, die sich bis in die den Waferverbund mechanisch stabilisierende Schicht erstrecken.

Die Trennfugen können sich von der der stabilisierenden Schicht abgewandten Seite des Verbundes bis in die stabilisierende Schicht erstrecken. Besonders bevorzugt durchdringen die Trennfugen die stabilisierende Schicht nicht vollständig. Mit Vorteil ist so die Stabilität des Verbundes trotz der Trennfugen in der stabilisierenden Schicht noch gewährleistet. Die Trennfugen sind mit Vorzug derart ausgebildet, dass der Verbund in Einzelelemente zerfällt, falls die Trennfugen die stabilisierende Schicht vollständig durchdringen.

Die stabilisierende Schicht kann beispielsweise, wie oben beschrieben, als Stabilisationsschicht ausgebildet oder durch die Trägerschicht gebildet sein.

Wird die stabilisierende Schicht, insbesondere von der den Halbleiterfunktionsbereichen gegenüberliegenden Seite und/oder in vertikaler Richtung, zumindest bis zu oder in die Trennfugen abgedünnt, so "zerfällt" der Waferverbund in optoelektronische Bauelemente bzw. Vorrichtungen, da aufgrund des Abdünnens bis zu den Trennfugen die stabilisierende Schicht ihre mechanisch stabilisierende Wirkung verliert. Ein derartige Vereinzelungsvariante wird auch als "dicing by thinning" (Trennen bzw. Vereinzeln durch Abdünnen) bezeichnet.

Die Trennfugen sind weiterhin bevorzugt zwischen zwei, insbesondere beliebigen, Halbleiterfunktionsbereichen angeordnet. Besonders bevorzugt umläuft eine Trennfuge einen dieser Trennfuge zugeordneten Halbleiterfunktionsbereich, insbesondere in lateraler Richtung, vollständig.

In einer weiteren bevorzugten Ausgestaltung wird den Halbleiterfunktionsbereichen bzw. der Halbleiterschichtenfolge, insbesondere im Waferverbund, ein Leuchtstoff oder ein Absorptionsstoff nachgeordnet. Bevorzugt wird der Leucht- oder Absorptionsstoff mittels elektrostatischer Kräfte, insbesondere direkt, auf die Halbleiterschichtenfolge bzw. die Halbleiterfunktionsbereiche aufgebracht. Hierdurch wird mit Vorzug eine Leucht- oder Absorptionsstoffschicht ausgebildet.

Bevorzugt wird der auf die Halbleiterschichtenfolge bzw. die Halbleiterfunktionsbereiche aufzubringende Stoff - der Absorptions- oder Leuchtstoff - mittels elektrostatischer Anziehung, insbesondere elektrostatischer Kräfte, auf die Halbleiterschichtenfolge bzw. die Halbleiterfunktionsbereiche aufgebracht. Hierzu wird seitens des Halbleiterfunktionsbereichs beispielsweise eine Hilfsschicht aufgebracht, die nachfolgend elektrostatisch geladen wird und vorzugsweise elektrisch isolierend ist. Der Stoff kann beispielsweise mit einer zur Ladung der Hilfsschicht ungleichnamigen Ladung aufgeladen werden, wodurch eine elektrostatische Anziehung zwischen der Hilfsschicht und dem Stoff erreicht wird. Ist der Stoff elektrisch polarisierbar, so ist ein elektrisches Laden des Stoffes mit Vorteil nicht erforderlich. Die Hilfsschicht ist vorzugsweise elektrisch isolierend ausgebildet. Beispielsweise kann die Hilfsschicht mittels des Isolationsmaterials ausgebildet werden.

Weiterhin wird der Stoff bevorzugt auf die der Trägerschicht oder der Stabilisationsschicht abgewandten Seite des Waferverbunds aufgebracht. Der Stoff kann geeignet strukturiert auf den Verbund aufgebracht oder nach dem Aufbringen geeignet strukturiert werden.

Weiterhin kann der aufzubringende Stoff in einem Stoffgemisch aufgebracht werden, das vorzugsweise zusätzlich zum Absorptions- oder Leuchtstoff ein Haftmaterial aufweist, das die Haftung des Stoffes auf dem Halbleiterfunktionsbereich bzw. der Hilfsschicht erhöht. Das Haftmaterial kann gegebenenfalls unter Temperaturerhöhung an- oder ausgehärtet werden. Als Haftmaterial ist ein Harz, etwa ein Trockenmatrix-Polymerharz (Thermoplast) besonders geeignet. Mittels des Haftmaterials wird die mechanische Anbindung des Stoffes an die Halbleiterschichtenfolge bzw. die Halbleiterfunktionsbereiche verbessert.

Über die Ladung kann insbesondere die Dicke der Stoffschicht eingestellt werden. Beim Aufbringen des Stoffes mittels elektrostatischer Kräfte kann über geeignete Wahl der Ladung die Dicke der aufzubringenden Stoffschicht eingestellt werden. Weiterhin erleichtert ein derartiges Verfahren das Aufbringen einer Stoffschicht mit einer gleichmäßigen Dicke. Die Dicke der Stoffschicht beträgt bevorzugt zwischen 15 und 25 µm.

In einer weiteren bevorzugten Ausgestaltung ist der Leuchtstoff oder der Absorptionsstoff in der Stabilisationsschicht angeordnet. Beispielsweise kann der Leucht- oder Absorptionsstoff in einer, vorzugsweise ebenen, Stabilisationsschicht, insbesondere einer Fensterschicht, angeordnet sein. Hierbei kann eine Filterglasplatte oder eine mit einem Leuchtstoff, insbesondere ein Material der seltenen Erden enthaltend, dotierte oder versetzte Glasplatte als Stabilisationsschicht Anwendung finden.

Entsprechend dem beschriebenen Verfahren werden bevorzugt die weiter oben und im folgenden näher beschriebenen Bauelemente oder Vorrichtungen hergestellt, so dass die hier und im folgenden im Verfahren genannten Merkmale sich auch auf ein Bauelement oder eine Vorrichtung beziehen können und umgekehrt.

Weitere Vorteile, Merkmale und Zweckmäßigkeiten der Erfindung ergeben sich aus der Beschreibung der folgenden Ausführungsbeispiele in Verbindung mit den Figuren.

Es zeigen
Figur 1 ein erstes Ausführungsbeispiel eines erfindungsgemäßen optoelektronischen Bauelements anhand einer schematischen Schnittansicht,
Figur 2 ein zweites Ausführungsbeispiel eines erfindungsgemäßen optoelektronischen Bauelements anhand einer schematischen Schnittansicht,
Figur 3 ein drittes Ausführungsbeispiel eines nicht beanspruchten optoelektronischen Bauelements anhand einer schematischen Schnittansicht,
Figur 4 ein erstes Ausführungsbeispiel eines erfindungsgemäßen Verfahrens zur Herstellung eines optoelektronischen Bauelements anhand von in den Figuren 4a bis 4i in verschiedenen schematischen Ansichten dargestellten Zwischenschritten,
Figur 5 ein Ausführungsbeispiel einer erfindungsgemäßen Vorrichtung mit einer Mehrzahl optoelektronischer Bauelemente,
Figur 6 ein zweites Ausführungsbeispiel eines nicht beanspruchten Verfahrens zur Herstellung eines optoelektronischen Bauelements anhand von in den Figuren 6a bis 6e schematisch dargestellten Zwischenschritten,
Figur 7 eine schematische Schnittansicht einer Variante des Ausführungsbeispiels nach Figur 1,
Figur 8 eine schematische Schnittansicht einer nicht beanspruchten Variante des Ausführungsbeispiels nach Figur 2 und
Figur 9 in den Figuren 9a bis 9i anhand von schematischen Schnittansichten und Aufsichten verschiedene Varianten für die Ausführung der Kontaktstruktur zur elektrischen Kontaktierung des Halbleiterfunktionsbereichs,
Figur 10 ein drittes Ausführungsbeispiel eines erfindungsgemäßen Verfahrens zur Herstellung eines optoelektronischen Bauelements anhand von in den Figuren 10a bis 10k schematisch dargestellten Zwischenschritten und
Figur 11 ein viertes Ausführungsbeispiel eines erfindungsgemäßen Verfahrens zur Herstellung eines optoelektronischen Bauelements anhand von in den Figuren 11a bis 11g schematisch dargestellten Zwischenschritten.

Gleichartige und gleich wirkende Elemente sind in den Figuren mit gleichen Bezugszeichen versehen.

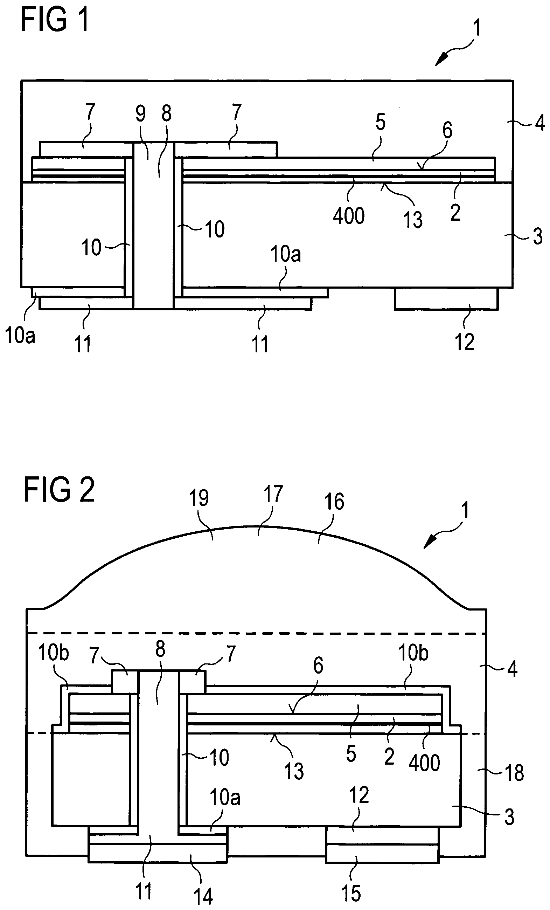

In Figur 1 ist ein erstes Ausführungsbeispiel eines erfindungsgemäßen optoelektronischen Bauelements anhand einer schematischen Schnittansicht dargestellt.

Das optoelektronische Bauelement 1 umfasst einen Halbleiterfunktionsbereich 2, der auf einem Träger 3 angeordnet ist. Der Halbleiterfunktionsbereich umfasst eine zur Strahlungserzeugung oder zum Strahlungsempfang vorgesehene aktive Zone 400 und weist eine laterale Haupterstreckungsrichtung auf.

Die aktive Zone kann beispielsweise eine Heterostruktur, insbesondere eine Doppelheterostruktur, eine Ein- oder Mehrfach-Quantentopfstruktur oder einen pn-Übergang umfassen.

Der Halbleiterfunktionsbereich 2, insbesondere dessen aktive Zone 400, umfasst beispielsweise eine Mehrzahl von Halbleiterschichten und/oder basiert etwa auf GaN oder GaP. Basiert der Halbleiterfunktionsbereich auf GaP, so ist das optoelektronische Bauelement vorzugsweise für Strahlung im infraroten bis gelbgrünen Spektralbereich vorgesehen und bei einem auf GaN basierendem Halbleiterfunktionsbereich vorzugsweise für Strahlung im ultravioletten bis grünen Spektralbereich. Für obige Spektralbereiche sind auf GaP bzw. GaN basierende III-V-Halbleitermaterialien aufgrund der hohen erzielbaren internen Quanteneffizienz besonders geeignet. Für optoelektronische Bauelemente besonders geeignet ist beispielsweise InGaN oder InGaAlP.

Der Träger 3 enthält bevorzugt ein Material, das als Aufwachssubstrat für eine epitaktische Herstellung des Halbleiterfunktionsbereichs geeignet ist bzw. der Träger ist bevorzugt aus einem geeigneten Aufwachssubstrat für die Herstellung des Halbleiterfunktionsbereichs gebildet. Für einen auf GaP-basierenden Halbleiterfunktionsbereich ist z.B. GaAs oder Ge, für einen auf GaN-basierenden Halbleiterfunktionsbereich z.B. SiC oder Saphir für ein Aufwachssubstrat besonders geeignet.

Die aktive Zone 400 weist einen als Aussparung 9, die den Halbleiterfunktionsbereich vollständig durchdringt, ausgebildeten Durchbruch auf. Im Bereich des Durchbruchs ist ein Verbindungsleitermaterial 8 angeordnet. Die Aussparung ist in lateraler Richtung mit Vorzug vollständig vom Halbleiterfunktionsbereich umgeben und wird demnach vom Halbleiterfunktionsbereich lateral begrenzt.

Der Halbleiterfunktionsbereich ist von einer Umhüllung 4 umgeben, die vorzugsweise strahlungsdurchlässig ausgebildet ist und beispielsweise ein Silikon, ein BCB, ein Glas, ein Spin-on-Oxid, wie Al₂O₃, oder einen Lack enthält.

Auf dem Halbleiterfunktionsbereich 2 ist, vorzugsweise auf der dem Träger 3 abgewandten Seite des Halbleiterfunktionsbereichs, eine Stromaufweitungsschicht 5 angeordnet. Die Stromaufweitungsschicht weist mit Vorteil gute elektrische Kontakteigenschaften zum seitens des Halbleiterfunktionsbereichs angeordneten, insbesondere angrenzenden, Halbleitermaterial auf.

Die Stromaufweitungsschicht weist weiterhin bevorzugt eine hohe Leitfähigkeit in lateraler Richtung auf, um einen homogenen Stromeintrag von der ersten Hauptfläche 6 des Halbleiterfunktionsbereichs her in den Halbleiterfunktionsbereich, insbesondere die aktive Zone, zu erleichtern. Dies ist für strahlungsemittierende Bauelemente von besonderem Vorteil.

Ferner zeichnet sich die Stromaufweitungsschicht bevorzugt durch hohe Durchlässigkeit gegenüber einer im Halbleiterfunktionsbereich 2 zu erzeugenden oder vom Halbleiterfunktionsbereich zu empfangenden Strahlung aus. Dadurch wird die Absorption von Strahlung in der Stromaufweitungsschicht bei gleichzeitig guten elektrischen Kontakteigenschaften vorteilhaft verringert.

In einer bevorzugten Ausgestaltung der Erfindung enthält die Stromaufweitungsschicht ein strahlungsdurchlässiges leitfähiges Oxid, insbesondere ein Metalloxid, etwa ein sogenanntes TCO (Transparent Conducting Oxide). TCO-Materialien, beispielsweise ein Zinkoxid, etwa ZnO, ein Zinnoxid, etwa SnO, ein Indiumzinnoxid, etwa ITO, ein Titanoxid, etwa TiO, oder ähnliche Materialien sind wegen der vergleichsweise hohen Leitfähigkeit in lateraler Richtung und hoher Strahlungsdurchlässigkeit über einen weiten Wellenlängenbereich gut als Materialien für die Stromaufweitungsschicht geeignet. ZnO beispielsweise ist für den Kontakt zu p-leitenden Halbleitermaterialien, insbesondere III-V-Halbleitermaterialien, besonders geeignet und kann zu diesen einen im wesentlichen ohmschen Kontakt ausbilden. Zur Erhöhung der Leitfähigkeit in lateraler Richtung kann die Stromaufweitungsschicht, z. B. mit einem Metall, wie Al im Falle von ZnO, dotiert sein. Für einen Kontakt zu n-leitendem Halbleitermaterial ist beispielsweise SnO, eventuell mit Sb dotiert, besonders geeignet. Im Gegensatz zu Halbleitermaterialien, die monolithisch im Halbleiterfunktionsbereich integrierbar sind, weist eine derartige Stromaufweitungsschicht eine vorteilhaft hohe Leitfähigkeit in lateraler Richtung auf. Auf eine vergleichsweise dicke, im Halbleiterfunktionsbereich integrierte Halbleiterschicht zur Stromaufweitung kann daher verzichtet werden. Hierdurch wird die Ausbildung flacher Bauelemente erleichtert.

Der Stromaufweitungsschicht 5 ist von der ersten Hauptfläche 6 des Halbleiterfunktionsbereichs aus gesehen, vorzugsweise unmittelbar, eine erste Kontaktschicht 7 nachgeordnet und mit der Stromaufweitungsschicht elektrisch leitend verbunden. Die erste Kontaktschicht enthält vorzugsweise ein Metall, beispielsweise Ti, Pt, Au, Al oder eine Legierung mit mindestens einem dieser Materialien.

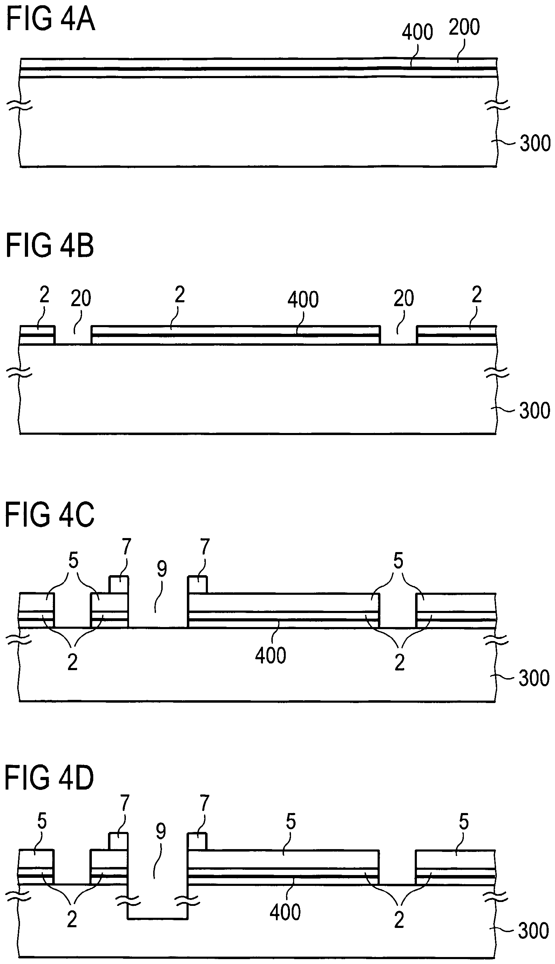

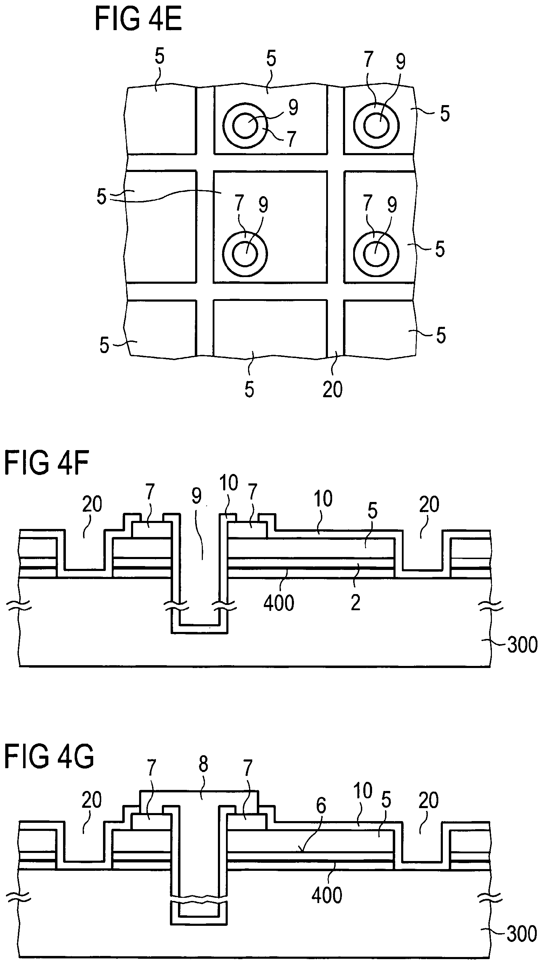

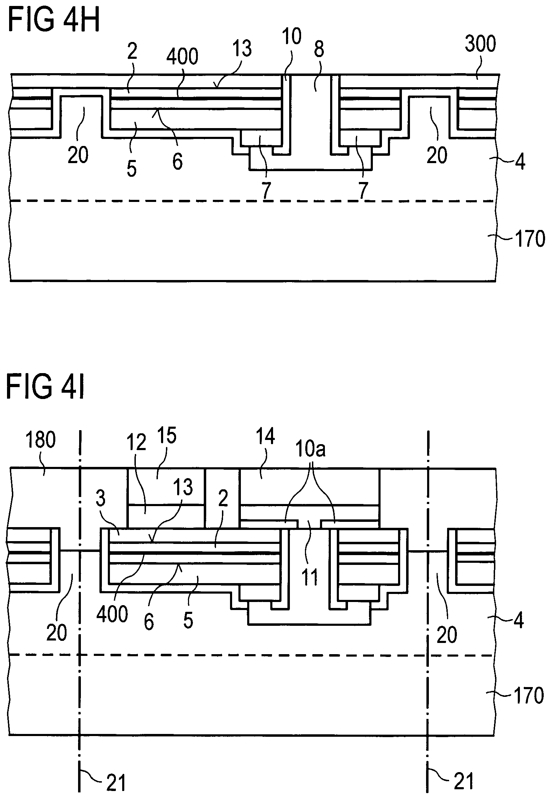

Die erste Kontaktschicht ist mit Vorzug in Aufsicht im wesentlichen ringförmig ausgebildet (vgl. die schematische Aufsicht in Figur 4e). In ihrem Mittenbereich ist die Kontaktschicht 7 elektrisch leitend mit einem Verbindungsleitermaterial 8 verbunden, das beispielsweise ebenfalls ein Metall, wie Sn, enthält. Sn ist für die Herstellung eines derartigen optoelektronischen Bauelements besonders vorteilhaft, insbesondere bei der Herstellung des Verbindungsleiters, den das Verbindungsleitermaterial 8 ausbildet (vgl. die Beschreibung des Ausführungsbeispiels in Verbindung mit Figur 4).

Das Verbindungsleitermaterial 8 erstreckt sich in vertikaler Richtung durch den Durchbruch der aktiven Zone im Halbleiterfunktionsbereich 2 von der ersten Kontaktschicht 7 über den Bereich der Stromaufweitungsschicht 5 und den Halbleiterfunktionsbereichs 2 sowie durch den Träger 3 zu der dem Halbleiterfunktionsbereich gegenüberliegenden Seite des Trägers. Der Durchbruch durchdringt gemäß dem vorliegenden Ausführungsbeispiel somit bevorzugt nicht nur den Halbleiterfunktionsbereich, sondern auch den Träger 3 vollständig. Im Bereich des Trägers ist der Durchbruch mit Vorzug als Aussparung ausgebildet, die mit besonderem Vorzug in lateraler Richtung vollständig vom Träger begrenzt ist.

Der Halbleiterfunktionsbereich 2 und insbesondere die aktive Zone 400 sind durch ein Isolationsmaterial 10, beispielsweise SiN enthaltend, im Bereich des Durchbruchs vom elektrisch leitenden Verbindungsleitermaterial 8 elektrisch isoliert. Dadurch werden nachteilige, im Betrieb zu einer Fehlfunktion des Bauelements führende Kurzschlüsse der aktiven Zone 400 über das Verbindungsleitermaterial 8 vermieden. Die Aussparung 9 ist im wesentlichen vollständig mit dem Verbindungsleitermaterial gefüllt und zumindest im Bereich des Halbleiterfunktionsbereichs elektrisch von diesem isoliert. Das Isolationsmaterial 10 kleidet die Wand der Aussparung im Halbleiterfunktionsbereich, insbesondere an der aktiven Zone, bevorzugt vollständig aus.

Das Verbindungsleitermaterial 8 ist auf der dem Halbleiterfunktionsbereich 2 abgewandten Seite des Trägers mit einem ersten Anschluß 11 elektrisch leitend verbunden. Zwischen dem ersten Anschluß und dem Träger ist ein weiteres Isolationsmaterial 10a, beispielsweise SiN enthaltend, angeordnet. Dieses weitere Isolationsmaterial isoliert den ersten Anschluß elektrisch von einem zweiten Anschluß 12, der auf der dem Halbleiterfunktionsbereich abgewandten Seite des Trägers angeordnet ist. Bevorzugt weist das weitere Isolationsmaterial 10a eine größere Ausdehnung in lateraler Richtung auf als der erste Anschluss, um die Gefahr eines Kurzschlusses der Anschlüsse 11 und 12 weiter zu verringern.

Der Anschluß 12 ist mit dem Träger, der vorzugsweise elektrisch leitend ausgeführt ist, leitend verbunden, so dass der Halbleiterfunktionsbereich über den ersten Anschluß und den zweiten Anschluß elektrisch ansteuerbar ist. Beispielsweise enthalten der erste und/oder der zweite Anschluß ein Metall, wie Ti, Pt, Al oder Au. Auch Legierungen, insbesondere Legierungen mit mindestens einem dieser Metalle, etwa AuGe, sind für die Ausbildung der Anschlüsse geeignet.

Die Kontaktierung des Bauelements erfolgt durch den Halbleiterfunktionsbereich und insbesondere den Bereich der aktiven Zone, weshalb das Isolationsmaterial 10 bevorzugt dick genug ist, um einen Kurzschluß der aktiven Zone über das Verbindungsleitermaterial zu verhindern. Die Aussparung ist bevorzugt vollflächig mit dem Isolationsmaterial ausgekleidet.

Die Umhüllung 4 bildet zusammen mit dem Träger 3 eine schützende Verkapselung für die aktive Zone bzw. den Halbleiterfunktionsbereich.

Das hier dargestellte optoelektronische Bauelement 1 ist komplett im Waferverbund herstellbar (vgl. die schematische Darstellung der Herstellung ähnlicher Bauelemente gemäß dem in Figur 4 beschriebenen Ausführungsbeispiel).

Der Halbleiterfunktionsbereich ist beispielsweise epitaktisch auf einem Aufwachssubstrat, aus dem der Träger 3 hervorgehen kann, hergestellt und kann nach dem Aufwachsen mit der Stromaufweitungsschicht 5 versehen werden. Nachfolgend kann die Leiterstruktur mit dem als Aussparung 9 ausgebildeten Durchbruch sowie dem Isolations- und dem Verbindungsleitermaterial und der ersten Kontaktschicht ausgebildet werden. Hierauf wird seitens der ersten Hauptfläche des Halbleiterfunktionsbereichs ein Umhüllungsmaterial, vorzugsweise in der flüssigen Phase, auf den Halbleiterfunktionsbereich und den Träger aufgebracht. Dieses Umhüllungsmaterial kann beispielsweise aufgedampft oder durch Spincoating aufgebracht werden. Von der zweiten Hauptfläche 13 des Halbleiterfunktionsbereichs her werden das Isolationsmaterial 10a und der erste Anschluß 11 sowie der zweite Anschluß 12, beispielsweise durch Aufdampfen oder Aufsputtern, vorgesehen.

Ein derartiges Bauelement kann in verschiedenen Größen hergestellt werden. Diesen verschiedenen Größen können auch verschiedene Dimensionierungen der Kontaktstruktur des Bauelements und insbesondere des Durchbruchs bzw. der Aussparung 9 entsprechen. Die laterale Ausdehnung des Halbleiterfunktionsbereichs kann beispielsweise von 10 µm bis einigen 100 µm, etwa 200 µm, 300 µm oder 400 µm, reichen. Hierbei beträgt die laterale Abmessung, etwa der Durchmesser, des Durchbruchs bzw. der Aussparung entsprechend 100 oder einige 100 nm bis ungefähr 30 µm oder 50 µm. Durch geeignete Abstimmung der lateralen Bemessung des Verbindungsleitermaterials und der Anzahl der Aussparungen - anders als dargestellt kann auch eine Mehrzahl von Aussparungen vorgesehen sein - kann die zur effizienten Kontaktierung des Halbleiterfunktionsbereichs erforderliche Leitfähigkeit bzw. Stromtragfähigkeit der Verbindungsleiterstruktur realisiert werden. Die Kontaktierung des Halbleiterfunktionsbereichs bzw. des Bauelements kann über Anschlüsse 11 und 12 erfolgen, die beide seitens der zweiten Hauptfläche des Halbleiterfunktionsbereichs angeordnet sind. Das optoelektronische Bauelement ist demnach insbesondere oberflächenmontierbar ausgebildet. Beispielsweise können die Anschlüsse 12 und 13 mit Leiterbahnen einer Leiterplatte verlötet werden.

Auf einen elektrischen Kontakt, der eine Kontaktierung des Halbleiterfunktionsbereichs mittels eines Bonddrahts oder ähnlich komplizierter Maßnahmen erfordert, kann somit vorteilhaft verzichtet werden. Die Ausbildung sehr kleiner Bauelemente wird in der Folge erleichtert.

Weiterhin kann zumindest teilweise auf den Träger verzichtet werden, da die Umhüllung vorzugsweise mechanisch stabilisierende Wirkung auf den Halbleiterfunktionsbereich hat. Folglich kann die Trägerschicht der Halbleiterschichtenfolge bzw. der Träger des Halbleiterfunktionsbereichs bei der Herstellung des Bauelements zumindest teilweise oder vollständig entfernt bzw. abgedünnt werden, was beispielsweise durch Abschleifen oder Ätzen erfolgen kann. Hierdurch wird die Bauelementhöhe vorteilhaft verringert.

Der Halbleiterfunktionsbereich eines derartigen Bauelements kann demnach aus einer, insbesondere epitaxisch, aufwachsbaren Schichtstruktur gebildet sein. Auf einen den Halbleiterfunktionsbereich stabilisierenden Träger kann verzichtet werden. Im Extremfalle umfasst der Halbleiterfunktionsbereich im wesentlichen nur die aktive Zone 400.

In der Umhüllung kann weiterhin ein Leuchtstoff, etwa in der Form von Leuchtstoffpartikeln, angeordnet sein, der vom Halbleiterfunktionsbereich erzeugte Strahlung zum Teil absorbiert und als Strahlung einer größeren Wellenlänge reemittiert. Die beiden Strahlungen können sich in der Folge mischen, so dass mischfarbiges Licht, insbesondere weißes Licht, entstehen kann. Soll das Bauelement weißes Licht emittieren, so basiert der Halbleiterfunktionsbereich mit Vorzug auf GaN, das zur Erzeugung kurzwelliger, insbesondere blauer oder ultravioletter Strahlung, besonders geeignet ist. Der Leuchtstoff ist mit Vorzug als YAG-basierender Leuchtstoff ausgeführt und konvertiert beispielsweise blaue Strahlung zum Teil in gelbe Strahlung. Aus geeigneter Mischung der blauen und gelben Strahlungsanteile ergibt sich weißes Licht.

Gegebenenfalls kann der Leuchtstoff als Leuchtstoffschicht, die zwischen der Umhüllung und dem Halbleiterfunktionsbereich angeordnet sein kann, auf dem Halbleiterfunktionsbereich angeordnet sein. Mit Vorzug ist der Leuchtstoff in diesem Falle mittels elektrostatischer Kräfte auf den Halbleiterfunktionsbereich aufgebracht.

In der Figur 2 ist ein zweites Ausführungsbeispiel eines erfindungsgemäßen optoelektronischen Bauelements anhand einer schematischen Schnittansicht dargestellt.

Das hier gezeigte Bauelement entspricht im wesentlichen dem in Figur 1 dargestellten Bauelement.

Im Unterschied zu dem in Figur 1 gezeigten Bauelement ist in Figur 2 der Stromaufweitungsschicht 5 ein weiteres Isolationsmaterial 10b nachgeordnet. Diese Isolationsmaterialschicht kann beispielsweise SiN enthalten und wirkt nicht nur isolierend, sondern bevorzugt auch schützend oder passivierend bezüglich des Halbleiterfunktionsbereichs 2 und insbesondere dessen aktiver Zone. Das Isolationsmaterial 10b ist mit Vorzug auch an den Flanken des Halbleiterfunktionsbereichs 2 angeordnet und erstreckt sich mit besonderem Vorzug in vertikaler Richtung von der ersten Hauptfläche 6 bis zur zweiten Hauptfläche 13 des Halbleiterfunktionsbereichs. Der Schutz der aktiven Zone vor schädlichen äußeren Einflüssen wird durch diese zusätzliche Isolations- bzw. Passivierungsschicht weitergehend erhöht. Die elektrische Kontaktierung des Bauelements erfolgt wie bei dem Bauelement in Figur 1 über das erste Kontaktmaterial 7 seitens der ersten Hauptfläche 6 des Halbleiterfunktionsbereichs 2, das elektrisch leitend mit dem Verbindungsmaterial 8 verbunden ist.

Die Passivierungsschicht schützt weiterhin die seitlichen Flanken des Halbleiterfunktionsbereichs und ist bevorzugt an diesem angeordnet. Weiterhin kann die Passivierungsschicht 10b auf dem Träger 3 angeordnet sein.

Zwischen der Umhüllung 4 und dem Halbleiterfunktionsbereich, insbesondere zwischen Passivierungsschicht und Umhüllung, kann eine oder eine Mehrzahl von Antireflexionsschichten, die etwa als λ/4-Schicht ausgeführt sein können, angeordnet sein. Insbesondere kann die Passivierungsschicht als Antireflexionsschicht ausgeführt sein. Dadurch können durch Brechungsindexsprünge verursachte Reflexionsverluste an Grenzflächen mit Vorteil vermindert werden.

Das Verbindungsleitermaterial 8 ist mit dem ersten Anschluß 11 elektrisch leitend verbunden, der über das Isolationsmaterial 10a seitens der dem Halbleiterfunktionsbereich gegenüberliegenden Hauptfläche des Trägers elektrisch vom zweiten Anschluß 12 isoliert ist. Auf der dem Träger abgewandten Seite der Anschlüsse 11 und 12 ist jeweils eine erste 14 bzw. eine zweite Lotschicht 15 angeordnet. Diese Lotschichten enthalten beispielsweise AuGe und sind mit den jeweiligen Anschlüssen vorzugsweise elektrisch leitend verbunden. Über derartige Lotschichten wird die Verbindung, z.B. über Löten, der Anschlüsse 11 und 12 mit externen Anschlüssen, beispielsweise den Leiterbahnen einer Leiterplatte oder ähnlichen externen Leitervorrichtungen, erleichtert.

Weiterhin ist im Unterschied zu dem Ausführungsbeispiel nach Figur 1 das in Figur 2 dargestellte optoelektronische Bauelement mit einer Verkapselung 16 versehen. Diese Verkapselung umfaßt ein Fenster 17, das der Umhüllung 4, die den Halbleiterfunktionsbereich zumindest teilweise umhüllt bzw. in die der Halbleiterfunktionsbereich eingebettet ist, von der ersten Hauptfläche des Halbleiterfunktionsbereichs aus gesehen nachgeordnet ist. Weiterhin umfaßt die Verkapselung 16 ein Verkapselungselement 18, das der Umhüllung 4 in Richtung des Trägers nachgeordnet bzw. auf der der ersten Hauptfläche gegenüberliegenden Seite des Halbleiterfunktionsbereichs angeordnet ist. Das Verkapselungselement 18 umgreift den Träger 3 vorzugsweise von seiner dem Halbleiterfunktionsbereich 2 abgewandten Seite her beispielsweise zangenartig. Insbesondere kann das Verkapselungselement 18 im Bereich der zweiten Hauptfläche 13 des Halbleiterfunktionsbereichs 2 an die Umhüllung 4 angrenzen. Die Verkapselung 16, die die Umhüllung 4 und das Verkapselungselement 18 und gegebenenfalls das Fenster 17 umfassen kann, kann mit Vorteil im Waferverbund ausgebildet werden.

Die gestrichelten Linien in Figur 2 im Bereich der Umhüllung 4 und des Verkapselungselements 18 geben die Grenzbereiche zwischen den verschiedenen Teilen der Verkapselung an. Mit Vorteil können die Umhüllung 4 und das Verkapselungselement 18 bereits eine im wesentlichen hermetisch gegenüber äußeren Einflüssen dichte Verkapselung ausbilden. Das Material des Verkapselungselements kann mit Vorteil beliebig im Rahmen der Fertigungsmöglichkeiten gewählt werden und kann insbesondere im wesentlichen strahlungsundurchlässig ausgebildet sein, da im Bereich des Verkapselungselements 18 nur in geringem Maße eine vom Halbleiterfunktionsbereich zu empfangende oder im Halbleiterfunktionsbereich zu erzeugende Strahlung auf die Verkapselung trifft. Das Fenster 17 und die Umhüllung 4 sind bevorzugt strahlungsdurchlässig bezüglich dieser Strahlung ausgebildet, um die Effizienz des Bauelements mit Vorteil zu erhöhen.

Das Fenster 17 kann beispielsweise ein Glas, einen Teil einer Glasplatte oder im wesentlichen das gleiche Material wie die Umhüllung enthalten. Im letzteren Falle können die Umhüllung 4 und das Fenster 17 mit Vorteil in einem Verfahrensschritt ausgebildet werden. Insbesondere können Umhüllung und Fenster einstückig in einer gemeinsamen Struktur ausgebildet sein. In diesem Fall entspricht die gestrichelte Linie zwischen dem Fenster und der Umhüllung einer gedachten Linie. Sind das Fenster und die Umhüllung jedoch zweistückig realisiert, so kennzeichnet die gestrichelte Linie den Grenzbereich zwischen diesen Elementen.

Im Fenster 17 ist in diesem Ausführungsbeispiel ein optisches Element 19 ausgebildet. Dieses optische Element kann mit Vorteil bereits im Waferverbund vorgesehen werden. Hierzu wird das Fenstermaterial auf geeignete Weise strukturiert. Bei einer einstückigen Ausbildung der Umhüllung und des Fensters kann die Umhüllung insbesondere der Ausbildung des optischen Elements entsprechend geformt sein. Die Strukturierung des Fensters kann beispielsweise durch Ätzprozesse oder Einstempeln der Struktur des optischen Elements in das gegebenenfalls nach dem Aufbringen noch plastisch formbare Fenstermaterial erreicht werden. In diesem Ausführungsbeispiel ist das optische Element nach Art einer Linse gewölbt ausgebildet und erhöht mit Vorteil die Effizienz des optoelektronischen Bauelements. Weiterhin kann ein Streuelement zur homogenen Strahlungsverteilung vorgesehen sein, das z.B. mittels einer Streustruktur, etwa aus dem Fenster strukturiert, oder Streupartikeln, etwa in dem Fenster und/oder der Umhüllung angeordnet, realisiert sein kann. Das optische Element kann gegebenenfalls auch als Fresnellinse ausgeführt sein.

Bei der Verbindung der Lotschichten 14 und 15 mit externen Leitern wird im Lötvorgang das Lot gewöhnlich hohen Temperaturen ausgesetzt, so dass es zumindest teilweise aufweicht. Mit Vorteil verbindet sich das Lot während des Lötvorgangs in den Grenzbereichen zum Verkapselungselement mit dem Material des Verkapselungselements derart, dass die Verkapselung des optoelektronischen Bauelements weitergehend abgedichtet wird.

Die Teile der Verkapselung, insbesondere das Verkapselungselement 18 und die Umhüllung 4, sind vorzugsweise so beschaffen, dass sie gegenüber den beim Löten auftretenden Temperaturen zumindest in einem Zeitraum, der dem des Lötprozesses entspricht, im wesentlichen beständig, vorzugsweise formbeständig, sind.

Das Fenster 17 kann gemeinsam mit der Umhüllung 4 ausgebildet werden oder beispielsweise auf der Umhüllung aufgeklebt werden. Vorzugsweise hat die Umhüllung im letzteren Falle bereits eine haftvermittelnde Wirkung, so dass auf eine zusätzliche Klebeschicht zwischen dem Fenster und der Umhüllung verzichtet werden kann. Dies kann wegen der geringeren Anzahl von Grenzflächen Vorteile für die Strahlungsauskopplung oder -einkopplung aus bzw. in den Halbleiterfunktionsbereich haben.

Wird das Fenster 17 über eine Klebeverbindung auf der Umhüllung 4 angeordnet, so enthält die Umhüllung bevorzugt Silikon oder BCB, die eine haftvermittelnde Wirkung bezüglich der Umhüllung und des Fenstermaterials aufweisen können. Dies gilt insbesondere für Fenster, die ein Glas enthalten oder aus einer Glasplatte gefertigt sind.

Ein Leuchtstoff, insbesondere zur Erzeugung mischfarbigen Lichts, ist vorzugsweise in der Umhüllung 4 möglichst nahe an der aktiven Zone angeordnet. Insbesondere kann das Umhüllungsmaterial als Trägermatrix für Leuchtstoffpartikel dienen, die in der Folge gemeinsam mit dem Material der Umhüllung auf den Halbleiterfunktionsbereich aufgebracht werden können. Die Gefahr einer Degradation der Umhüllung bzw. des Fensters aufgrund energiereicher kurzwelliger Strahlung wird durch Wellenlängenkonversion nahe am Halbleiterfunktionsbereich verringert.

Abweichend von der Darstellung in den Figuren 1 und 2 ist auf der dem Träger zugewandten Seite des Halbleiterfunktionsbereichs eine Spiegelschicht, beispielsweise ein, insbesondere im Halbleiterfunktionsbereich monolithisch integrierter, Bragg-Spiegel oder eine metallhaltige, insbesondere metallische, Spiegelschicht, beispielsweise Au, Pt, Al oder eine Legierung mit mindestens einem dieser Metalle, wie etwa AuGe, enthaltend, angeordnet. Der Träger 3 ist im Falle einer metallischen Spiegelschicht bevorzugt verschieden vom Aufwachssubstrat der Halbleiterschichtenfolge, aus der der Halbleiterfunktionsbereich vorzugsweise im Waferverbund ausgebildet wird. Das Aufwachssubstrat wird nach dem Aufbringen der Spiegelschicht auf die dem Aufwachssubstrat abgewandte Seite des Halbleiterfunktionsbereichs bzw. der Halbleiterschichtenfolge abgelöst. Vor dem Ablösen des Aufwachssubstrats wird der Halbleiterfunktionsbereich bzw. die Halbleiterschichtenfolge, insbesondere seitens der Spiegelschicht, auf einer Trägerschicht befestigt oder angeordnet, aus der der Träger 3 des Dünnfilm-Bauelements beim Vereinzeln hervorgeht. Der Träger 3 ist hierbei insbesondere vom Aufwachssubstrat verschieden.

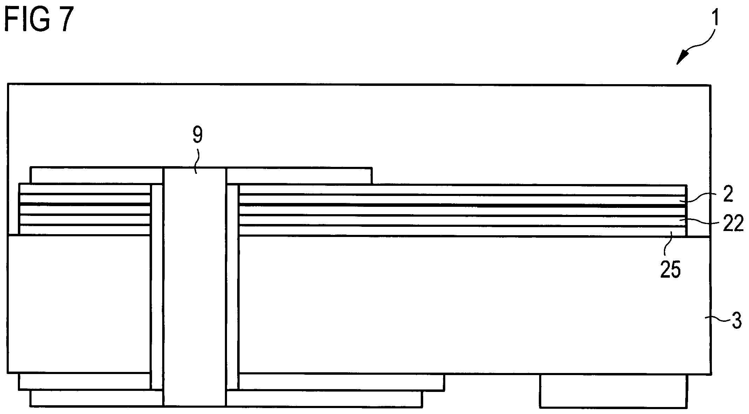

Eine dementsprechende Variante des Ausführungsbeispiels gemäß Figur 1 ist in Figur 7 anhand einer Schnittansicht schematisch dargestellt. Zwischen dem vom Aufwachssubstrat verschiedenen Träger 3 und dem Halbleiterfunktionsbereich 2 ist die metallhaltige Spiegelschicht 22, etwa Au oder Ag enthaltend, angeordnet. Zwischen der Spiegelschicht und dem Träger 3 ist vorzugsweise eine Verbindungsschicht 25, etwa eine Lotschicht, angeordnet, über die der Halbleiterfunktionsbereich mechanisch stabil auf dem Träger befestigt ist. Der als Aussparung 9 ausgebildete Durchbruch durchdringt insbesondere den Halbleiterfunktionsbereich 2, die Spiegelschicht 22 und die Verbindungsschicht 25.

Abweichend von der Darstellung in Figur 2 kann weiterhin auf den Träger 3 verzichtet werden. Insbesondere wenn die Umhüllung und/oder die Fensterschicht den Halbleiterfunktionsbereich 2, vorzugsweise vollständig, mechanisch stabilisieren, kann der Träger abgedünnt oder, insbesondere vollständig, entfernt werden, ohne die Gefahr einer Schädigung des Halbleiterfunktionsbereichs wesentlich zu erhöhen. Hierdurch wird die Ausbildung dünner optoelektronischer Bauelemente erleichtert. Wird auf den Träger des Halbleiterfunktionsbereichs verzichtet, so kann das Verkapselungselement 18 seitens der zweiten Hauptfläche 13 des Halbleiterfunktionsbereichs im wesentlichen eben verlaufen bzw. das Verkapselungselement kann als ebene Schicht ausgeführt sein.

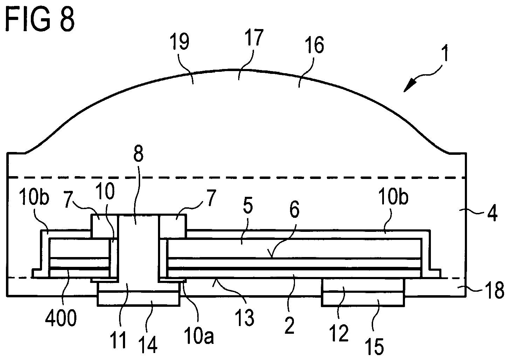

Eine dementsprechende Variante des Ausführungsbeispiels gemäß Figur 2 ist in Figur 8 anhand einer Schnittansicht schematisch dargestellt. Im Unterschied zu dem in Figur 2 gezeigten Ausführungsbeispiel ist das Bauelement 1 in dem Ausführungsbeispiel gemäß Figur 8 frei von einem Träger des Halbleiterfunktionsbereichs 2. Der Halbleiterfunktionsbereich kann hierbei als monolithisch integrierte, etwa epitaxierbare, Halbleiterschichtstruktur ausgebildet sein. Insbesondere können sämtliche Halbleiterkomponenten des Bauelements monolithisch integriert sein. Das Verkapselungselement 18 grenzt direkt an die zweite Hauptfläche des Halbleiterfunktionsbereichs 2 an. Weiterhin grenzt das Verkapselungselement 18 an die Umhüllung 4 an.

Optoelektronische Bauelemente, wie in Figur 2 oder den Varianten gemäß den Figuren 7 und 8 gezeigt, können einschließlich der Verkapselung komplett im Waferverbund hergestellt werden.

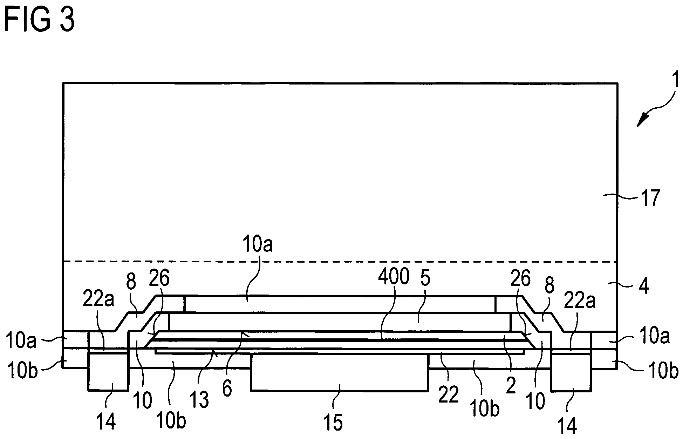

In Figur 3 ist ein weiteres Ausführungsbeispiel eines erfindungsgemäßen optoelektronischen Bauelements anhand einer schematischen Schnittansicht dargestellt.

Das optoelektronische Bauelement 1 ist in diesem Ausführungsbeispiel als sogenanntes Dünnfilm-Bauelement ausgeführt. Dünnfilm-Bauelement bedeutet hierbei, wie bereits weiter oben erwähnt, dass während des Herstellungsprozesses das Aufwachssubstrat einer Halbleiterschichtenfolge, aus der der Halbleiterfunktionsbereich 2 ausgebildet wird, entfernt wird. Das Aufwachssubstrat kann beispielsweise über ein Laserablations- oder trennverfahren, Ätzen oder mechanische Methoden entfernt werden. Vor oder nach dem Entfernen des Aufwachssubstrats wird die Halbleiterschichtenfolge oder der Halbleiterfunktionsbereich bevorzugt mit einer, besonders bevorzugt metallhaltigen, Spiegelschicht versehen. Die Spiegelschicht kann die Effizienz des optoelektronischen Bauelements verbessern. Beispielsweise kann die Spiegelschicht die Absorption von im Halbleiterfunktionsbereich erzeugter Strahlung in einer auf der dem Halbleiterfunktionsbereich gegenüberliegenden Seite der Spiegelschicht angeordneten Struktur, wie beispielsweise einer Leiterplatte, verringern.

In Figur 3 ist ein Dünnfilm-Bauelement dargestellt, das in Gänze im Waferverbund herstellbar ist.

Das optoelektronische Bauelement 1 umfasst einen Halbleiterfunktionsbereich 2 mit einer aktiven Zone 400 und einer lateralen Haupterstreckungsrichtung, wobei der Halbleiterfunktionsbereich eine laterale, die aktive Zone begrenzende Seitenfläche 26 aufweist und der Seitenfläche in lateraler Richtung nachgeordnet ein Verbindungsleitermaterial 8 angeordnet ist, das von der aktiven Zone 400 zumindest in einem Teilbereich der Seitenfläche 26 elektrisch isoliert ist. Insbesondere kann die Seitenfläche 26 eben, das heißt frei von einer Vertiefung in lateraler Richtung, ausgeführt sein.

Das Verbindungsleitermaterial 8 ist in lateraler Richtung vom Halbleiterfunktionsbereich im Bereich der Seitenfläche mittels des Isolationsmaterials 10, das vorzugsweise direkt an die Seitenfläche 26 angrenzt, von der aktiven Zone 400 isoliert. Das Verbindungsleitermaterial ist hierzu insbesondere mittels des Isolationsmaterials in lateraler Richtung von der Seitenfläche beabstandet. Insgesamt wird so die Gefahr eines Kurzschlusses der aktiven Zone durch das Verbindungsleitermaterial zumindest stark verringert.

Die Seitenfläche 26 begrenzt mit Vorzug den Halbleiterfunktionsbereich über seine gesamte vertikale Ausdehnung. Der Halbleiterfunktionsbereich 2 bzw. die aktive Zone 400 kann weiterhin allseitig durch derartig ausgebildete Seitenflächen begrenzt sein. Insbesondere kann der Halbleiterfunktionsbereich 2 bzw. die aktive Zone 400 durch eine Mehrzahl von Seitenflächen in lateraler Richtung begrenzt sein.

Dem Halbleiterfunktionsbereich 2, der beispielsweise auf GaN oder GaP basiert, ist seitens seiner ersten Hauptfläche 6 eine Stromaufweitungsschicht 5 nachgeordnet. Die Stromaufweitungsschicht 5 kann beispielsweise ein TCO-Material, wie ZnO, oder ein geeignetes III-V-Halbleitermaterial umfassen. Da III-V-Halbleitermaterialien, insbesondere solche, die epitaktisch gemeinsam mit dem Halbleiterfunktionsbereich hergestellt werden können, in der Regel eine relativ geringe Leitfähigkeit in lateraler Richtung aufweisen, sind TCO-Materialien jedoch bevorzugt.

Der Halbleiterfunktionsbereich 2 ist seitens seiner ersten Hauptfläche 6 über die Stromaufweitungsschicht 5 elektrisch leitend mit dem Verbindungsleitermaterial 8 verbunden. Das Verbindungsleitermaterial erstreckt sich dabei in vertikaler Richtung von der ersten Hauptfläche bis zur zweiten Hauptfläche 13 des Halbleiterfunktionsbereichs.

Seitens der zweiten Hauptfläche des Halbleiterfunktionsbereichs ist diesem eine Spiegelschicht 22 nachgeordnet. Die Spiegelschicht enthält vorzugsweise ein Metall, beispielsweise Ti, Au, Pt, Ag, Al oder eine Legierung mit mindestens einem dieser Metalle, etwa AuGe. Die Spiegelschicht 22 ist bevorzugt bezüglich einer vom optoelektronischen Bauelement zu erzeugenden oder zu empfangenen Strahlung reflektierend ausgebildet und erhöht mit Vorteil die Effizienz des Bauelements. Die Spiegelschicht kann, insbesondere direkt, auf dem Halbleiterfunktionsbereich angeordnet sein.

Ist das optoelektronische Bauelement beispielsweise als Sender ausgebildet, so wird im Betrieb des Bauelements in der aktiven Zone des Halbleiterfunktionsbereichs Strahlung erzeugt. Strahlung, die von der aktiven Zone in Richtung des Spiegels emittiert wird, wird von der Spiegelschicht in Richtung der ersten Hauptfläche 6 des Halbleiterfunktionsbereichs 2 reflektiert und kann das Bauelement über die Stromaufweitungsschicht 5, die Umhüllung 4 und gegebenenfalls über ein der Umhüllung nachgeordneten Fenster 17 verlassen. Mit Vorteil wird durch die Spiegelschicht 22 der in Richtung der zweiten Hauptfläche aus dem Bauelement austretende Strahlungsanteil erheblich reduziert, so dass die Absorption in Strukturen, die der Spiegelschicht vom Halbleiterfunktionsbereich aus gesehen, wie etwa eine Leiterplatte, nachgeordnet sein können, zumindest stark reduziert wird.

Die Spiegelschicht 22 ist auf ihrer dem Halbleiterfunktionsbereich abgewandten Seite elektrisch leitend mit einer Lotschicht 15 verbunden. Das Verbindungsleitermaterial 8 ist seitens der zweiten Hauptfläche 13 des Halbleiterfunktionsbereichs 2 mit einer weiteren Lotschicht 14 leitend verbunden. In dem Zwischenraum zwischen der weiteren Lotschicht 14 und der Lotschicht 15 ist ein weiteres Isolationsmaterial 10b, beispielsweise SiN enthaltend, angeordnet, das die Gefahr eines Kurzschlusses der mittels der Lotschichten gebildeten elektrischen Anschlüsse des optoelektronischen Bauelements reduziert. Der Halbleiterfunktionsbereich ist über das Verbindungsleitermaterial und die Spiegelschicht und die Anschlüsse bzw. Lotschichten extern elektrisch kontaktierbar.

Das dargestellte optoelektronische Bauelement weist eine im wesentlichen hermetische Verkapselung des Halbleiterfunktionsbereichs auf. Der Halbleiterfunktionsbereich ist hierbei allseitig von Schutzmaterialien, wie dem Isolationsmaterial, das vorzugsweise auch als Passivierungsschicht oder Schutzschicht dient, in Form der Schichten 10, 10a, 10b umgeben. Nur im Bereich der elektrischen Kontakte ist diese schützende Struktur unterbrochen. Beim Löten der Anschlüsse verbinden sich die Lotschichten vorzugsweise mit dem Isolationsmaterial und erhöhen so mit Vorteil weitergehend den Schutz des Halbleiterfunktionsbereichs. Das Isolationsmaterial kann hierzu z.B. mit den Lotschichten verschmelzen.

Weiterhin ist der Halbleiterfunktionsbereich zumindest teilweise von der Umhüllung 4 umgeben bzw. in die Umhüllung eingebettet, die den Schutz des Halbleiterfunktionsbereichs weitergehend erhöht. Insbesondere gilt dies für die Seite des optoelektronischen Bauelements, die nach der Montage auf einer Leiterplatte vom Halbleiterfunktionsbereich aus gesehen der Leiterplatte gegenüberliegt und somit in erhöhtem Maße schädlichen äußeren Einflüssen ausgesetzt sein kann.

Die Umhüllung 4 ist strahlungsdurchlässig für eine vom Halbleiterfunktionsbereich zu erzeugende oder zu empfangende Strahlung und kann beispielsweise ein Silikon oder ein BCB enthalten, wobei sich ein Silikon durch eine besonders vorteilhafte Beständigkeit gegenüber kurzwelliger, insbesondere ultravioletter, Strahlung auszeichnet oder ein von den genannten Materialien verschiedenes, etwa mittels Aufdampfen oder Spincoating aufgebrachtes Umhüllungsmaterial umfassen. Das der Umhüllung nachgeordnete Fenster 17 kann beispielsweise Teil einer Glasplatte sein, die auf dem Umhüllungsmaterial mittels einer Klebeverbindung, beispielsweise ebenfalls über ein Silikon oder Siloxan, verbunden ist. Die Umhüllung 4 und das Fenster 17 können aber auch aus dem im wesentlichen gleichen Material gefertigt und insbesondere einstückig ausgebildet sein, was durch die gestrichelte Linie angedeutet ist (vgl. die entsprechenden Ausführungen zum Ausführungsbeispiel nach Figur 2).

Die zwischen der Lotschicht 14 und dem Verbindungsleitermaterial 8 angeordnete Schicht 22a enthält beispielsweise das gleiche Material wie die Spiegelschicht, was bei der Fertigung des Bauelements im Waferverbund Vorteile haben kann. Für das Aufbringen der Lotschichten und der Spiegelschicht kann so insbesondere die gleiche Maskenstruktur verwendet werden. Mit besonderem Vorteil können die Spiegelschicht und die Lotschichten das gleiche Material, beispielsweise AuGe, enthalten.

Abweichend von der Darstellung in Figur 3 kann das optoelektronische Bauelement auch ein zusätzliches Verkapselungselement umfassen, das seitens der zweiten Hauptfläche, etwa entsprechend dem in Figur 2 dargestellten Verkapselungselement 18, vorgesehen ist. Mit Vorteil kann ein derartiges Verkapselungselement den Schutz des Halbleiterfunktionsbereichs gegenüber schädlichen äußeren Einflüssen weitergehend erhöhen.

Die in Figur 3 dargestellte Abstufung zwischen der Stromaufweitungsschicht 5 und dem Halbleiterfunktionsbereich 2 kann ebenso wie die randseitige Abschrägung des Halbleiterfunktionsbereichs die Aufbringung des Isolationsmaterials 10 erleichtern. Die Gefahr von Brüchen im Isolationsmaterial, die an steilen Kanten entstehen können, und somit die Gefahr eines Kurzschlusses kann durch entsprechend ausgebildete Abstufungen oder Abschrägungen, etwa der mit dem Isolationsmaterial 10 oder weiteren Materialien, etwa dem Verbindungsleitermaterial 8 zu beschichtenden Strukturen, vorteilhaft verringert werden.

Das Fenster 17 und/oder die Umhüllung 4 haben vorzugsweise eine derart stabilisierende Wirkung bezüglich des Halbleiterfunktionsbereichs, dass bei der Herstellung des Bauelements eine im Waferverbund seitens der zweiten Hauptfläche angeordnete Trägerschicht - beispielsweise das Aufwachssubstrat der Halbleiterschichtenfolge - vollständig entfernt und nachfolgend die Spiegelschicht 22 auf die zweite Hauptfläche 13 aufgebracht werden kann.

In Figur 4 ist ein Ausführungsbeispiel eines erfindungsgemäßen Verfahrens zur Herstellung optoelektronischer Bauelemente anhand verschiedener Ansichten und Zwischenschritte schematisch dargestellt. Gezeigt ist die Herstellung eines Bauelements ähnlich dem in Figur 2 gezeigten Bauelement.

Zunächst wird eine Halbleiterschichtenfolge 200, die eine laterale Haupterstreckungsrichtung und eine zur Strahlungserzeugung und/oder zum Strahlungsempfang vorgesehene aktive Zone 400 umfasst, auf einer Trägerschicht 300, wie in Figur 4a dargestellt, bereitgestellt. Die Trägerschicht 300 ist beispielsweise durch das Aufwachssubstrat gegeben, auf dem die Halbleiterschichtenfolge 200 epitaktisch gewachsen wurde. Beispielsweise basiert die Halbleiterschichtenfolge auf mindestens einem III-V-Halbleitermaterialsystem. Das Aufwachssubstrat kann beispielsweise GaAs im Fall von GaP- oder GaAs-basierenden Halbleiterschichtenfolgen, SiC oder Saphir im Fall von GaN basierenden Halbleiterschichtenfolgen enthalten.

Nachfolgend wird der so bereitgestellte Waferverbund bzw. die Halbleiterschichtenfolge des Waferverbunds derart strukturiert, dass eine Mehrzahl von Halbleiterfunktionsbereichen 2 entsteht, die auf der gemeinsamen Trägerschicht 300 durch Zwischenräume 20 voneinander beabstandet angeordnet sind (Figur 4b). Die Zwischenräume 20 bilden beispielsweise in Aufsicht auf die Trägerschicht ein im wesentlichen kreuzgitterförmiges Muster aus.

Die Strukturierung der Halbleiterschichtenfolge 200 in Halbleiterfunktionsbereiche 2 erfolgt beispielsweise mittels photolithographischer Strukturierungsmethoden in Kombination mit Ätzverfahren, Laserstrukturierung oder anderen bekannten Strukturierungsmethoden, wie Sägen.

Beispielsweise wird zunächst eine Photolackschicht auf die der Trägerschicht abgewandte Seite der Halbleiterschichtenfolge aufgebracht, die nachfolgend mittels einer der vorgesehenen Anordnung der Halbleiterfunktionsbereiche entsprechenden Maskenstruktur belichtet und entwickelt wird. In den Bereichen, in denen die Photolackschicht von der Halbleiterschichtenfolge mittels Entwickeln entfernt wurde, kann die Halbleiterschichtenfolge über nass- oder trockenchemisches Ätzen von der der Trägerschicht gegenüberliegenden Seite her strukturiert werden. Nach der Strukturierung der Halbleiterschichtenfolge in eine Mehrzahl von Halbleiterfunktionsbereichen kann das Photolackmaterial entfernt werden.

In Figur 4b sind die Halbleiterfunktionsbereiche 2, die durch Zwischenräume 20 voneinander beabstandet und auf der Trägerschicht 300 angeordnet sind, in einer Schnittansicht schematisch dargestellt. Die Zwischenräume 20 können sich auch abweichend von der Darstellung in Figur 4b bis in die Trägerschicht 300 hinein erstrecken.

Nachfolgend wird auf die Halbleiterfunktionsbereiche eine Stromaufweitungsschicht 5, beispielsweise ZnO, SnO₂ oder SnO enthaltend, aufgebracht (Figur 4c). ZnO kann zur Erhöhung der Leitfähigkeit mit Al, SnO₂ oder SnO mit Sb dotiert sein. Die Stromaufweitungsschicht 5 kann mittels einer Maskenstruktur, etwa einer entsprechenden nach der Aufbringung der Stromaufweitungsschicht wieder zu entfernenden Photolackmaske, strukturiert auf die Halbleiterfunktionsbereiche aufgebracht.

Alternativ kann die Stromaufweitungsschicht 5 auf die der Trägerschicht 300 abgewandten Seite der Halbleiterschichtenfolge 200 vor der Strukturierung der Halbleiterschichtenfolge in Halbleiterfunktionsbereiche, vorzugsweise vollflächig, aufgebracht werden. Mit Vorteil kann eine in diesem Falle erforderliche Strukturierung der Halbleiterschichtenfolge und der Stromaufweitungsschicht in einem Verfahrensschritt, insbesondere unter Verwendung einer gemeinsamen Maske, erfolgen.

Die Stromaufweitungsschicht wird bevorzugt mittels Aufdampfen, insbesondere Sputtern, auf die Halbleiterfunktionsbereiche bzw. die Halbleiterschichtenfolge aufgebracht.

Die Halbleiterfunktionsbereiche 2 sind mit Vorzug annähernd vollflächig mit der Stromaufweitungsschicht bedeckt. Am Rand der Halbleiterfunktionsbereiche können abweichend von der Darstellung in Figur 4 Abstufungen zwischen den Halbleiterfunktionsbereichen und der Stromaufweitungsschicht ausgebildet sein, wodurch die Gefahr einer Schädigung, etwa aufgrund einer Rissbildung, für im weiteren Verlauf der Herstellung im Randbereich des Halbleiterfunktionsbereichs anzuordnende Elemente verringert wird. Weiterhin können die Halbleiterfunktionsbereiche oder die Stromaufweitungsschicht zu diesem Zwecke eine, insbesondere randseitige, Abschrägung aufweisen.

Nach dem Aufbringen der Stromaufweitungsschicht wird die Struktur mit Halbleiterfunktionsbereichen und Stromaufweitungsschicht derart strukturiert, dass ein als Aussparung 9 ausgebildeter Durchbruch durch die aktive Zone entsteht. Die Aussparung 9 reicht durch die Stromaufweitungsschicht 5 und den Halbleiterfunktionsbereich 2 bis zu der Trägerschicht.

Gegebenenfalls kann die Stromaufweitungsschicht schon vorstrukturiert auf den Halbleiterfunktionsbereich bzw. die Halbleiterschichtenfolge aufgebracht werden oder nach dem Aufbringen entsprechend vorstrukturiert werden. Insbesondere kann eine Aussparung in der Stromaufweitungsschicht eine größere laterale Abmessung als eine nachfolgend durch den Bereich der ausgesparten Stromaufweitungsschicht erzeugte Aussparung im Halbleiterfunktionsbereich aufweisen.

Die Aussparung 9 im Halbleiterfunktionsbereich 2 und/oder in der Stromaufweitungsschicht 5 kann beispielsweise mittels eines Maskierungs- und einem nachfolgenden Ätzprozess oder einer anderen geeigneten Strukturierungsmethode ausgebildet werden.

Vor oder nach der Strukturierung der Aussparung 9 wird auf die dem Halbleiterfunktionsbereich 2 abgewandte Seite der Stromaufweitungsschicht 5 eine erste Kontaktschicht 7, beispielsweise ein Metall wie Ti, Pt oder Au enthaltend, aufgebracht. Das Aufbringen kann z.B. durch Sputtern oder Aufdampfen, insbesondere unter Verwendung einer entsprechend ausgebildeten Maske, erfolgen. Die erste Kontaktschicht ist bevorzugt entsprechend der Aussparung 9 strukturiert aufgebracht oder wird nach ihrer Aufbringung dementsprechend strukturiert. Bevorzugt wird im letzteren Falle die Strukturierung der Kontaktschicht in einem Schritt mit dem Ausbilden der Aussparung 9, insbesondere unter Verwendung einer gemeinsamen Maske, ausgeführt.

Um die Kontaktfläche zwischen der Stromaufweitungsschicht 5 und der ersten Kontaktschicht 7 zu vergrößern, ist im Bereich der Aussparung mit Vorzug eine Abstufung zwischen der Stromaufweitungsschicht und dem Halbleiterfunktionsbereich ausgebildet. Die erste Kontaktschicht kann sich dann anders als in Figur 4c dargestellt an der Stufe der Stromaufweitungsschicht entlang von der dem Halbleiterfunktionsbereich abgewandten Seite der Stromaufweitungsschicht in vertikaler Richtung zum Halbleiterfunktionsbereich erstrecken. Insbesondere kann die Wand der Aussparung in der Stromaufweitungsschicht mit dem Material der ersten Kontaktschicht ausgekleidet sein. Auf diese Weise kann die Kontaktfläche zwischen der Stromaufweitungsschicht und der Kontaktschicht weitergehend vergrößert werden, ohne den von der Kontaktschicht abgeschatteten Bereich der aktiven Zone maßgeblich zu erhöhen. Absorptionsverluste durch Absorption von Strahlung in der ersten Kontaktschicht können so gegenüber einer Kontaktschicht gleicher Fläche, die vollständig auf der dem Halbleiterfunktionsbereich abgewandten Seite der Stromaufweitungsschicht angeordnet ist, verringert werden.

Die resultierende Struktur mit der Trägerschicht 300, den auf der Trägerschicht angeordneten Halbleiterfunktionsbereichen 2, den auf den Halbleiterfunktionsbereichen angeordneten Stromaufweitungsschichten 5 und den ersten Kontaktschichten 7, die die Aussparung beispielsweise ringartig umlaufen, ist in Figur 4c anhand einer Schnittansicht schematisch dargestellt.

Nachfolgend wird die Aussparung 9 im Halbleiterfunktionsbereich, die den Durchbruch durch die aktive Zone 400 bildet, in vertikaler Richtung weiter in die Trägerschicht vertieft, was beispielsweise wieder über Maskierungs- und Ätzprozesse erreicht werden kann. Die hieraus resultierende Struktur ist in Figur 4d schematisch dargestellt. Bevorzugt wird die Aussparung jedoch gleichzeitig mit der Ausbildung der Aussparung im Halbleiterfunktionsbereich und der Stromaufweitungsschicht in die Trägerschicht hineinstrukturiert, so dass sich die in Figur 4c gezeigte Aussparung 9 bereits bis in die Trägerschicht hinein erstrecken kann.

In Figur 4e ist eine Aufsicht auf die Struktur aus Figur 4d, gezeigt. Die mit der Stromaufweitungsschicht 5 bedeckten Halbleiterfunktionsbereiche 3 sind hierbei im wesentlichen quadratisch ausgebildet und durch ein zusammenhängendes Netz von Zwischenräumen 20 voneinander getrennt. Die Aussparungen 9 in dem Halbleiterfunktionsbereich sind in diesem Ausführungsbeispiel im wesentlichen kreisförmig und im Bereich der Ecken der jeweiligen Halbleiterfunktionsbereiche angeordnet.

Um die Aussparungen 9 herum ist die erste Kontaktschicht 7 angeordnet, die die Aussparung mit Vorzug umläuft. Die Anordnung der Aussparungen in den Eckbereichen der Halbleiterfunktionsbereiche erhöht mit Vorteil die Effizienz eines späteren optoelektronischen Bauelements, da die zentrale Fläche der aktiven Zone in der Mitte des Halbleiterfunktionsbereichs, welche in der Regel eine besonders hohe Quanteneffizienz hinsichtlich Strahlungserzeugung oder Strahlungsempfang aufweist, mit Vorteil im wesentlichen frei von der Kontaktschicht 7 ist und somit nicht von dieser überdeckt wird. Absorption durch eine metallische Kontaktschicht in diesem zentralen Bereich hoher Effizienz wird somit weitgehend vermieden.

Die laterale Abmessung, etwa der Durchmesser oder eine Kantenlänge, der Aussparung 9 kann von beispielsweise 100 nm bis ungefähr 100 µm reichen. Auch können in einem Halbleiterfunktionsbereich mehrere Aussparungen vorgesehen sein. Die laterale Abmessung kann je nach Ausbildung und Größe des späteren optoelektronischen Bauelements bzw. des Halbleiterfunktionsbereichs im Rahmen des Herstellungsverfahrens an die jeweiligen Erfordernisse angepasst werden.

Auf die in Figur 4d dargestellte Struktur wird nachfolgend ein Isolationsmaterial 10, beispielsweise ein Siliziumnitrid, wie SiN, enthaltend, aufgebracht. Das Isolationsmaterial kann beispielsweise vollflächig auf die in Figur 4d gezeigte Struktur aufgebracht werden. Zum Aufbringen des Isolationsmaterials eignet sich beispielsweise ein Aufdampfverfahren, etwa Sputtern oder PECVD.

Das Isolationsmaterial kleidet die Wand der Aussparung zumindest in dem Bereich, in dem die Wand der Aussparung durch den Halbleiterfunktionsbereich gebildet ist, aus. Die Aufbringung des Isolationsmaterials auf die Wand der Aussparung kann durch eine entsprechend angeschrägte Wand oder angeschrägte Wände der Aussparung erleichtert werden.

Nachfolgend wird das Isolationsmaterial, beispielsweise mittels eines photolithographischen Verfahrens in Verbindung mit einem Ätzverfahren, derart strukturiert, dass die erste Kontaktschicht 7 zumindest in einem Teilbereich frei von Isolationsmaterial 10 ist. Gegebenenfalls kann die Strukturierung auch durch Rücksputtern erfolgen. Das Isolationsmaterial kann weiterhin auch mittels einer geeigneten Maske schon entsprechend strukturiert auf die in den Figuren 4d oder 4e gezeigte Struktur aufgebracht werden.

Die daraus resultierende Struktur ist in Figur 4f anhand einer Schnittansicht schematisch dargestellt. Dadurch, dass das Isolationsmaterial die erste Kontaktschicht auf ihrer der Trägerschicht abgewandten Seite noch teilweise bedeckt, wird die Gefahr reduziert, dass bei der Strukturierung des Isolationsmaterials oder dessen strukturierter Aufbringung die aktive Zone im Halbleiterfunktionsbereich 2 frei von dem Isolationsmaterial ist. Insgesamt wird somit die Gefahr eines Kurzschlusses der aktiven Zone über ein nachfolgend in die Aussparung 9 einzubringendes Verbindungsleitermaterial 8 reduziert.

Das Verbindungsleitermaterial 8 enthält beispielsweise ein Metall, insbesondere Sn, und wird vorzugsweise so in die Aussparung 9 eingebracht, dass diese im wesentlichen vollständig mit dem Verbindungsleitermaterial ausgefüllt ist. Zinn-haltige Materialien, insbesondere Sn, sind als Verbindungsleitermaterial besonders geeignet, da sie sich, insbesondere bei vergleichsweise geringen lateralen Abmessungen der Aussparung, etwa aufgrund kapillarer Kräfte, selbst in die Aussparung "hineinziehen" und/oder diese vollständig ausfüllen können.

Das Verbindungsleitermaterial kann durch galvanisches Auffüllen, Auffüllen aus der Dampfphase oder Einlegieren eines Lots in die Aussparung eingebracht werden. Ferner kann durch geeignete Formgebung des Randes, etwa eine mittels naß- oder trockenchemischem Ätzen erzeugte Abformung, insbesondere Abrundung, der Kante der Aussparung ein Hineinziehen eines flüssigen Verbindungsleitermaterials, insbesondere Sn, in die Aussparung erleichtert werden.

Bevorzugt ist das Verbindungsleitermaterial in vertikaler Richtung derart angeordnet, dass es sich von der Seite des Halbleiterfunktionsbereichs mit der ersten Kontaktschicht durch den Bereich der aktiven Zone des Halbleiterfunktionsbereichs hindurch erstreckt. Besonders bevorzugt ist das Verbindungsleitermaterial jedoch in der Aussparung bis in die Trägerschicht hinein angeordnet. Beispielsweise füllt das Verbindungsleitematerial die Aussparung aus. In dem Bereich der ersten Kontaktschicht, der frei vom Isolationsmaterial 10 ist, ist das Verbindungsleitermaterial elektrisch leitend mit der ersten Kontaktschicht verbunden.

Die hieraus resultierende Struktur ist in Figur 4g anhand einer Schnittansicht schematisch dargestellt. Der Halbleiterfunktionsbereich 2 ist mit dem Verbindungsleitermaterial 8 über die erste Kontaktschicht 7 seitens der ersten Hauptfläche 6 elektrisch leitend verbunden. Das Isolationsmaterial 10 umformt den Halbleiterfunktionsbereich 2 bzw. die Stromaufweitungsschicht 5 in Teilbereichen schichtartig und bildet weiterhin eine vorteilhafte Schutz- bzw. Passivierungsschicht für den Halbleiterfunktionsbereich insbesondere in vertikaler Richtung im Randbereich des Halbleiterfunktionsbereichs. Weiterhin ist das Isolationsmaterial bezüglich der aktiven Zone und des Verbindungsleitermaterials elektrisch isolierend ausgebildet und vermeidet vorteilhaft einen Kurzschluß der aktiven Zone über das Verbindungsleitermaterial im späteren Betrieb des Bauelements.

In einem nachfolgenden Verfahrensschritt wird von der der Trägerschicht gegenüberliegenden Seite der Halbleiterfunktionsbereiche eine Umhüllung 4, vorzugsweise vollflächig, aufgebracht, die die Halbleiterfunktionsbereiche zumindest teilweise umhüllt und insbesondere in den Zwischenräumen 20 zwischen zwei Halbleiterfunktionsbereichen angeordnet sein kann (Figur 4h). Die Umhüllung kann beispielsweise mittels Spincoating, Aufdampfen, Aufsputtern aufgebracht werden. Durch Spincoating kann beispielsweise eine BCB enthaltende Umhüllung 4 vorgesehen werden.

Die Umhüllung wird bevorzugt in einer flüssigen und/oder plastisch formbaren Phase aufgebracht und nachfolgend in eine feste, mechanisch stabile, Phase überführt, was beispielsweise durch Temperaturerhöhung und An- oder Aushärten des Umhüllungsmaterials erreicht werden kann. Bevorzugt kann dies bei Temperaturen durchgeführt werden, die für den Halbleiterfunktionsbereich unschädlich sind. Bevorzugt liegt diese Temperatur bei unter 300°C, besonders bevorzugt unter 200°C.

Der Umhüllung ist vom Halbleiterfunktionsbereich aus gesehen eine Fensterschicht 170 nachgeordnet. Die Fensterschicht ist bevorzugt wie die Umhüllung 4 strahlungsdurchlässig bezüglich der vom Halbleiterfunktionsbereich zu erzeugenden oder zu empfangenden Strahlung ausgebildet und zeichnet sich weiterhin mit Vorzug durch hohe mechanische Stabilität aus. Die Fensterschicht 170 kann so, eventuell im Zusammenwirken mit der Umhüllung 4, eine Stabilisationsschicht für die Halbleiterfunktionsbereiche auf der Trägerschicht 300 bilden. Mit Vorteil sind die Umhüllung 4 und die Fensterschicht 170 aus dem gleichen Material und/oder einstückig ausgebildet, so dass ein zusätzliches Aufbringen einer stabilisierenden Schicht vermieden wird. Vielmehr ist in diesem Falle die Umhüllung als Stabilisationsschicht und als Fensterschicht ausgebildet.

Ein strahlungsdurchlässiger Lack, etwa ein aluminiumoxidhaltiger Lack, der mittels Aufschleudern aufgebracht und nachfolgend ausgehärtet wird, ist hierfür aufgrund der hohen Strahlungsdurchlässigkeit und der hohen mechanischen Stabilität besonders geeignet. Die gegebenenfalls einstückige Ausführung von stabilisierender Fensterschicht und Umhüllung ist in Figur 4h durch die gestrichelte Linie angedeutet.

Es ist jedoch auch möglich, eine separate Fensterschicht 170 vorzusehen, beispielsweise eine Glasplatte, die mit der Umhüllung 4, vorzugsweise mechanisch stabil, verbunden ist. Dies kann beispielsweise über eine Klebeverbindung erreicht werden, die besonders bevorzugt mittels einer zur Fensterschicht haftvermittelnden Umhüllung 4 ausgebildet wird, so dass auf eine zusätzliche haftvermittelnde Schicht verzichtet werden kann. Diese haftvermittelnde Umhüllung kann beispielsweise ein Silikon oder ein BCB enthalten.

Eine derartige Stabilisationsschicht, gebildet aus der Umhüllung und/oder der Fensterschicht, kann mit Vorteil den gesamten Waferverbund mit den Halbleiterfunktionsbereichen und der Trägerschicht derart stabilisieren, dass auf die die Halbleiterfunktionsbereiche mechanisch stabilisierende Trägerschicht 300 verzichtet, und diese zumindest teilweise entfernt oder abgedünnt werden kann.

Besonders bevorzugt hat die Stabilisationsschicht eine derart stabilisierende Wirkung, dass die gesamte Trägerschicht entfernt werden kann. Somit wird die Herstellung sehr dünner optoelektronischer Bauelemente erleichtert.

Figur 4h zeigt die resultierende Struktur anhand einer schematischen Schnittansicht mit einer stark abgedünnten Trägerschicht 300. Die stabilisierende Wirkung der Umhüllung und der Fensterschicht wird durch die im Vergleich zu Figur 4g um 180° gedrehte Ausrichtung der Struktur verdeutlicht. Die Trägerschicht wird bevorzugt zumindest soweit abgedünnt, dass das Verbindungsleitermaterial in der Aussparung 9 von der zweiten Hauptfläche 13 des Halbleiterfunktionsbereichs 2 her elektrisch anschließbar ist. Das Abdünnen oder vollständige Entfernen der Trägerschicht kann beispielsweise durch Abschleifen oder sonstige, beispielsweise mechanische oder chemische, Strukturierungsmethoden, wie Ätzen, erreicht werden.

Nachfolgend kann die in Figur 4h gezeigte Struktur von der zweiten Hauptfläche 13 der Halbleiterfunktionsbereiche her derart strukturiert werden, dass die Trägerschicht 300 und/oder das Isolationsmaterial 10 im Bereich der Zwischenräume 20 entfernt wird (Figur 4i). Dies kann beispielsweise mittels Maskieren und Ätzen erreicht werden. Vorzugsweise wird zumindest bis an oder in das Material der Umhüllung 4 strukturiert, indem etwa die Trägerschicht bereichsweise vollständig entfernt wird. Der Bereich, in dem die Trägerschicht entfernt ist, kann den Halbleiterfunktionsbereich, vorzugsweise vollständig, umlaufen.

Von der Seite der zweiten Hauptfläche 13 des Halbleiterfunktionsbereichs her wird vor oder nach dieser Strukturierung eine Isolationsschicht 10a vorgesehen, der vom Halbleiterfunktionsbereich aus gesehen ein erster Anschluß 11 nachgeordnet wird, welcher mittels der Isolationsschicht 10a vom ebenfalls seitens der zweiten Hauptfläche auf die Trägerschicht bzw. den Halbleiterfunktionsbereich bei vollständig entfernter Trägerschicht aufgebrachten zweiten Anschluß 12 elektrisch isoliert ist. Der Halbleiterfunktionsbereich 2 ist mit dem ersten Anschluß 11 über den Verbindungsleiter 8 und die Stromaufweitungsschicht 5 seitens der ersten Hauptfläche 6 leitend verbunden, während die zweite Hauptfläche 13 des Halbleiterfunktionsbereichs mit dem zweiten Anschluss 12, eventuell über den Träger 3, der aus der strukturierten Trägerschicht hervorgeht, leitend verbunden ist.

Von der zweiten Hauptfläche 13 des Halbleiterfunktionsbereichs her wird hierauf ein Verkapselungsmaterial 180 vorgesehen. Das Verkapselungsmaterial wird dabei vorzugsweise so angeordnet, dass es mit dem Umhüllungsmaterial 4 in direkten Kontakt tritt. Beispielsweise kann das Verkapselungsmaterial aufgeschleudert und gegebenenfalls nachfolgend ausgehärtet werden.

Im Bereich der Anschlüsse 11 und 12 zur Kontaktierung des optoelektronischen Bauelements wird das bevorzugt zunächst vollflächig aufgebrachte Verkapselungsmaterial mit einer Struktur versehen, die die Aufbringung von Lotschichten 14 und 15 auf die Anschlüsse erlaubt. Beispielsweise wird das Verkapselungsmaterial hierzu bereichsweise über den Anschlüssen 11 bzw. 12 entfernt oder ausgespart. Mit Vorteil ist das Verkapselungselement hierzu photostrukturierbar ausgeführt, so dass auf eine zusätzliche Photolackschicht verzichtet werden kann. Die Lotschichten 14, 15, beispielsweise AuGe enthaltend, sind vorzugsweise mit den Anschlüssen 11 und 12 elektrisch leitend verbunden und/oder können mittels Aufdampfen oder einem galvanischen Vorgang erzeugt werden.

Die daraus hervorgehende Struktur ist anhand einer schematischen Schnittansicht in Figur 4i dargestellt. Wird entlang der in Figur 4i gestrichelt eingezeichneten Linien 21, z.B. auf Folie, vereinzelt, so entsteht ein Bauelement, das komplett auf Waferlevel hergestellt ist, seitens einer Hauptfläche anschließbar ist und eine hermetisch dichte Verkapselung bezüglich der aktiven Zone aufweist. Insbesondere ist das Bauelement oberflächenmontierbar ausgeführt.

Hierbei wird durch die Stabilisationsschicht, insbesondere die Umhüllung, gegebenenfalls durch die Fensterschicht und das Verkapselungselement, vereinzelt. Dabei können in den genannten Elementen aufgrund des Vereinzelns Trennspuren, z.B. Sägespuren, ausgebildet werden.

Auch ein optisches Element, wie beispielsweise eine Linse entsprechend dem in Figur 2 gezeigten Bauelement oder eine die Lichtein- oder -auskopplung erhöhende Mikrostruktur, kann noch im Waferverbund in der Fensterschicht 170 zum Beispiel durch ein mikrolithographisches Verfahren, etwa mittels Ätzen, oder Stempeln ausgebildet werden.

Es sei angemerkt, dass eine Stabilisationsschicht, die den Waferverbund stabilisiert auch mehrfach Anwendung finden kann. Eine erste Stabilisationsschicht, die bevorzugt photostrukturierbar ausgebildet ist, kann nach dem Aufbringen und gegebenenfalls Aushärten einer zweiten Stabilisationsschicht entfernt werden. Zweckmäßigerweise wird die erste Stabilisationsschicht nach dem Aushärten der zweiten Stabilisationsschicht entfernt und ist auf der der ersten Stabilisationsschicht gegenüberliegenden Seite des Halbleiterfunktionsbereichs angeordnet.

Das hier anhand des Ausführungsbeispiels skizzierte Verfahren ist selbstverständlich nicht auf dieses Ausführungsbeispiel beschränkt.

Weiterhin kann alternativ oder zusätzlich auf die der Trägerschicht 300 abgewandte Seite der Halbleiterschichtenfolge gemäß Figur 4a eine, insbesondere metallhaltige, Spiegelschicht aufgebracht werden und nachfolgend die Halbleiterschichtenfolge seitens der Spiegelschicht auf einer Zusatzträgerschicht angeordnet und/oder befestigt, etwa über Kleben oder ein Waferbonding-Verfahren, werden. Die Trägerschicht kann hierauf entfernt werden, so dass zwischen der Zusatzträgerschicht und der Halbleiterschichtenfolge eine Spiegelschicht angeordnet ist. Die Zusatzträgerschicht und/oder die Spiegelschicht können entsprechend der Trägerschicht aus Figur 4 im weiteren Verfahren prozessiert werden. Das Aufwachssubstrat der Halbleiterschichtenfolge, das von der Trägerschicht umfasst sein kann, wird hierbei mit Vorzug abgelöst (vgl. das in Figur 7 gezeigte Ausführungsbeispiel, bei dem der Träger 3 gemäß den obigen Ausführungen dann beim Vereinzeln aus der Zusatzträgerschicht hervorginge).

Ferner kann gemäß diesem Verfahren auch eine Vorrichtung mit einer Mehrzahl optoelektronischer Bauelemente hergestellt werden.

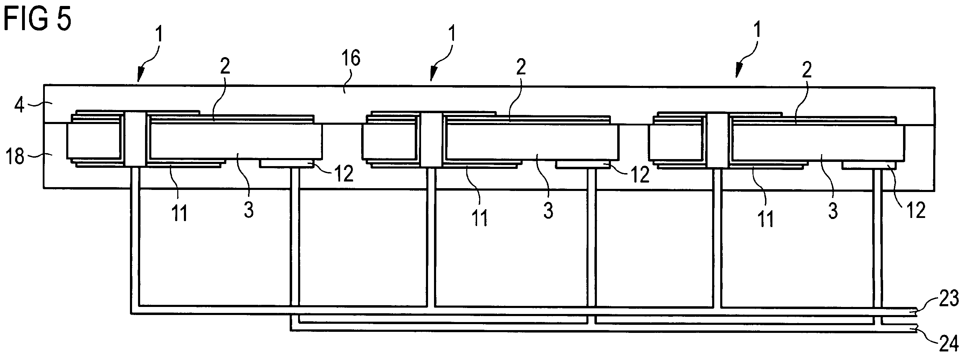

In Figur 5 ist ein Ausführungsbeispiel einer erfindungsgemäßen Vorrichtung anhand einer schematischen Schnittansicht dargestellt.

Die Anschlüsse 11 und 12 der in lateraler Richtung nebeneinander angeordneten, beispielsweise drei, optoelektronischen Bauelemente 1 sind jeweils mit externen Anschlüsse 23 und 24 leitend verbunden. Die Anordnung der optoelektronischen Bauelemente entspricht derjenigen der Halbleiterfunktionsbereiche 2 im Waferverbund. Die gezeigte Vorrichtung wird durch die von der einstückigen, durchgehenden Umhüllung 4 und/oder dem Verkapselungselement 18 gebildete Verkapselung 16 mechanisch stabilisiert und vor schädlichen äußeren Einflüssen geschützt. Eine derartige Vorrichtung kann aus der in Figur 4i gezeigten Struktur hervorgehen, wenn diese Struktur derart vereinzelt wird, dass das hervorgehende optoelektronische Bauteil bzw. dann die Vorrichtung eine Mehrzahl von Halbleiterfunktionsbereichen, die insbesondere flächig, als Array, angeordnet sein können, umfasst. Auf eine Darstellung der aktiven Zone der Halbleiterfunktionsbereiche wurde in Figur 5 aus Übersichtlichkeitsgründen verzichtet.

Auf die Träger 3 der Halbleiterfunktionsbereiche kann entsprechend den obigen Ausführungen bei geeigneter Ausbildung der Umhüllung 4 als Stabilisationsschicht oder einer zusätzlich vorgesehenen Stabilisationsschicht, etwa einer Fensterschicht, auch verzichtet werden.

Ist das Verkapselungselement hinreichend dünn ausgebildet, wird die Ausbildung von Hochleistungsbauelementen bzw. eines Arrays von Hochleistungsbauelementen erleichtert, da eine Wärmeableitung der im Betrieb entstehenden Verlustwärme, etwa zu einer externen Wärmesenke, auf der das Hochleistungsbauelement angeordnet und/oder befestigt sein kann, durch das Verkapselungselement hindurch verbessert wird. Das Hochleistungsbauelement kann beispielsweise als Laser oder Hochleistungs-Lumineszenzdiode ausgeführt sein.

Die externen Anschlüsse, die die einzelnen Halbleiterfunktionsbereiche leitend verbinden, können gegebenenfalls mittels Lithographie, insbesondere Mikrolithographie, in den in Figur 5 gezeigten Verbund, insbesondere in das Verkapselungselement, integriert sein, wodurch eine kleine und kompakte Ausgestaltung der Vorrichtung vereinfacht erzielt werden kann. Hierzu kann beispielsweise die den Halbleiterfunktionsbereichen abgewandte Oberfläche des Verkapselungselements entsprechend strukturiert und die externen Anschlüsse können, etwa als Metallisierungen, in der ausgebildeten Struktur angeordnet werden. Die Metallisierung kann beispielsweise mittels eines galvanischen Prozesses erfolgen.

Weiterhin kann eine Mehrzahl von Vorrichtungen oder eine Vorrichtung mit einem oder mehreren einzelnen optoelektronischen Bauelementen leitend verbunden werden. Die Vorrichtung und das Bauelement können gegebenenfalls gemeinsam betrieben werden.

Auch ein optoelektronisches Bauelement, das im wesentlichen dem in Figur 3 gezeigten entspricht, kann gemäß einem Verfahren, das gegenüber dem in Figur 4 gezeigten leicht abgeändert ist, hergestellt werden. Hierzu werden das Verbindungsleitermaterial und das Isolationsmaterial beispielsweise in dem Bereich des Durchbruchs durch die aktive Zone in den Zwischenräumen 20 der Figur 4b angeordnet. Die Randbereiche der Halbleiterfunktionsbereiche sind vorzugsweise entsprechend abgestuft oder abgeschrägt, um die Anordnung des Isolationsmaterials und/oder des Verbindungsleitermaterials zu erleichtern. Die Trägerschicht wird von der durch die Stabilisationsschicht gehaltenen Struktur vorzugsweise vollständig entfernt, so dass nachfolgend eine metallhaltige, insbesondere metallische, Spiegelschicht seitens der zweiten Hauptfläche auf den Halbleiterfunktionsbereich aufgebracht werden kann.

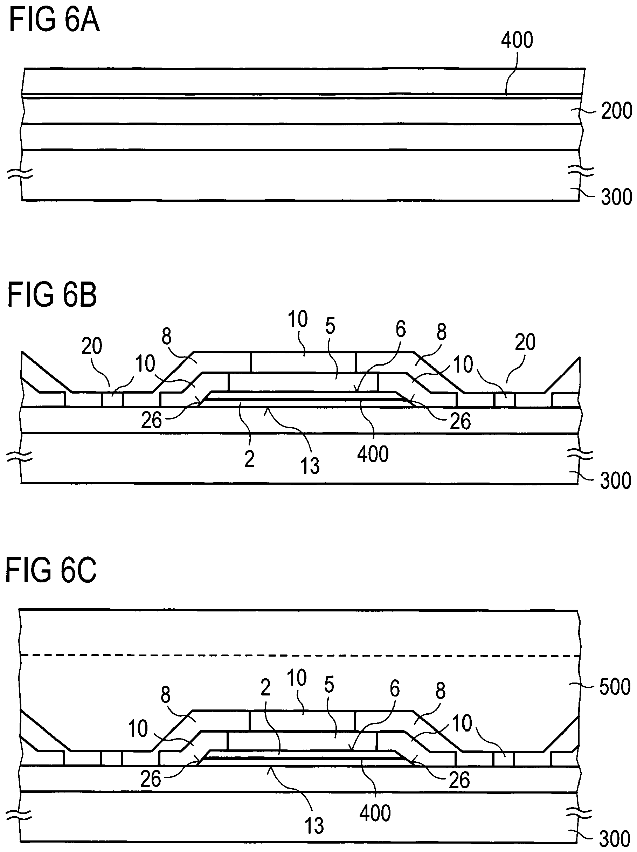

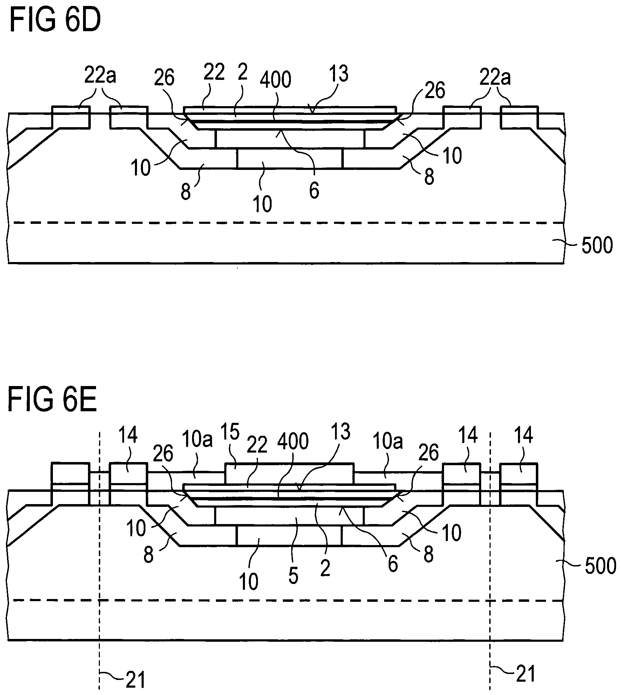

Ein dementsprechendes Ausführungsbeispiel eines Herstellungsverfahrens eines optoelektronischen Bauelements ist in Figur 6 anhand der in den Figuren 6a bis 6e schematisch dargestellten Zwischenschritte gezeigt.

Zunächst wird, wie anhand der Schnittansicht in Figur 6a gezeigt, ein Waferverbund mit einer auf einer Trägerschicht 300 angeordneten Halbleiterschichtenfolge 200, die eine zur Strahlungserzeugung oder zum Strahlungsempfang vorgesehene aktive Zone 400 umfasst, bereitgestellt. Die Trägerschicht kann beispielsweise durch das Aufwachssubstrat, auf dem die Halbleiterschichtenfolge epitaktisch gewachsen wurde, gegeben sein.

Nachfolgend wird die Halbleiterschichtenfolge 200, etwa mittels eines photolithographischen Prozesses in Verbindung mit einem Ätzprozess, in eine Mehrzahl von durch Zwischenräume 20 räumlich voneinander getrennte Halbleiterfunktionsbereiche 2 strukturiert (vgl. Figur 6b). Hierbei werden die aktive Zone der Halbleiterfunktionsbereiche in lateraler Richtung begrenzende Seitenflächen 26 ausgebildet. In Figur 6 ist aus Übersichtlichkeitsgründen lediglich ein einzelner Halbleiterfunktionsbereich 2 dargestellt.

Auf die Halbleiterfunktionsbereiche 2 oder die noch unstrukturierte Halbleiterschichtenfolge 200 wird eine Stromaufweitungsschicht 5, etwa ZnO:Al enthaltend, aufgebracht (Figur 6b). Hierzu eignet sich beispielsweise besonders Sputtern. Wird die Stromaufweitungsschicht auf die unstrukturierte Halbleiterschichtenfolge aufgebracht, so kann sie gemäß der gewünschten Struktur der Halbleiterfunktionsbereiche strukturiert oder vollflächig und unstrukturiert aufgebracht werden. Im letzteren Fall kann gegebenenfalls die Strukturierung der Halbleiterschichtenfolge in Halbleiterfunktionsbereiche und der Stromaufweitungsschicht in einem Verfahrensschritt, etwa unter Benutzung einer gemeinsamen Maske, erfolgen.

Es sei angemerkt, dass die Stromaufweitungsschicht nicht notwendigerweise ein TCO-Material enthalten muss. Es kann gegebenenfalls auch alternativ oder zusätzlich eine metallhaltige, insbesondere metallische und/oder absorbierende, Stromaufweitungsstruktur vorgesehen sein, die zur homogenen Stromeinprägung in die aktive Zone ausgebildet sein kann. Eine homogene Stromeinprägung kann durch eine entsprechende Ausbildung der Stromaufweitungsstruktur, etwa mit von einem metallischen Zentralbereich auslaufenden metallischen Fingern und/oder einer metallischen Rahmenstruktur, die den Randbereich des Halbleiterfunktionsbereich, vorzugsweise vollständig, umläuft, erreicht werden. Die Stromaufweitungsstruktur bedeckt die der Trägerschicht abgewandte Oberfläche des Halbleiterfunktionsbereichs bevorzugt nicht vollständig, so dass zumindest ein Teilbereich der Oberfläche, insbesondere der ersten Hauptfläche 6, des Halbleiterfunktionsbereichs frei von der Stromaufweitungsstruktur ist. Hierdurch kann eine homogene Stromeinprägung in den Halbleiterfunktionsbereich bei maßvoller Absorption in den von der Struktur überdeckten bzw. abgeschatteten Bereichen der aktiven Zone und einer im wesentlichen vollständigen Transmission von Strahlung in den von der Struktur freien Bereichen der Oberfläche des Halbleiterfunktionsbereichs erreicht werden.

Nachfolgend wird ein Isolationsmaterial 10, etwa ein Siliziumnitrid, ein Siliziumoxid, oder ein Siliziumoxinitrid, im Bereich der Seitenflächen 26 angeordnet.

Bevorzugt erstreckt sich das Isolationsmaterial, insbesondere direkt, an der Seitenfläche 26 des Halbleiterfunktionsbereichs 2 entlang von der der Trägerschicht 300 gegenüberliegenden ersten Hauptfläche 6 des Halbleiterfunktionsbereichs in vertikaler Richtung an der aktiven Zone vorbei in Richtung der Trägerschicht oder bis auf die Trägerschicht. Das Isolationsmaterial wird mit Vorzug, etwa durch Sputtern, zunächst vollflächig aufgebracht und daraufhin in einem mit der der Trägerschicht abgewandten Oberfläche des Halbleiterfunktionsbereichs, insbesondere der Stromaufweitungsschicht, überlappenden Bereich und/oder im Bereich des Zwischenraums 20 bereichsweise entfernt. Die Abschrägung des Halbleiterfunktionsbereichs bzw. die Abstufung zwischen der Stromaufweitungsschicht und dem Halbleiterfunktionsbereich erleichtern das Aufbringen des Isolationsmaterials und reduzieren die Gefahr einer Rissbildung in der mittels des Isolationsmaterials gebildeten Isolationsmaterialschicht.

In den Bereichen, in denen das Isolationsmaterial entfernt ist, wird ein Verbindungsleitermaterial 8, etwa Ti, Pt, Au oder eine Legierung mit mindestens einem dieser Metalle enthaltend angeordnet, das mit dem Halbleiterfunktionsbereich seitens dessen erster Hauptfläche 6 über die Stromaufweitungsschicht elektrisch leitend verbunden ist. Hierzu eignet sich beispielsweise Aufdampfen, insbesondere mittels einer entsprechend ausgebildeten Maske.

Das Verbindungsleitermaterial erstreckt sich im Randbereich des Halbleiterfunktionsbereichs am Isolationsmaterial und den Seitenflächen 26 entlang über den Bereich der aktiven Zone 400 bis zur zweiten Hauptfläche 13 des Halbleiterfunktionsbereichs 2. Ein einen Kurzschluss verursachender direkter Kontakt zwischen dem Verbindungsleitermaterial und der aktiven Zone wird durch das Isolationsmaterial verhindert.

Auf die der Trägerschicht abgewandte Seite der Struktur in Figur 6b kann gegebenenfalls noch eine Antireflexbeschichtung oder eine anderweitige optische Vergütung, die eine oder eine Mehrzahl von Schichten umfasst, aufgebracht werden. Übermäßige Brechungsindexsprünge zu einem nachfolgend aufzubringenden Material, die mit Reflexionsverlusten an von einem fertigen optoelektronischen Bauelement zu emittierender oder zu empfangender Strahlung einhergehen, können durch eine Antireflexbeschichtung verringert werden. Insbesondere kann das Isolationsmaterial als Antireflexionsschicht, etwa als λ/4-Schicht, ausgeführt sein.

Nachfolgend wird von der der Trägerschicht 300 abgewandten Seite der Halbleiterfunktionsbereiche 2 eine strahlungsdurchlässige Stabilisationsschicht 500 auf der Struktur aus Figur 6b angeordnet. Beispielsweise wird die Stabilisationsschicht mittels Spincoating aufgebracht und, etwa durch nachfolgendes, insbesondere temperaturgestütztes, Aushärten, verfestigt. Hierzu ist ein Spin on Oxid oder ein Lack als Material für die Stabilisationsschicht besonders beeignet. Die Stabilisationsschicht ist mit Vorzug einstückig ausgebildet. Gegebenenfalls kann die Stabilisationsschicht auch zwei- oder mehrstückig, etwa aus einer Fensterschicht und einer, vorzugsweise hinsichtlich der Fensterschicht haftvermittelnden, Umhüllung, etwa gemäß dem im Zusammenhang mit Figur 4 beschriebenen Ausführungsbeispiel, ausgebildet sein. Dies ist durch die gestrichelte Linie in der schematischen Schnittansicht in Figur 6c angedeutet.

Die Stabilisationsschicht umformt die Halbleiterfunktionsbereiche teilweise und stabilisiert den Waferverbund mechanisch derart, dass auf die stabilisierende Trägerschicht verzichtet werden kann. Die Trägerschicht wird nachfolgend, etwa mittels eines Ätzprozesses oder eines Laserablations- oder -trennverfahrens, vollständig entfernt, so dass der Verbund seitens der zweiten Hauptfläche 13 der Halbleiterfunktionsbereiche für die weitere Prozessierung zugänglich ist

Daraufhin wird auf die der Stabilisationsschicht abgewandten Seite des Verbunds eine, insbesondere elektrisch leitende, Spiegelschicht 22, etwa ein Metall oder eine Legierung, wie AuGe, enthaltend, auf dem Halbleiterfunktionsbereich angeordnet. Die resultierende Struktur ist anhand einer schematischen Schnittansicht in Figur 6d gezeigt.

Die Spiegelschicht 22 kann beispielsweise über Aufdampfen oder Aufsputtern, insbesondere mittels einer geeignet ausgebildeten Maske, aufgebracht werden. Bevorzugt wird die Spiegelschicht derart aufgebracht, dass auf dem seitens der zweiten Hauptfläche freiliegenden Verbindungsleiter 8 Schichten 22a aus dem Material der Spiegelschicht angeordnet sind, die besonders bevorzugt eine der Dicke der Spiegelschicht vergleichbare Dicke aufweisen oder deren Dicke gleich derjenigen der Spiegelschicht ist. Die Spiegelschicht ist mit dem Halbleiterfunktionsbereich seitens dessen zweiter Hauptfläche 13 und die Schicht 22a seitens dessen erster Hauptfläche 6 leitend verbunden. Durch vergleichbare, insbesondere gleiche, Dicken der Spiegelschicht und der Schicht 22a wird eine gleichmäßige Erhöhung der Strukturen - der Spiegelschicht und der Schicht 22a -, die für die elektrische Kontaktierung des späteren Bauelements vorgesehen sind, über den Halbleiterfunktionsbereich erreicht, was die Aufbringung nachfolgender, z.B. ebenfalls der Kontaktierung dienender, Strukturen erleichtert. AuGe zeichnet sich durch besonders vorteilhafte elektrische Kontakteigenschaften zu Halbleitermaterialien, insbesondere III-V-Materialien, etwa auf GaP basierend, einerseits und zu metallhaltigen Materialien, wie dem Verbindungsleitermaterial andererseits bei gleichzeitig hoher Reflektivität aus.

Die Spiegelschicht ist mit Vorteil reflektierend bezüglich einer im Halbleiterfunktionsbereich zu erzeugenden oder von diesem zu empfangenden Strahlung ausgebildet. Hierdurch kann die Effizienz eines z.B. strahlungsemittierenden Bauelements durch erhöhte und gerichtetere Strahlungsauskopplung aus dem Bauelement erhöht werden.

Nachfolgend wird auf der der Stabilisationsschicht gegenüberliegenden Seite des Verbunds ein weiteres Isolationsmaterial 10a, vorzugsweise zunächst vollflächig, angeordnet. Bevorzugt ist das Material mit dem Isolationsmaterial 10 identisch und/oder enthält das weitere Isolationsmaterial 10a ein Siliziumnitrid, ein Siliziumoxid oder ein Siliziumoxinitrid. Ein zunächst vollflächig aufgebrachtes Isolationsmaterial 10a kann in mit dem Verbindungsleitermaterial 8 bzw. dem Halbleiterfunktionsbereich 2 überlappenden Bereich bereichsweise, etwa mittels nass- oder trockenchemischem Ätzen entfernt werden. In den entfernten Bereichen kann nachfolgend ein Lotmaterial derart angeordnet werden, dass eine erste Lotschicht 14 und eine zweite Lotschicht 15 ausgebildet werden. Die erste Lotschicht ist mit dem Halbleiterfunktionsbereich seitens der ersten Hauptfläche - über die Schicht 22a, das Verbindungsleitermaterial 8 und die Stromaufweitungsschicht 5 - und die zweite Lotschicht ist über die Spiegelschicht 22 mit dem Halbleiterfunktionsbereich seitens der zweiten Hauptfläche 13 leitend verbunden.

Der Halbleiterfunktionsbereich ist entsprechend der schematischen Schnittansicht in Figur 6e allseitig durch schützende Strukturen, insbesondere die Isolationsmaterialien 10 und 10a sowie die mechanisch stabile Stabilisationsschicht, umgeben und demnach, etwa hermetisch, verkapselt. Die Verkapselung ist lediglich in Teilbereichen zu Kontaktierungszwecken ausgespart.

Entlang der Linien 21 kann in optoelektronische Bauelemente mit einem einzelnen Halbleiterfunktionsbereich oder in eine Vorrichtung mit einer Mehrzahl von Halbleiterfunktionsbereichen, etwa mittels Sägen und/oder auf Folie, vereinzelt werden. Das Vereinzeln erfolgt hierbei im Bereich der Zwischenräume 20 und insbesondere durch die Stabilisationsschicht sowie die Isolationsmaterialien 10 und 10a hindurch.

Das Bauelement bzw. die Vorrichtung sind demnach komplett im Waferverbund gefertigt und aufgrund der hermetischen Kapselung kann auf ein zusätzliches schützendes Gehäuse verzichtet werden. Zum weitergehenden Schutz kann gegebenenfalls noch im Verbund seitens der zweiten Hauptfläche ein zusätzliches Verkapselungselement, etwa ähnlich dem Element 180 aus Figur 4, vorgesehen werden. Da die Kontaktierung bzw. die Montage des Bauelements auf einer Trägerplatte, etwa auf einer Leiterplatte, aber seitens der zweiten Hauptfläche vorgesehen ist und diese Montageseite im Vergleich zu der ersten Hauptfläche nur in verringertem Maße schädlichen äußeren Einflüssen ausgesetzt ist, kann auf ein zusätzliches Verkapselungselement verzichtet werden, ohne die Gefahr einer Schädigung des Bauelements maßgeblich zu erhöhen.

Die Verkapselung des Halbleiterfunktionsbereichs kann durch eine, insbesondere innige, Verbindung des weiteren Isolationsmaterials 10a mit dem Lotmaterial, die bei der Montage, insbesondere Oberflächenmontage, des Dünnfilm-Bauelements, etwa mittels Löten auf einer Leiterplatte, ausgebildet wird, weitergehend abgedichtet werden.

Es sei angemerkt, dass im Verfahren nach Figur 6 auch ein optisches Element in der Stabilisationsschicht ausgebildet werden kann oder im Material der Stabilisationsschicht ein Lumineszenzkonversionsstoff angeordnet sein kann. Auch weitere, in den vorhergehenden Ausführungsbeispielen beschriebene Merkmale können sich auf das Verfahren nach Figur 6 beziehen.

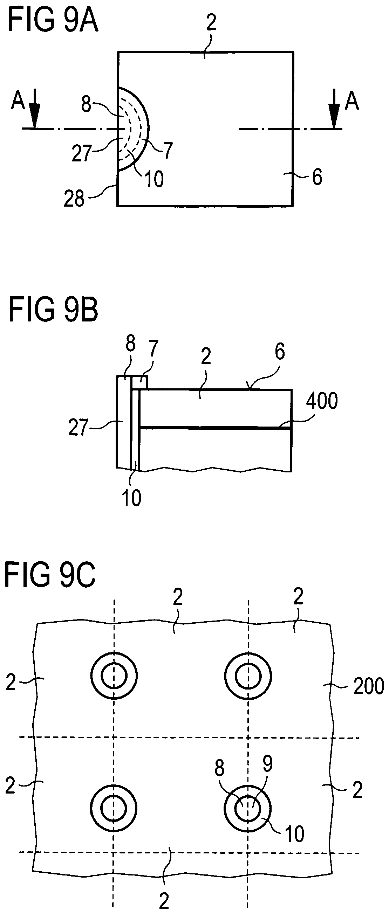

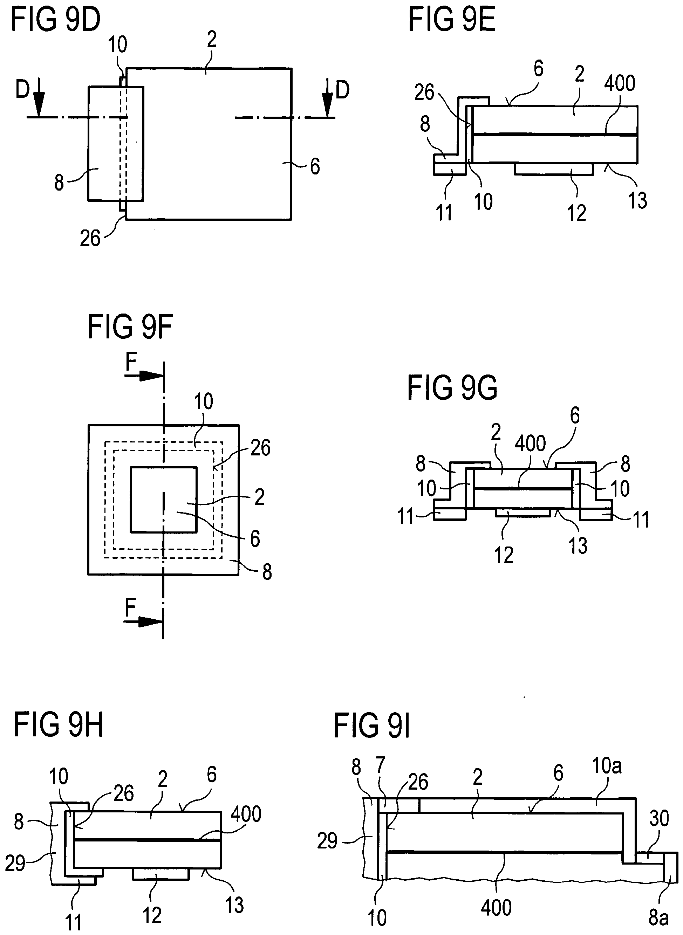

Figur 9 zeigt in den Figuren 9a bis 9i anhand schematischer Schnittansichten und schematischer Aufsichten verschiedene Varianten für die Ausführung der Kontaktstruktur zur elektrischen Kontaktierung des Halbleiterfunktionsbereichs.

Die in Figur 9 gezeigten Elemente sind allesamt komplett im Waferverbund realisierbar.

Figur 9a zeigt eine schematisch Aufsicht auf die erste Hauptfläche 6 des Halbleiterfunktionsbereichs 2 und Figur 9b zeigt eine zugehörige schematische Schnittansicht eines Schnitts entlang der Linie A-A.

In den Figuren 9a und 9b ist der Durchbruch durch die aktive Zone 400 des Halbleiterfunktionsbereichs 2 als laterale Vertiefung 27 ausgebildet. Die Vertiefung 27 ist insbesondere als Einbuchtung einer Seitenfläche 28 des Halbleiterfunktionsbereichs 2 ausgeführt. Das Isolationsmaterial 10 isoliert die aktive Zone 400 von dem in der lateralen Vertiefung angeordneten Verbindungsleitermaterial 8, das seitens der ersten Hauptfläche 6 des Halbleiterfunktionsbereichs mit dem ersten Kontakt 7 elektrisch leitend verbunden ist. In vertikaler Richtung erstreckt sich das Verbindungsleitermaterial am Halbleiterfunktionsbereich entlang in Richtung der der ersten Hauptfläche 6 bezüglich der aktiven Zone gegenüberliegenden zweiten Hauptfläche bzw. in Richtung der Trägerschicht des Waferverbunds. Die Trägerschicht und die zweite Hauptfläche sind in den Figuren 9a und 9b nicht explizit dargestellt (vgl. hierzu die oben näher beschriebenen Ausführungsbeispiele). Die hier gezeigte Variante eignet sich insbesondere für ein Bauelement gemäß den in den Figuren 1, 2, 7 und 8 gezeigten Ausführungsbeispielen, kann gegebenenfalls jedoch auch bei einem Bauelement nach Figur 3 eingesetzt werden.

Bei der Herstellung einer derartigen Kontaktstruktur können in der Halbleiterschichtenfolge 200 des Waferverbunds zunächst Durchbrüche erzeugt werden, die vorzugsweise als, insbesondere lateral allseitig durch die Halbleiterschichtenfolge begrenzte, Aussparungen 9 ausgeführt sind (vgl. die in Figur 9c gezeigte schematische Aufsicht auf einen Waferverbund). Nachfolgend werden die Durchbrüche bevorzugt mit Verbindungsleitermaterial 8 befüllt. Besonders bevorzugt wird zuvor ein Isolationsmaterial 10 im Bereich des Durchbruchs angeordnet, das eine Wand des Durchbruchs auskleiden und/oder die durchbrochene aktive Zone von dem Verbindungsleitermaterial elektrisch isolieren kann. Hierauf kann eine Strukturierung der Halbleiterschichtenfolge 200 in Halbleiterfunktionsbereiche 2 erfolgen. Hierbei wird mit Vorzug derart durch die Durchbrüche strukturiert, dass die Halbleiterfunktionsbereiche 2 eine Vertiefung in lateraler Richtung, etwa gemäß den Figuren 9a und 9b, aufweist. Dies ist in Figur 9c durch die gestrichelten Linien angedeutet, entlang derer die Halbleiterschichtenfolge mit Vorzug in Halbleiterfunktionsbereiche 2 strukturiert wird.

Gegebenenfalls kann das Anordnen des Verbindungsleitermaterials 8 und/oder des Isolationsmaterials 10 im Bereich der Durchbrüche hierbei auch nach der Strukturierung der Halbleiterschichtenfolge in Halbleiterfunktionsbereiche erfolgen.

Im Unterschied zu der oben beschriebenen Variante ist in der Variante, die in einer Aufsicht in Figur 9d und einer Schnittansicht entlang der Linie D-D in Figur 9e dargestellt ist, der Halbleiterfunktionsbereich 2 frei von einer Vertiefung in lateraler Richtung. Das Isolationsmaterial 10 ist an einer die aktive Zone 400 lateral begrenzenden, ebenen Seitenfläche 26 angeordnet. Das Verbindungsleitermaterial 8 ist mit der ersten Hauptfläche 6 elektrisch leitend verbunden und erstreckt sich in vertikaler Richtung bis zur zweiten Hauptfläche 13 des Halbleiterfunktionsbereichs 2. Seitens der zweiten Hauptfläche ist das Verbindungsleitermaterial mit dem ersten Anschluss 11 elektrisch leitend verbunden. Ein direkter elektrischer Kontakt zwischen dem Verbindungsleitermaterial 8 bzw. dem ersten Anschluss 11 und der zweiten Hauptfläche 13 wird durch das Isolationsmaterial 10 vermieden. Die zweite Hauptfläche ist mit dem zweiten Anschluss 12 elektrisch leitend verbunden. Um die Gefahr eines Kurzschlusses der aktiven Zone weitergehend zu verringern, weist das Isolationsmaterial 10 bevorzugt in einer Richtung parallel zur Seitenfläche 26 eine größere Ausdehnung auf als das Verbindungsleitermaterial 8. Eine derartige Kontaktstruktur ist beispielsweise für ein in Figur 3 gezeigten Bauelement besonders geeignet.

Im Gegensatz zum in Figur 3 gezeigten Bauelement verläuft das Verbindungsleitermaterial in den Figuren 9d und 9e in vertikaler Richtung einseitig, das heißt an einer einzelnen Seitenfläche 26 des Halbleiterfunktionsbereichs 2 entlang.

Im Unterschied hierzu ist in der Variante, die in einer schematischen Aufsicht in Figur 9f und einer schematischen Schnittansicht entlang der Linie F-F in Figur 9g dargestellt ist, das Verbindungsleitermaterial in lateraler Richtung allseitig um den Halbleiterfunktionsbereich 2 angeordnet.

In Figur 9h ist eine Schnittansicht einer weiteren Variante der Kontaktstruktur gezeigt. Das Verbindungsleitermaterial 8 ist mit der ersten Hauptfläche 6 des Halbleiterfunktionsbereichs elektrisch leitend verbunden und seitens der zweiten Hauptfläche mittels des Isolationsmaterials 10 bezüglich eines direkten elektrischen Kontakt zum Halbleiterfunktionsbereich 2 seitens dessen zweiter Hauptfläche 13 isoliert. Seitens der zweiten Hauptfläche bildet das Verbindungsleitermaterial einen ersten Anschluss 11 aus. Gegebenenfalls kann ein separater erster Anschluss und/oder ein separates weiteres Isolationsmaterial anstatt einer jeweils einstückigen Ausbildung des ersten Anschlusses 11 und/oder des Verbindungsleitermaterials 8 vorgesehen sein (vgl. hierzu beispielsweise Figur 1). Den Gegenpol der Diodenkontaktierung bildet der zweite Anschluss 12, der mit der zweiten Hauptfläche 13, insbesondere direkt, elektrisch leitend verbunden ist. Das Verbindungsleitermaterial 8 umgreift den Halbleiterfunktionsbereich 2 vorzugsweise klammerartig. Ist das Verbindungsleitermaterial im Bereich eines Durchbruchs 29 durch die aktive Zone 400 angeordnet, so ist die gezeigte Kontaktstruktur für ein Bauelement gemäß den Figuren 1, 2, 7 oder 8 besonders geeignet. Erstreckt sich das Verbindungsleitermaterial entlang einer die aktive Zone in lateraler Richtung begrenzenden Seitenfläche 26, so eignet sich die in Figur 9h gezeigte Kontaktstruktur besonders für ein Bauelement gemäß Figur 3.

In Figur 9i ist eine weitere Variante der Kontaktstruktur des Halbleiterfunktionsbereichs 2 anhand einer Schnittansicht schematisch dargestellt.

Im Gegensatz zu den weiteren in Figur 9 gezeigten Kontaktstrukturen sind der erste Kontakt 7 und ein zweiter Kontakt 30 auf einer gemeinsamen Seite des Halbleiterfunktionsbereichs 2, insbesondere auf der im Waferverbund der Trägerschicht bzw. auf der einem Träger des Bauelements abgewandten Seite, angeordnet. Um eine Kontaktierung des Halbleiterfunktionsbereichs seitens dessen nicht dargestellter zweiter Hauptfläche zu ermöglichen, erstrecken sich ein mit dem ersten Kontakt verbundenes Verbindungsleitermaterial 8 das über das Isolationsmaterial 10 von der aktiven Zone 400 isoliert ist in Richtung der zweiten Hauptfläche und ein mit dem zweiten Kontakt 30 verbundenes weiteres Verbindungsleitermaterial 8a in Richtung der zweiten Hauptfläche. Weiterhin ist auf der ersten Hauptfläche 6 ein weiteres Isolationsmaterial 10a angeordnet, das sowohl schützend und passivierend bezüglich des Halbleiterfunktionsbereichs 2, insbesondere an dessen Flanke, wirkt als auch die Gefahr eines Kurzschlusses der aktiven Zone über den zweiten Kontakt 30 verringert.

Der Halbleiterfunktionsbereich bzw. die Halbleiterschichtenfolge kann, etwa durch geeignetes. Ätzen im Waferverbund, derart strukturiert werden, dass die aktive Zone, wie in Figur 9i gezeigt, mittels der auf einer gemeinsamen Seite des Halbeiterfunktionsbereichs angeordneten Kontakte 7 und 30 elektrisch kontaktierbar ist. Die Kontakte 7 und 30 sind mit der aktiven Zone 400 insbesondere von verschiedenen Seiten der aktiven Zone her elektrisch leitend verbunden.

Das Verbindungsleitermaterial 8 kann sich entweder im Bereich des Durchbruchs 29 oder entlang der die aktiven Zone lateral begrenzenden Seitenfläche 26 erstrecken, wobei der Durchbruch vorzugsweise als Aussparung des Halbleiterfunktionsbereichs, die lateral allseitig vom Halbleiterfunktionsbereich begrenzt ist, ausgeführt ist.

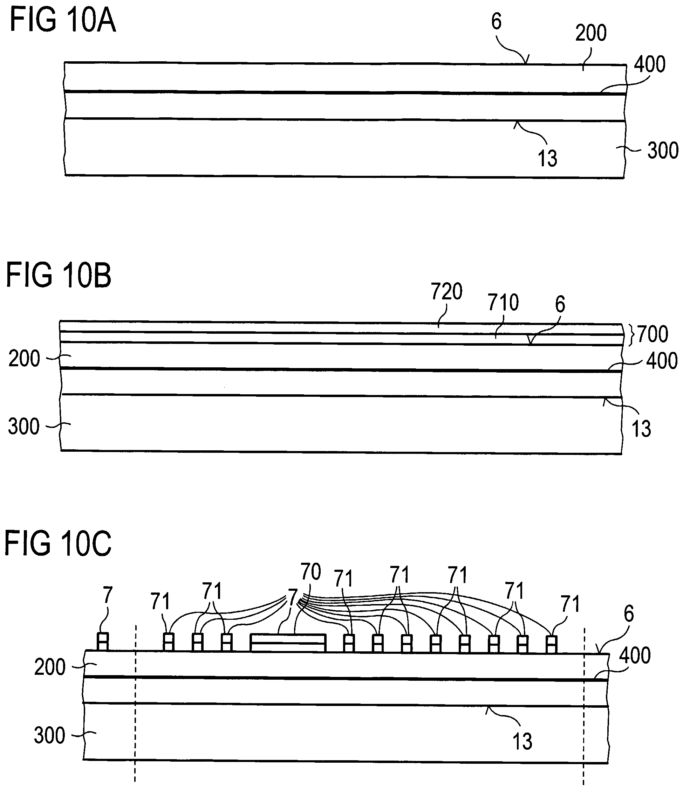

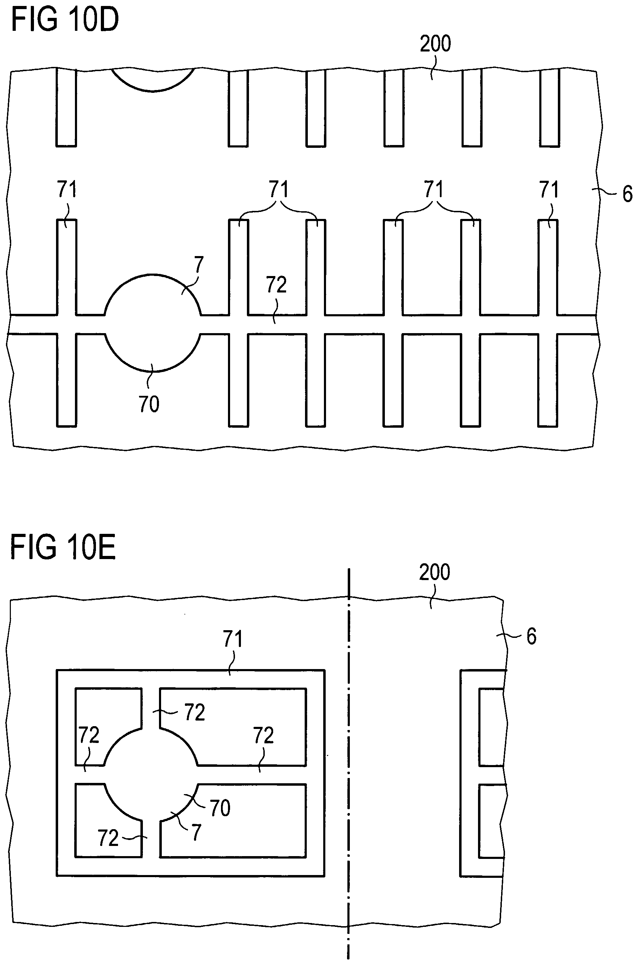

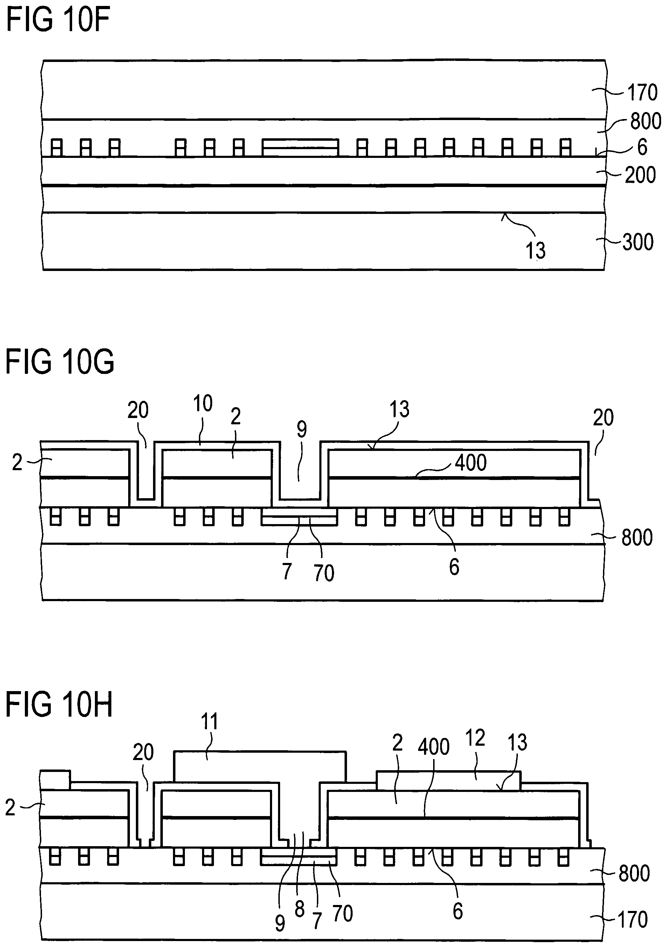

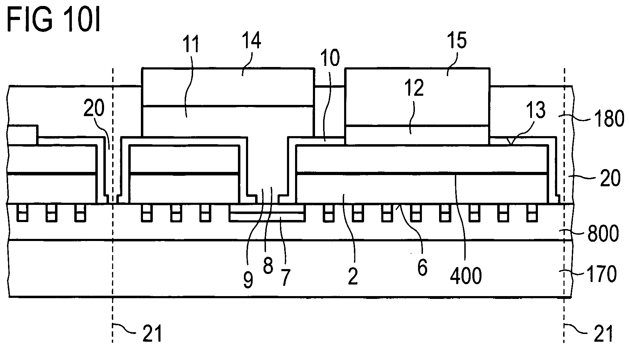

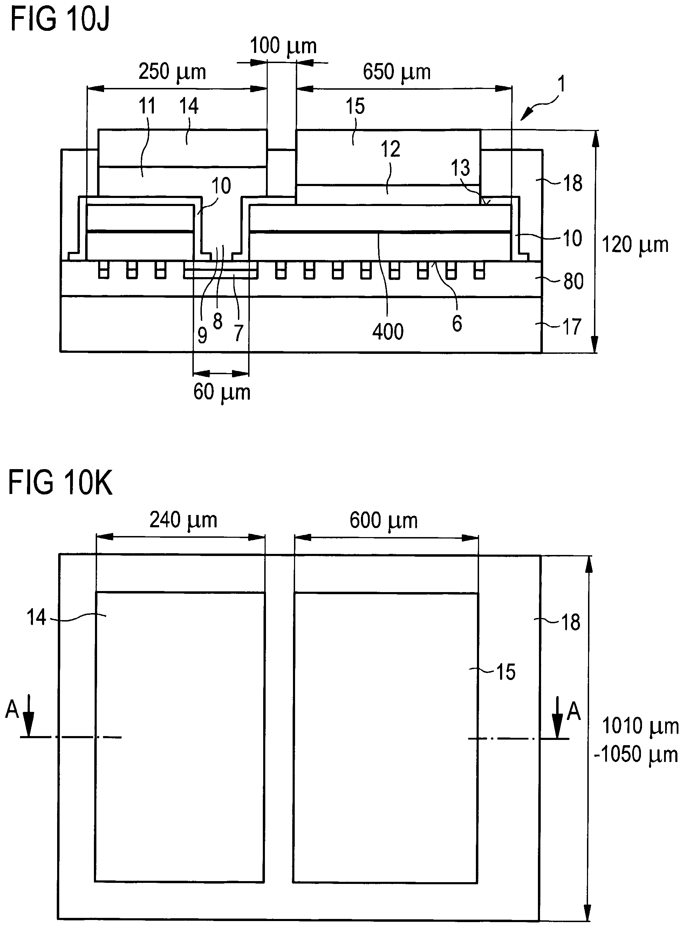

Figur 10 zeigt ein drittes Ausführungsbeispiel eines erfindungsgemäßen Verfahrens zur Herstellung eines optoelektronischen Bauelements anhand von in den Figuren 10a bis 10k schematisch dargestellten Zwischenschritten.

Zunächst wird, wie anhand der schematischen Schnittansicht in Figur 10a dargestellt, eine auf einer Trägerschicht 300 angeordnete Halbleiterschichtenfolge 200, die eine zur Strahlungserzeugung oder zum Strahlungsempfang vorgesehene aktive Zone 400 aufweist, im Waferverbund bereitgestellt.

Die Trägerschicht 300 ist mit Vorzug aus dem Aufwachssubstrat gebildet, auf dem die Halbleiterschichtenfolge 200 epitaktisch gewachsen wurde. Beispielsweise basiert die Halbleiterschichtenfolge auf GaN. Als Aufwachssubstrat ist hierfür beispielsweise eine SiC- oder eine Saphir-Trägerschicht besonders geeignet. Saphirhaltige Aufwachssubstrate sind jedoch verglichen mit siliziumcarbidhaltigen Aufwachssubstraten gewöhnlich kostengünstiger, wobei Saphir jedoch eine oftmals erheblich geringere elektrische Leitfähigkeit als SiC aufweist. Wird die Trägerschicht 300 im Verlauf des Herstellungsverfahrens entfernt und/oder ist die Trägerschicht nicht an der elektrischen Kontaktierung des herzustellenden optoelektronischen Bauelements beteiligt, so wird zweckmäßigerweise ein Saphir-Substrat eingesetzt.

Die Halbleiterschichtenfolge, insbesondere die aktive Zone, enthält mit Vorzug InGaN. Weiterhin kann die aktive Zone zur effizienten Strahlungserzeugung bzw. zum effizienten Strahlungsempfang als Mehrfach-Quantentopfstruktur ausgeführt sein.

Die Dicke der Halbleiterschichtenfolge kann beispielsweise 10 µm oder weniger, vorzugsweise 6 µm oder weniger betragen.

Die Halbleiterschichtenfolge 200 weist weiterhin eine erste Hauptfläche 6 und eine der ersten Hauptfläche bezüglich der aktiven Zone 400 gegenüber liegende zweite Hauptfläche 13 auf, wobei die Halbleiterschichtenfolge 200 seitens der zweiten Hauptfläche 13 auf der Trägerschicht 300 angeordnet ist.

Nachfolgend wird, Figur 10b, eine erste Kontaktschicht 700 auf die der Trägerschicht 300 gegenüber liegenden Seite, insbesondere auf die erste Hauptfläche 6, der Halbleiterschichtenfolge 200 aufgebracht. Bevorzugt wird zunächst eine erste Schicht 710 der ersten Kontaktschicht 700 auf die Halbleiterschichtenfolge aufgebracht, die für die Ausbildung eines elektrischen Kontakts zur Halbleiterschichtenfolge mit Vorteil besonders geeignet ist. Nachfolgend wird auf die erste Schicht eine zweite Schicht 720 der Kontaktschicht 700 aufgebracht, deren Material gegenüber dem der ersten Schicht mit Vorteil vergleichsweise frei gewählt werden kann. Insbesondere kann für die zweite Schicht ein verglichen mit dem Material der ersten Schicht kostengünstigeres Material verwendet werden.

Die erste Schicht 710 ist zwischen der Halbleiterschichtenfolge 200 und der zweiten Schicht 720 angeordnet. Die Kontaktschicht 700 wird beispielsweise mittels Aufdampfen auf die Halbleiterschichtenfolge 200 aufgebracht.

Für die Ausbildung eines guten elektrischen Kontakts zu GaNhaltigen Materialien ist beispielsweise eine Pt-enthaltende oder daraus bestehende erste Schicht 710 besonders geeignet. Zum Ausbilden eines hochwertigen Kontakts kann diese Schicht vergleichsweise dünn ausgeführt sein, etwa mit einer Dicke von 100 nm, vorzugsweise 40 nm, oder weniger. Als zweite Schicht ist beispielsweise eine Au-haltige Schicht besonders geeignet. Au ist verglichen mit Pt vergleichsweise kostengünstig. Die zweite Schicht 720 weist mit Vorzug eine Dicke auf, die größer als die der ersten Schicht 710 ist. Die zweite Schicht 720 bestimmt aufgrund der größeren Dicke mit Vorzug die Stromtragfähigkeit des Kontakts. Die zweite Schicht weist bevorzugt eine Dicke auf, die größer ist als 500 µm, besonders bevorzugt größer als 800 µm. Als besonders geeignet hat sich eine zweite Schicht einer Dicke von 1000 µm erwiesen.

Die Halbleiterschichtenfolge 200 weist mit Vorzug an den beiden bezüglich der aktiven Zone 400 gegenüberliegend angeordneten Seiten unterschiedliche Leitungstypen auf. Beispielsweise ist die Halbleiterschichtenfolge 200 seitens der der Trägerschicht 300 gegenüberliegenden Seite p-leitend und seitens der der Trägerschicht zugewandten Seite n-leitend ausgebildet. Dies kann durch geeignete Dotierung der Halbleiterschichtenfolge, insbesondere während des Epitaxievorgangs, erreicht werden. Für die elektrische Kontaktbildung zu p-leitenden Materialien, die auf GaN basieren, ist Pt besonders geeignet.

Die erste Kontaktschicht 700 wird vorzugsweise vollflächig, auf im wesentlichen die gesamte der Trägerschicht abgewandte Oberfläche der Halbleiterschichtenfolge 200 aufgebracht.

Daraufhin, Figur 10c, wird die Kontaktschicht 700 derart strukturiert, dass eine Mehrzahl von ersten Kontakten 7 ausgebildet wird. Eine derartige Strukturierung kann beispielsweise mittels eines Ätzprozesses, etwa Nass- oder Trockenätzen, und/oder Rücksputtern gegebenenfalls in Kombination mit einer geeignet ausgebildeten Maske, etwa einer Photolack- oder einer Hartmaske, insbesondere einer Metallmaske, erfolgen. Für die Strukturierung einer Auhaltigen zweiten Schicht 720 ist Ätzen, für die Strukturierung einer Pt-haltigen ersten Schicht 710 Rücksputtern besonders geeignet. Insbesondere kann für die Strukturierung der ersten und der zweiten Schicht gegebenenfalls eine gemeinsame Maske verwendet werden.

Weiterhin wird die erste Kontaktschicht 700 bevorzugt derart in erste Kontakte 7 strukturiert, dass im wesentlichen jeder Bereich der Oberfläche der Halbleiterschichtenfolge der für die Oberfläche eines späteren Halbleiterfunktionsbereichs vorgesehen ist, zumindest einen derartigen ersten Kontakt 7 aufweist. Ein beispielhafter Halbleiterfunktionsbereich mit einem ersten Kontakt 7 ist durch die in Figur 10c gestrichelt eingezeichneten Linien eingegrenzt.

Zwei auf der Halbleiterschichtenfolge benachbart angeordnete, vorzugsweise beliebige, erste Kontakte, sind bevorzugt frei von einer direkten elektrisch leitenden Verbindung untereinander. Die ersten Kontakte 7 weisen, insbesondere jeweils, einen Zentralbereich 70 und bevorzugt zumindest einen, besonders bevorzugt eine Mehrzahl von, vom Zentralbereich lateral beabstandeten, elektrisch leitend mit dem Zentralbereich verbundenen Teilbereich(en) 71 auf.

Teilbereiche der vom ersten Kontakt überspannten Oberfläche der Halbleiterschichtenfolge können somit insbesondere frei von einer diese überdeckenden Kontaktstruktur sein, so dass eine Strahlungsauskopplung über diese, vom ersten Kontakt unbedeckten Teilbereiche nicht durch Absorption in dem ersten Kontakt vermindert wird. Gleichzeitig wird über den ersten Kontakt 7 eine flächige vergleichsweise homogene Strominjektion in die aktive Zone 400 erzielt, da eine Mehrzahl von Kontaktstellen, etwa die mittels der Teilbereiche 71 gebildeten Kontaktstellen, zwischen dem ersten Kontakt und der Halbleiterschichtenfolge hergestellt ist. Da GaN-basierende Halbleitermaterialien gewöhnlich eine vergleichsweise geringe Leitfähigkeit in lateraler Richtung aufweisen, sind die Kontaktstellen des ersten Kontakts für eine homogene Bestromung der aktiven Zone in lateraler Richtung vorzugsweise vergleichsweise eng nebeneinander angeordnet. Eine homogene Bestromung der aktiven Zone kann gegebenenfalls auch durch Einsatz einer Stromaufweitungsschicht, die ein strahlungsdurchlässiges leitfähiges Oxid enthält, erzielt werden.

In den Figuren 10d und 10e sind anhand schematischer Teilaufsichten auf die erste Hauptfläche 6 der Halbleiterschichtenfolge 200 zwei Varianten eines ersten Kontakts 7 dargestellt.

Die Teilbereiche 71 sind jeweils über einen Steg 72 mit dem Zentralbereich 70 verbunden.

In der Variante gemäß Figur 10d verbindet ein gemeinsamer Steg 72, die von dem Steg fingerartig, insbesondere beidseitig des Steges, auslaufenden Teilbereiche 71 elektrisch leitend mit dem Zentralbereich.

In der Variante gemäß Figur 10e ist demgegenüber der Teilbereich 71 als den Zentralbereich 70 umlaufender Rahmen ausgeführt, der mit dem Zentralbereich 70 über eine Mehrzahl von Stegen 72, die vom Zentralbereich ausgehend, insbesondere radial, nach außen verlaufen, elektrisch leitend verbunden.

Die gestrichelten Linien in den Figuren 10d und 10e grenzen jeweils einen für die Ausbildung eines Halbleiterfunktionsbereichs vorgesehenen Bereich der Halbleiterschichtenfolge 200 ein.

Alternativ zu den in Figur 10d und 10e gezeigten Ausführungen des Kontakts kann der erste Kontakt 7 auch als Gitterkontakt, etwa in Form eines regulären Gitters, beispielsweise eines Rechteck- oder Quadratgitters, ausgeführt sein. Verschiedene Teilbereiche 71 können sich demnach an Gitterpunkten des Gitters kreuzen. Hierbei ist bevorzugt ein Gitterpunkt als Zentralbereich 70 mit einer verglichen mit der lateralen Ausdehnung der Teilbereiche 71 größeren lateralen Ausdehnung ausgebildet.

Nachfolgend wird, Figur 10f, der Halbleiterschichtenfolge 200 auf ihrer der Trägerschicht 300 abgewandten Seite, insbesondere seitens der ersten Hauptfläche 6, eine Fensterschicht 170, etwa eine Glasplatte, insbesondere eine Borsilikat-Glasplatte, nachgeordnet.

Bevorzugt wird die Fensterschicht 170 mittels einer haftvermittelnden Schicht 800, etwa BCB enthaltend, auf der Halbleiterschichtenfolge 200, insbesondere dem Waferverbund, befestigt.

Bevorzugt ist sowohl die Fensterschicht 170 als auch die haftvermittelnde Schicht 800 strahlungsdurchlässig bezüglich einer von der aktiven Zone 400 zu empfangenden oder zu erzeugenden Strahlung ausgebildet.

Die haftvermittelnde Schicht kann, beispielsweise in flüssiger Phase, etwa mittels Spincoating, auf den Waferverbund oder die Fensterschicht aufgebracht werden.
Nachfolgend wird die Fensterschicht mittels der haftvermittelnden Schicht 800 auf der Halbleiterschichtenfolge befestigt. Die Fensterschicht kann hierzu beispielsweise unter Druckausübung an den mit der haftvermittelnden Schicht versehenen Verbund angedrückt werden. Die haftvermittelnde Schicht 800 zeichnet sich bevorzugt sowohl durch haftvermittelnde Wirkung zur Fensterschicht 170 als auch zur Halbleiterschichtenfolge 200 und/oder dem ersten Kontakt 7 aus. Gegebenenfalls kann die haftvermittelnde Schicht beispielsweise durch ein temperaturgestütztes Verfahren, z.B. durch Erhitzung auf eine Temperatur zwischen 200°C und 300°C, an- oder vollständig ausgehärtet werden. Hierdurch kann die Stabilität der mechanischen Anbindung der Fensterschicht an die Halbleiterschichtenfolge bzw. den Waferverbund erhöht werden.

Die haftvermittelnde Schicht kann eine Dicke von 500 nm oder weniger, vorzugsweise 300 nm oder weniger aufweisen. Eine Dicke von ungefähr 100 nm hat sich als besonders geeignet erwiesen.

Die Fensterschicht 170 kann die Halbleiterschichtenfolge 200 mechanisch derart stabilisieren, dass auf die mechanisch stabilisierende Wirkung der Trägerschicht 300 verzichtet werden kann. Hierzu ist die Fensterschicht zweckmäßigerweise freitragend, insbesondere mit einer geeignet großen Dicke, ausgebildet. Beispielsweise weist die Fensterschicht eine Dicke von 200 µm oder weniger, vorzugsweise von 100 µm oder weniger auf. Die Fensterschicht ist demnach bevorzugt als Stabilisationsschicht ausgeführt.

Aufgrund der nun gegenwärtigen Stabilisationsschicht kann die Trägerschicht 300 nachfolgend abgelöst werden, Figur 10g. Das Ablösen kann beispielsweise mittels eines Laserliftoff-Verfahrens erfolgen. Ein derartiges Verfahren ist für das Ablösen einer saphirhaltigen Trägerschicht von einer GaNhaltigen Halbleiterschichtenfolge besonders geeignet.

Die Halbleiterschichtenfolge 200 ist aufgrund des Ablösens der gesamten Trägerschicht 300 auf ihrer der Stabilisationsschicht abgewandten Seite, insbesondere seitens der zweiten Hauptfläche 13, vollflächig einer direkten Strukturierung ohne vorheriger Durchdringung der Trägerschicht zugänglich.

Alternativ kann gegebenenfalls die Trägerschicht abgedünnt oder bereichsweise entfernt werden, da auf ihre mechanisch stabilisierende Wirkung verzichtet werden kann. Das Ablösen der gesamten Trägerschicht erleichtert dem gegenüber aber mit Vorteil die Ausbildung dünner optoelektronischer Bauelemente.

In einem weiteren Verfahrensschritt, Figur 10g, wird die Halbleiterschichtenfolge, insbesondere von ihrer der Stabilisationsschicht abgewandten Seite her, derart strukturiert, dass eine Mehrzahl von durch Zwischenräume 20 räumlich voneinander getrennten Halbleiterfunktionsbereichen 2 ausgebildet wird. Eine derartige Strukturierung kann mittels Ätzen, etwa Nass- oder Trockenätzen, gegebenenfalls unter Einsatz einer geeignet ausgebildeten Maske, insbesondere einer Photolackmaske, erfolgen. Die Maske kann hierzu auf der zweiten Hauptfläche 13 angeordnet sein und nach der Strukturierung entfernt werden. Für die Ausbildung vergleichsweise enger Zwischenräume, etwa mit einer lateralen Ausdehnung von 50 µm oder weniger ist Trockenätzen besonders geeignet. Mittels Trockenätzen können Strukturen bis ungefähr 10 µm lateraler Abmessung besonders effizient erzeugt werden. Je enger der Zwischenraum ausgeführt ist, desto geringer ist mit Vorteil der strukturierungsbedingte Verlust an Halbleitermaterial.

Weiterhin wird, bevorzugt in einem gemeinsamen Verfahrensschritt mit dem Ausbilden der Halbleiterfunktionsbereiche 2, in den Halbleiterfunktionsbereichen ein Durchbruch durch deren aktive Zonen 400 erzeugt. Bevorzugt ist der Durchbruch als Aussparung 9 im jeweiligen Halbleiterfunktionsbereich 2 ausgebildet. Mit Vorteil kann das Ausbilden der Durchbrüche und der Halbleiterfunktionsbereiche unter Verwendung einer gemeinsamen Maske erfolgen.

Zweckmäßigerweise wird der Durchbruch durch die aktive Zone derart erzeugt, dass die Aussparung 9 von der zweiten Hauptfläche 13 bis zur ersten Hauptfläche 6 reicht und der erste Kontakt 7, insbesondere dessen Zentralbereich 70, den Durchbruch zumindest teilweise, vorzugsweise vollständig, überdeckt. Gegebenenfalls kann hierbei bis in oder an die der ersten Hauptfläche zugewandte erste Schicht des ersten Kontakts 7 strukturiert werden.

Nach dem Ausbilden des Durchbruchs wird von der der Stabilisationsschicht abgewandten Seite des Verbundes her ein Isolationsmaterial 10 auf den Verbund aufgebracht, Figur 10g. Das Isolationsmaterial kann zum Beispiel Si₃N₄ enthalten oder daraus bestehen. Zum Aufbringen des Isolationsmaterials eignet sich beispielsweise besonders Sputtern oder ein PECVD-Verfahren. Vorzugsweise wird das Isolationsmaterial vollflächig auf die der Stabilisationsschicht abgewandten Seite des Verbundes aufgebracht. Beispielsweise bildet das Isolationsmaterial 10 eine Isolationsschicht, insbesondere einer Dicke von weniger als 500 nm, vorzugsweise von 400 nm oder weniger, aus. Eine Dicke von 330 nm hat sich als besonders vorteilhaft erwiesen. Das Isolationsmaterial 10 kleidet die Wand der Aussparung mit Vorzug im wesentlichen vollständig aus und wirkt an den Flanken des Halbleiterfunktionsbereiches schützend und passivierend bezüglich der dort freiliegenden aktiven Zone 400. Bevorzugt ist im wesentlichen die ganze freiliegende Oberfläche der Halbleiterfunktionsbereiche 2, insbesondere die gesamte freiliegende Oberfläche des Verbunds, mit dem Isolationsmaterial 10 überzogen.

Hierauf wird das Isolationsmaterial bereichsweise von dem Verbund entfernt, Figur 10h.

Mit Vorzug wird hierbei zumindest ein Teilbereich des ersten Kontakts 7, insbesondere ein Teilbereich des Zentralbereichs 70, der Halbleiterfunktionsbereiche von dem Isolationsmaterial 10 befreit.

Weiterhin kann auch im Bereich der Zwischenräume 20 das Isolationsmaterial 10 bereichsweise derart vom Verbund entfernt werden, dass die haftvermittelnde Schicht 800 im Bereich der Zwischenräume freigelegt wird. Vorzugsweise wird das Isolationsmaterial im Zwischenraum lateral umlaufend um, insbesondere jeweils, den gesamten Halbleiterfunktionsbereich 2 derart entfernt, dass die haftvermittelnde Schicht 800 umlaufend um den jeweiligen Halbleiterfunktionsbereich 2 freigelegt wird. Die seitlichen Flanken des Halbleiterfunktionsbereichs 2 bleiben jedoch mit Vorzug mit Isolationsmaterial 10 bedeckt und in der Folge geschützt.

Bevorzugt wird weiterhin seitens der zweiten Hauptflächen 13 der Halbleiterfunktionsbereiche 2 das Isolationsmaterial 10 bereichsweise derart entfernt, dass die zweite Hauptfläche 13 des jeweiligen Halbleiterfunktionsbereichs 2 in einem Teilbereich freigelegt wird.

Diese Strukturierungen des Isolationsmaterials 10 können beispielsweise mittels Ätzen, insbesondere Nass- oder Trockenätzen, gegebenenfalls in Kombination mit einer geeignet ausgebildeten Maske erfolgen. Trockenätzen ist hierfür besonders geeignet.

Nach dem Entfernen des Isolationsmaterials wird im seitens der zweiten Hauptfläche 13 vom Isolationsmaterial befreiten Bereich des Halbleiterfunktionsbereichs 2 ein zweiter Anschluss 12, beispielsweise ein Metall wie Ti, Pt, Au, Al, Ag oder eine Legierung mit mindestens einem dieser Materialien enthaltend angeordnet, der mit dem Halbleiterfunktionsbereich seitens der zweiten Hauptfläche direkt elektrisch leitend verbunden ist.

Alternativ zur Darstellung in Figur 10, in der der zweite Anschluss einschichtig ausgebildet ist, kann der zweite Anschluss 12 auch mehrschichtig, mit einer Mehrzahl von Einzelschichten, ausgeführt sein.

In einer bevorzugten Ausgestaltung umfasst der zweite Anschluss eine erste Anschlussschicht, die zur effizienten elektrischen Kontaktbildung seitens der zweiten Hauptfläche 13 zum Halbleitermaterial ausgebildet ist, und eine auf der dem Halbleitermaterial, etwa der dem Halbleiterfunktionsbereich 2, gegenüberliegenden Seite der ersten Anschlussschicht angeordnete zweite Anschlussschicht. Die zweite Anschlussschicht kann die erste Anschlussschicht schützen. Wird auf die der ersten Anschlussschicht abgewandte Seite der zweiten Anschlussschicht beispielsweise eine Lotschicht aufgebracht, mittels derer ein Bauelement mit externen Anschlussmitteln verlötet werden kann, so schützt die zweite Anschlussschicht die erste Anschlussschicht mit Vorteil vor einer Schädigung durch das aufgeschmolzene Lot. Die zweite Anschlussschicht kann demnach als Barriere, insbesondere Lotbarriere, ausgeführt sein. Die Gefahr einer Schädigung des elektrischen Kontaktes der ersten Anschlussschicht zum Halbleitermaterial wird in der Folge verringert.

Die erste Anschlussschicht des zweiten Anschlusses kann beispielsweise zwei Teilschichten, etwa eine erste Teilschicht, die seitens des Halbleitermaterials angeordnet ist und eine zweite Teilschicht, die auf der der ersten Teilschicht gegenüber liegenden Seite des Halbleitermaterials angeordnet ist, umfassen.

Für GaN-basierende Halbleitermaterialien ist eine erste Teilschicht, etwa einer Dicke von 3 nm, aus Ti und eine nachfolgende zweite Teilschicht, etwa einer Dicke von 200 nm, aus Al, besonders geeignet. Eine erste Anschlussschicht welche eine titanhaltige erste Teilschicht und eine aluminiumhaltige zweite Teilschicht aufweist ist weiterhin für die Ausbildung eines effizienten elektrischen Kontaktes zu n-leitenden auf GaN-basierenden Halbleitermaterialien besonders geeignet.

Auch die zweite Anschlussschicht des zweiten Anschlusses kann eine Mehrzahl von Teilschichten aufweisen. Für GaN-basierende Halbleitermaterialien ist eine zweite Anschlussschicht mit drei Teilschichten besonders geeignet. Seitens der ersten Anschlussschicht ist beispielsweise eine, etwa 50 nm dicke, erste Teilschicht aus Ti angeordnet. Auf dieser ersten Teilschicht ist mit Vorzug eine, etwa 100 nm dicke, zweite Teilschicht aus Pt angeordnet, der wiederum eine, etwa 1000 nm dicke, dritte Teilschicht aus Au nachgeordnet ist. Eine derartig ausgebildete zweite Anschlussschicht ist als Lotbarriere besonders geeignet.

Ferner wird im Bereich des Durchbruchs ein Verbindungsleitermaterial 8, beispielsweise ein Metall, etwa Ti, Pt, Au, Al, Ag, Sn oder eine Legierung mit mindestens einem dieser Materialien enthaltend, derart angeordnet, dass das Verbindungsleitermaterial 8 mit dem ersten Kontakt 7 und somit mit der ersten Hauptfläche 6 des Halbleiterfunktionsbereichs 2 elektrisch leitenden verbunden ist. Mit Vorzug ist das Verbindungsleitermaterial mit dem ersten Kontakt in direktem mechanischem Kontakt. Das Verbindungsleitermaterial kann beispielsweise mittels Aufdampfen im Durchbruch angeordnet werden. Als Verbindungsleitermaterial ist Au besonders geeignet.

Die Aussparung 9 wird mit Vorzug derart mit Verbindungsleitermaterial befüllt, dass die Aussparung vollständig ausgefüllt ist und das Verbindungsleitermaterial seitens der zweiten Hauptfläche 13 einen ersten Anschluss 11 ausbildet, der mit Vorzug eine laterale Ausdehnung aufweist, die größer als die des Durchbruchs ist. Der erste Anschluss und der Verbindungsleiter können somit insbesondere einstückig realisiert sein. Das Verbindungsleitermaterial 8 ist von der aktiven Zone ebenso wie der erste Anschluss von der zweiten Hauptfläche 13 über das Isolationsmaterial 10 elektrisch isoliert, so dass ein Kurzschluss der aktiven Zone über das Verbindungsleitermaterial oder der beiden Anschlüsse über die zweite Hauptfläche bei Inbetriebnahme des Bauelements vermieden wird. Ferner sind der erste und der zweite Anschluss seitens der zweiten Hauptfläche 13 angeordnet und in lateraler Richtung voneinander beabstandet.

Entgegen der Darstellung in Figur 10 kann der über das Verbindungsleitermaterial 8 gebildete Verbindungsleiter und/oder der erste Anschluss 11 auch mehrschichtig ausgeführt sein. Bevorzugt ist der Verbindungsleiter einschichtig ausgeführt und/oder enthält beispielsweise Au.

Seitens der zweiten Hauptfläche 13 kann auf dem Verbindungsleiter ein erster Anschluss 11 angeordnet werden, der eine Mehrzahl von Anschlussschichten, etwa gemäß den obigen Ausführungen zum zweiten Anschluss, umfassen kann. Bevorzugt kann jedoch auf eine zweite Anschlussschicht des ersten Anschlusses verzichtet werden, so dass dem Verbindungsleitermaterial seitens der zweiten Hauptfläche nachgeordnet eine erste Anschlussschicht, die eine erste Teilschicht, etwa aus Ti und eine zweite Teilschicht, etwa aus Al, umfasst, nachgeordnet sein.

Das Verbindungsleitermaterial und/oder die Anschlüsse können beispielsweise mittels eines Lift-Off-Prozesses auf den Verbund aufgebracht werden.

In einem darauf folgenden Verfahrensschritt wird eine Verkapselungsschicht 180 auf den Verbund aufgebracht, Figur 10i. Insbesondere wird die Verkapselungsschicht 180 von der der Stabilisationsschicht abgewandten Seite des Verbundes her auf die Halbleiterfunktionsbereiche aufgebracht. Die Verkapselungsschicht umformt die Halbleiterfunktionsbereiche 2. Insbesondere umgreift die Verkapselungsschicht die Halbleiterfunktionsbereiche mit Vorzug zangenartig.

Mit Vorzug ist die Verkapselungsschicht 180 strahlungsdurchlässig ausgebildet, da sie sich in vertikaler Richtung über den Bereich der aktiven Zone 400 erstreckt und somit in der aktiven Zone zu empfangende oder in dieser zu erzeugende Strahlung in erhöhtem Maße auf die Verkapselungsschicht trifft. Absorptionsverluste in der Verkapselungsschicht 180 können so verringert werden.

Bevorzugt wird die Verkapselungsschicht 180, etwa ein BCBenthaltend, mittels Spincoating, insbesondere vollflächig, auf den Verbund aufgebracht und gegebenenfalls, etwa durch Temperaturerhöhung, an- oder vorzugsweise vollständig ausgehärtet. Die Verkapselungsschicht bedeckt bevorzugt die gesamte der Stabilisationsschicht abgewandte Seite des Verbundes und ist insbesondere im Bereich der Zwischenräume 20 angeordnet Weiterhin ist die Verkapselungsschicht 180 mit Vorzug mit der haftvermittelnden Schicht 800 in direktem mechanischen Kontakt.

Um den ersten Anschluss 11 und den zweiten Anschluss 12, die mit der vollflächig aufgebrachten Verkapselungsschicht 180 bedeckt sein können, freizulegen, kann die Verkapselungsschicht im Bereich der Anschlüsse entfernt werden. Das Entfernen kann beispielsweise mittels Ätzen, etwa Trockenätzen unter Einsatz einer geeignet ausgebildeten Hartmaske, etwa einer metallhaltigen, insbesondere einer aluminiumhaltigen oder aus Aluminium bestehenden, Hartmaske, erfolgen. Als Ätzmittel hierfür ist ein Fluor-basierendes Ätzmittel, etwa Freon, besonders geeignet.

Zur Ausbildung einer geeignet strukturierten Hartmaske für den Trockenätzprozess kann beispielsweise zunächst eine Aluminiumschicht vollflächige auf der der Stabilisationsschicht abgewandte Seite des Verbunds, insbesondere auf der Verkapselungsschicht 180, angeordnet werden. Nachfolgend wird eine Photolackschicht auf die dem Halbleiterfunktionsbereich abgewandte Seite der Hartmaske aufgebracht und über geeignete Belichtung und Entwicklung derart strukturiert, dass die Bereiche in denen die Verkapselungsschicht entfernt werden soll frei von Photolack sind. Nachfolgend kann die Aluminiumschicht in den nicht mit Photolack bedeckten Bereichen, beispielsweise über nasschemisches Ätzen, entfernt werden, wodurch die Hartmaske ausgebildet wird. Hierauf kann mittels Trockenätzen die Verkapselungsschicht in den nicht von der Hartmaskenschicht bedeckten Bereichen entfernt werden. Die Hartmaske wird daraufhin mit Vorzug vom Verbund entfernt.

In den freigelegten Bereichen können auf die Anschlüsse Lotschichten 14 und 15, etwa Au oder Sn oder eine Legierung mit wenigstens einem dieser Materialien, z.B. AuSn, enthaltend, aufgebracht werden, die mit dem jeweiligen Anschluss elektrisch leitend verbunden sind. Die Lotschichten können beispielsweise mittels eines Lift-Off-Prozesses aufgebracht werden.

Nachfolgend kann entlang der Linien 21 in gebrauchsfertige, oberflächenmontierbare und, insbesondere hermetisch, verkapselte optoelektronische Bauelemente vereinzelt werden, die unmittelbar nach dem Vereinzeln aus dem Waferverbund auf einer externen Leiterplatte anschließbar sind. Das optoelektronische Bauelement ist insbesondere als Dünnfilm-Bauelement ausgeführt und komplett auf Waferlevel im Scheibenverbund (Waferverbund) hergestellt. Auf kostenintensive Einzelbearbeitungsschritte und Drahtbondungen kann mit Vorteil verzichtet werden.

Bei einer bevorzugten Variante der Vereinzelung werden während des Verfahrens Trennfugen erzeugt, die mit Vorzug von der der den Verbund stabilisierenden Schicht, im vorliegenden Ausführungsbeispiel die Fensterschicht 170, gegenüberliegenden Seite des Verbund bis in die stabilisierende Schicht hineinragen. Beispielsweise werden die Trennfugen im Bereich der Zwischenräume 20 und/oder mittels Trockenätzen erzeugt. Im oben beschriebenen Verfahren werden derartige Trennfugen mit Vorzug derart ausgebildet, dass sie durch die Verkapselungsschicht, die Haftvermittlungsschicht bis in die Fensterschicht hineinreichen, diese jedoch nicht vollständig durchdringen. Die stabilisierende Wirkung der Fensterschicht wird mit Vorzug durch die in diese hineinragende Trennfugen nicht beeinträchtigt. Zum Vereinzeln kann die den Verbund stabilisierende Schicht auf der den Halbleiterfunktionsbereichen gegenüberliegenden Seite abgedünnt werden. Wird die stabilisierende Schicht bis zu den Trennfugen abgedünnt, so wird der Waferverbund in optoelektronische Bauelemente vereinzelt bzw. der Waferverbund zerfällt in optoelektronische Bauelemente, da zwischen den einzelnen Bauelementen dann keine mechanische Verbindung mehr besteht. Eine mechanische Verbindung des Waferverbunds wurde nach dem Ausbilden der Trennfugen und vor dem Vereinzeln mit Vorzug im wesentlichen nur durch die stabilisierende Schicht gewährleistet. Nach dem Abdünnen der stabilisierenden Schicht bis zu den Trennfugen fehlt demnach eine mechanische Verbindung des Verbunds und es werden einzelne optoelektronische Bauelemente ausgebildet. Ein derartiges Trennverfahren eines Verbunds in einzelne Bauteile wird auch als "Trennen durch Abdünnen" (dicing by thinning) bezeichnet. Das Vereinzeln kann insbesondere auf eine Folie erfolgen.

In den Figuren 10j und 10k ist ein derartiges optoelektronisches Bauelement 1 nach dem Vereinzeln in einer Schnittansicht in Figur 10j und einer Aufsicht auf die Lotschichtseite schematisch dargestellt. Figur 10j entspricht einer Schnittansicht entlang der Linie A-A aus Figur 10k.

Die Verkapselung der aktiven Zone 400 des Bauelements wird durch das Teilstück 80, das beim Vereinzeln aus der haftvermittelnde Schicht 80 hervorgeht, und das beim Vereinzeln aus der Verkapselungsschicht 180 hervorgehende Verkapselungselement 18 gebildet. Das beim Vereinzeln aus der Fensterschicht 170 hervorgehende Fenster 17 stabilisiert das Bauelement 1 mit Vorzug mechanisch.

Weiterhin sind in den Figuren 10j und 10k beispielhaft Abmessungen des optoelektronischen Bauteils in µm angegeben. Der Halbleiterfunktionsbereich 2 kann in Aufsicht quadratisch mit einer sich aus Figur 10j ergebenden Kantenlänge von 1000 µm ausgeführt sein. Die Höhe des Bauelements beträgt beispielsweise 120 µm. Nach der Aufsicht in Figur 10k kann die Kantenlänge des gesamten Bauelements, das insbesondere im wesentlichen quadratisch ausgeführt sein kann, 1010 µm bis 1050 µm betragen. Die Angaben in den Figuren 10j und 10k sind selbstverständlich nicht beschränkend, sondern lediglich als beispielhafte Angaben anzusehen.

Der erste Anschluss, der zweite Anschluss und/oder der Verbindungsleiter kann weiterhin für die vom Bauelement zu erzeugende oder zu empfangende Strahlung reflektierend als Spiegelschicht ausgeführt sein, wodurch die Effizienz des Bauelements vorteilhaft erhöht wird.

Alternativ oder ergänzend zu dem Ausführungsbeispiel gemäß Figur 10 können auch weitergehende Abwandlungen etwa gemäß den in den vorherigen Ausführungsbeispielen beschriebenen Bauelementen, Verfahren oder Vorrichtungen in einem entsprechend abgewandelten Verfahren gemäß Figur 10 vorgenommen werden.

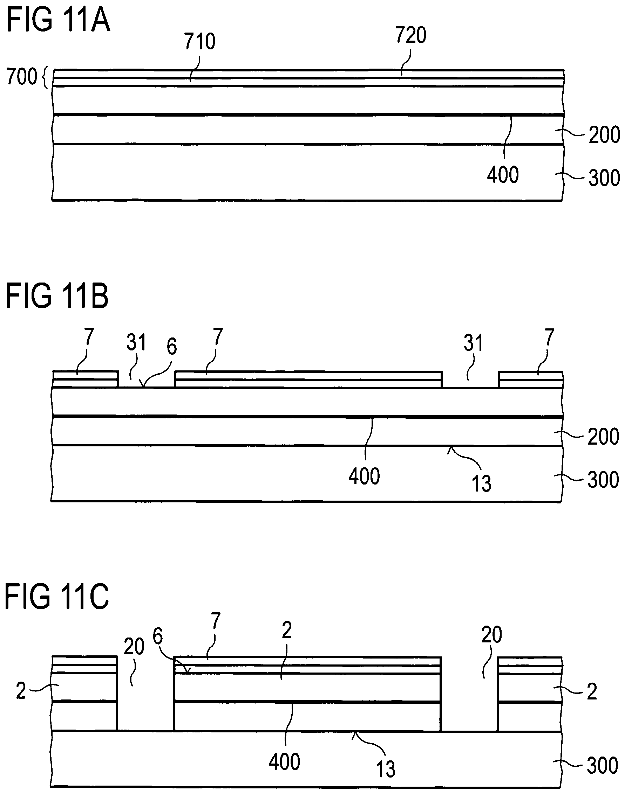

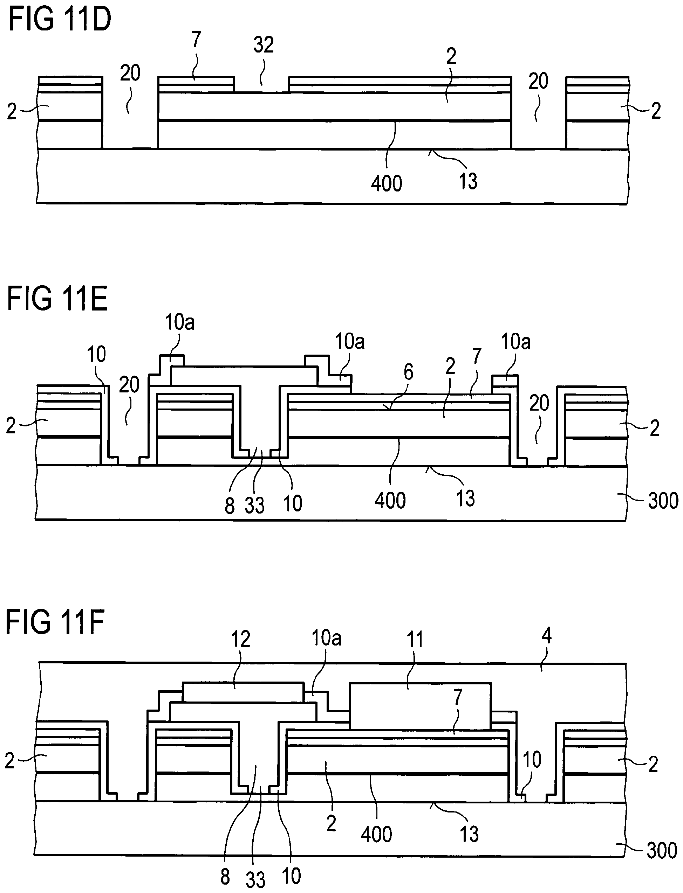

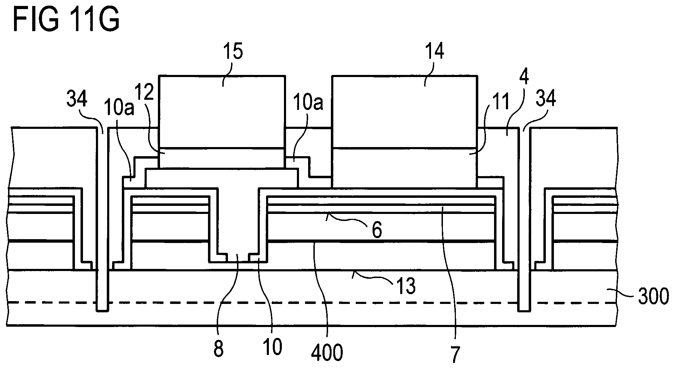

Figur 11 zeigt ein viertes Ausführungsbeispiel eines erfindungsgemäßen Verfahrens zur Herstellung eines optoelektronischen Bauelements anhand von in den Figuren 11a bis 11g schematisch dargestellten Zwischenschritten.

Zunächst wird ein Waferverbund mit einer auf einer Trägerschicht 300 angeordneten Halbleiterschichtenfolge 200 die eine zur Strahlungserzeugung oder zum Strahlungsempfang vorgesehene aktive Zone 400 aufweist, bereitgestellt, Figur 11a. Beispielsweise ist der Waferverbund gemäß den Ausführungen zu Figur 10 ausgebildet.

Auf der der Trägerschicht 300 abgewandten Seite der Halbleiterschichtenfolge 200 wird eine erste Kontaktschicht 700 aufgebracht, die bevorzugt eine erste Schicht 710 und eine zweite Schicht 720 aufweist (vgl. die Ausführungen zu Figur 10).

In einem nachfolgenden Verfahrensschritt wird die erste Kontaktschicht 700 in eine Mehrzahl von der Zwischenräume 31 räumlich voneinander getrennte Bereiche strukturiert, Figur 11b. Hierzu eignet sich beispielsweise Ätzen und/oder Rücksputtern. Während dieser Strukturierung wird insbesondere die der Trägerschicht abgewandte erste Hauptfläche 6 der Halbleiterschichtenfolge 200 im Bereich der Zwischenräume 31 freigelegt. Die Teilbereiche der ersten Kontaktschicht 700 bilden eine Mehrzahl von ersten Kontakten 7 zur Halbleiterschichtenfolge 200 aus. Besonders bevorzugt ist zumindest jedem für die Ausbildung eines Halbleiterfunktionsbereichs vorgesehenen Bereich der Halbleiterschichtenfolge 200 ein erster Kontakt 7 zugeordnet.

Seitens der ersten Hauptfläche 6 ist die Halbleiterschichtenfolge mit Vorzug p-leitend und seitens der der ersten Hauptfläche 6 bezüglich der aktiven Zone 400 gegenüberliegenden zweiten Hauptfläche 13 bevorzugt n-leitend ausgebildet. Die Dicke der p-leitenden Seite, z.B. 0,5 µm, ist mit Vorzug kleiner als die der n-leitenden Seite, z.B. 5 µm.

Nachfolgend wird die Halbleiterschichtenfolge 200, insbesondere in den von der ersten Kontaktschicht 700 befreiten Bereichen, derart strukturiert, dass eine Mehrzahl von nebeneinander auf der Trägerschicht 300 angeordneten Halbleiterfunktionsbereichen 2 ausgebildet wird, Figur 11c. Hierzu eignet sich beispielsweise besonders ein Trockenätzverfahren. Die Halbleiterfunktionsbereiche 2 sind durch Zwischenräume 20 voneinander beabstandet, die sich gegebenenfalls bis in die Trägerschicht 300 erstrecken können.

Nachfolgend, Figur 11d, wird eine Aussparung 32 im ersten Kontakt der Halbleiterfunktionsbereiche ausgebildet. Gegebenfalls kann die Aussparung 32 bereits mit der Ausbildung der Zwischenräume 31 in der ersten Kontaktschicht in einem gemeinsamen Verfahrensschritt, insbesondere unter Benutzung einer gemeinsamen Maske, erfolgen.

Hierauf, Figur 11e, wird ein Durchbruch durch die aktive Zone 400 der Halbleiterfunktionsbereiche 2 erzeugt. Bevorzugt weist im wesentlichen jeder Halbleiterfunktionsbereich zumindest einen Durchbruch auf. Der Durchbruch kann beispielsweise mittels Trockenätzen erzeugt werden. Weiterhin ist der Durchbruch bevorzugt als den Halbleiterfunktionsbereich 2 in vertikaler Richtung nicht vollständig durchdringende Ausnehmung 33 ausgeführt. Der Durchbruch ist somit seitens der zweiten Hauptfläche 13, insbesondere auf der Seite der Trägerschicht 300, in vertikaler Richtung vom Halbleitermaterial des Halbleiterfunktionsbereichs begrenzt. der Durchbruch kann beispielsweise einen Durchmesser von 10 µm aufweisen.

Nach dem Ausbilden des Durchbruchs wird ein Isolationsmaterial 10 von der Trägerschicht 300 abgewandten Seite der Halbleiterfunktionsbereiche, vorzugsweise vollflächig, auf den Waferverbund aufgebracht. Das Isolationsmaterial kleidet die Wand des Durchbruchs, insbesondere im Bereich der aktiven Zone, vorzugsweise jedoch vollständig, aus.

Nachfolgend wird das Isolationsmaterial bereichsweise von dem Verbund entfernt. Hierzu ist beispielsweise ein Trockenätzverfahren in Kombination mit einer geeigneten Maske besonders geeignet. Bei der Entfernung des Isolationsmaterials wird im Bereich des Durchbruchs, insbesondere am Boden der Ausnehmung, ein Halbleitermaterial des Halbleiterfunktionsbereichs 2 freigelegt, das mit Vorzug auf der Seite der aktiven Zone 400 angeordnet ist, die der Eindringstelle des Durchbruchs in den Halbleiterfunktionsbereich 2 gegenüber liegt.

Weiterhin wird bevorzugt das Isolationsmaterial im Bereich der Zwischenräume bereichsweise entfernt. Hierbei kann die Trägerschicht 300 freigelegt werden. Besonders bevorzugt verbleibt das Isolationsmaterial 10 an den Flanken der Halbleiterfunktionsbereiche, so dass diese durch das Isolationsmaterial geschützt sind.

Ferner wird das Isolationsmaterial 10 von dem ersten Kontakt 7 in einem Anschlussbereich entfernt, der vorzugsweise von dem Durchbruch lateral beabstandet ist.

Hierauf wird ein Verbindungsleitermaterial 8 in der Ausnehmung 33 angeordnet. Das Verbindungsleitermaterial 8 tritt mit dem Halbleiterfunktionsbereich, insbesondere am Boden der Ausnehmung, in dem Bereich des Durchbruchs, in dem das Isolationsmaterial 10 entfernt wurde, in leitenden Kontakt. Von der aktiven Zone 400 und der ersten Hauptfläche 6 ist das Verbindungsleitermaterial elektrisch isoliert. Die Ausnehmung wird mit Vorzug derart mit dem Verbindungsleitermaterial 8 befüllt, dass das Verbindungsleitermaterial die Ausnehmung im wesentlichen vollständig ausfüllt und auf der dem Halbleiterfunktionsbereich abgewandten Seite des Isolationsmaterials 10 auf der ersten Hauptfläche 6 des Halbleiterfunktionsbereichs angeordnet ist. Die laterale Ausdehnung des Verbindungsleitermaterials ist seitens der ersten Hauptfläche bevorzugt größer als die laterale Ausdehnung des Durchbruchs.

Nachfolgend wird von der der den Verbund mechanisch stabilisierenden Trägerschicht 300 abgewandten Seite des Verbundes her ein weiteres Isolationsmaterial 10a, vorzugsweise vollflächig, auf den Verbund aufgebracht. Das Isolationsmaterial 10a wird nachfolgend mit Vorzug derart bereichsweise entfernt, dass der erste Kontakt 7, insbesondere im Anschlussbereich, in dem das Isolationsmaterial 10 bereits zuvor entfernt wurde, wieder freigelegt wird. Weiterhin wird das Isolationsmaterial 10a vom Verbindungsleiter entfernt, so dass dieser einer weiteren Prozessierung zugänglich ist.

Vorzugsweise erstreckt sich das weitere Isolationsmaterial 10a in vertikaler Richtung am Rand des Verbindungsleitermaterials. Bevorzugt ist das weitere Isolationsmaterial 10a mit dem Isolationsmaterial 10 im Bereich des Verbindungsleiters in direktem mechanischem Kontakt.

Daraufhin werden ein erster Anschluss 11 und ein zweiter Anschluss 12 derart auf die Halbleiterfunktionsbereiche 2 des Verbundes aufgebracht, dass der erste Anschluss 11 im Anschlussbereich mit dem ersten Kontakt 7 und der zweite Anschluss 12 mit dem Verbindungsleitermaterial 8, insbesondere direkt, elektrisch leitend verbunden ist, Figur 11f. Mit Vorzug ist lediglich der Teilbereich der ersten Kontaktschicht, der zur Kontaktierung mit dem ersten Anschluss 11 vorgesehen ist frei von Isolationsmaterialien 10 und/oder 10a. Der verbleibende Bereich des ersten Kontakts 7 kann mit Isolationsmaterial 10 und/oder 10a bedeckt sein. Der zweite Anschluss 12 kann demnach mit Vorzug verglichen mit dem Verbindungsleiter seitens der ersten Hauptfläche 6 großflächiger ausgebildet werden und ist mittels des Isolationsmaterials 10 und/oder 10a elektrisch vom ersten Kontakt 7 bzw. dem ersten Anschluss 11 isoliert. Insbesondere kann so eine bahnenartige Anschlussstruktur des ersten und/oder zweiten Anschlusses 12 realisiert werden, ohne die Gefahr eines Kurzschlusses maßgeblich zu erhöhen.

Nachfolgend wird eine Umhüllung 4 von der der Trägerschicht 300 abgewandten Seite des Verbundes her auf den Verbund aufgebracht. Beispielsweise wird die Umhüllung aufgeschleudert und/oder enthält BCB. Gegebenenfalls kann die Umhüllung nach dem Aufbringen etwa mittels Erhitzen, insbesondere in einem Ofen, ausgehärtet werden. Bevorzugt überdeckt die Umhüllung 4 den Verbund, besonders bevorzugt vollständig.

Nachfolgend kann die Umhüllung 4 derart strukturiert werden, dass der erste Anschluss 11 und der zweite Anschluss 12 freigelegt werden, Figur 11g.

Hierzu kann beispielsweise gemäß der im Zusammenhang mit Figur 10 beschriebenen Strukturierung der dortigen Verkapselungsschicht 180 vorgegangen werden.

Weiterhin werden bevorzugt Trennfugen 34 ausgebildet, die sich von der der Trägerschicht abgewandten Seite der Umhüllung 4 bis in die den Verbund stabilisierende Trägerschicht 300 hinein erstrecken. Die Trägerschicht wird jedoch mit Vorzug nicht vollständig von den Trennfugen durchdrungen. Insbesondere gewährleistet die Trägerschicht bevorzugt nach wie vor die mechanische Stabilität des Verbundes. Zweckmäßigerweise werden die Trennfugen 34 in einem gemeinsamen Verfahrensschritt, insbesondere unter Verwendung einer gemeinsamen Maske, mit dem Freilegen des ersten und zweiten Anschlusses erzeugt.

Auf den ersten Anschluss 11 und den zweiten Anschluss 12 werden im weiteren Verlauf Lotschichten 14 und 15 aufgebracht.

Nachfolgend kann die Trägerschicht 300 von ihrer den Halbleiterfunktionsbereichen 2 abgewandten Seite her bis zu den Trennfugen 34 oder in diese hinein, z.B. bis zur gestrichelten Linie aus Figur 11g, abgedünnt werden, wodurch eine Vereinzelung des Verbundes in optoelektronische Bauelemente bewirkt wird. Die Trennfugen sind hierzu vorzugsweise umlaufend um die Halbleiterfunktionsbereiche 2 angeordnet.

Gegebenenfalls kann das Vereinzeln auch durch Sägen oder Brechen erfolgen.

Bevorzugt ist die Trägerschicht 300 für die in der aktiven Zone 400 zu erzeugende oder von dieser zu empfangenden Strahlung durchlässig. Saphir beispielsweise ist kostengünstig und strahlungsdurchlässig, insbesondere für mittels GaNbasierender Halbleiter erzeugte Strahlung. Strahlung kann demnach über die Trägerschicht bzw. ein aus dieser beim Vereinzeln gebildetes Trägerschichtstück des Bauelements in das Bauelement ein- oder aus diesem ausgekoppelt werden.

Mit besonderem Vorteil kann der erste Kontakt, der erste Anschluss, der zweite Anschluss und/oder das Verbindungsleitermaterial reflektierend für in der aktiven Zone erzeugte oder von dieser empfangene Strahlung ausgeführt sein. Hierdurch kann die Effizienz des optoelektronischen Bauelements weitergehend erhöht werden. Die genannten Elemente, insbesondere der erste Kontakt, können somit als Spiegelschicht ausgeführt sein.

Die Isolationsmaterialien und/oder die Umhüllung sind bevorzugt strahlungsdurchlässig.

In dem im Zusammenhang mit Figur 11 beschriebenen Verfahren ist eine Entfernung der Trägerschicht 300 nicht notwendigerweise erforderlich, so dass auf einen Verfahrensschritt zur Entfernung der Trägerschicht verzichtet werden kann. Mit Vorteil ist das Verfahren ohne Entfernen der Trägerschicht aufgrund der geringeren Anzahl an Verfahrensschritten gegenüber einem Verfahren bei dem die Trägerschicht entfernt wird kostengünstiger.

Alternativ oder ergänzend zu dem Ausführungsbeispiel gemäß Figur 11 können auch weitergehende Abwandlungen etwa gemäß den in den vorherigen Ausführungsbeispielen beschriebenen Bauelementen, Verfahren oder Vorrichtungen in einem entsprechend abgewandelten Verfahren gemäß Figur 11 vorgenommen werden.

Die vorliegende Patentanmeldung beansprucht die Priorität der deutschen Patentanmeldung DE 10 2004 008 853.5 vom 20. Februar 2004, deren gesamter Offenbarungsgehalt hiermit explizit durch Rückbezug in die vorliegende Patentanmeldung aufgenommen wird.

Die Erfindung ist nicht durch die Beschreibung der Erfindung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Bauelement (1) umfassend einen Halbleiterfunktionsbereich (2) mit einer aktiven Zone (400) und einer lateralen Haupterstreckungsrichtung, wobei
der Halbleiterfunktionsbereich (2) zumindest einen Durchbruch (9, 27, 29) durch die aktive Zone (400) aufweist und im Bereich des Durchbruchs (9, 27, 29) ein Verbindungsleitermaterial (8) angeordnet ist, das von der aktiven Zone (400) zumindest in einem Teilbereich des Durchbruchs (9, 27, 29) elektrisch isoliert ist,
der Halbleiterfunktionsbereich (2) auf einem Träger (3) angeordnet ist,
dem Halbleiterfunktionsbereich (2) eine Spiegelschicht (22) nachgeordnet ist, wobei die Spiegelschicht (22) bezüglich einer von der aktiven Zone (400) zu empfangenden oder zu erzeugenden Strahlung reflektierend ausgebildet ist, und
die Spiegelschicht (22) zwischen dem Träger (3) und der aktiven Zone (400) angeordnet ist, **dadurch gekennzeichnet, dass**
der Durchbruch (9, 27, 29) die Spiegelschicht (22) durchdringt.

2. Optoelektronisches Bauelement nach Anspruch 1,
**dadurch gekennzeichnet, dass**
der Halbleiterfunktionsbereich (2) aus einer epitaktisch aufwachsbaren Schichtstruktur gebildet ist.

3. Optoelektronisches Bauelement nach Anspruch 1 oder 2,
**dadurch gekennzeichnet, dass**
das Verbindungsleitermaterial (8) zumindest teilweise durch ein Isolationsmaterial (10) elektrisch von der aktiven Zone (400) isoliert ist.

4. Optoelektronisches Bauelement nach einem der vorhergehenden Ansprüche,
**dadurch gekennzeichnet, dass**
der Durchbruch (9, 27, 29) als Vertiefung (27) in lateraler Richtung ausgebildet ist.

5. Optoelektronisches Bauelement nach einem der vorhergehenden Ansprüche,
**dadurch gekennzeichnet, dass**
das Isolationsmaterial (10) den Durchbruch (9, 27, 29) zumindest teilweise auskleidet.

6. Optoelektronisches Bauelement nach einem der vorhergehenden Ansprüche,
**dadurch gekennzeichnet, dass**
sich der Durchbruch (9, 27, 29) in vertikaler Richtung durch den gesamten Halbleiterfunktionsbereich (2) erstreckt.

7. Optoelektronisches Bauelement nach einem der vorhergehenden Ansprüche,
**dadurch gekennzeichnet, dass**
der Halbleiterfunktionsbereich (2) eine erste Hauptfläche (6) und eine der ersten Hauptfläche bezüglich der aktiven Zone (400) gegenüberliegende zweite Hauptfläche (13) aufweist und der Halbleiterfunktionsbereich (2) seitens der ersten Hauptfläche mit dem Verbindungsleitermaterial (8) elektrisch leitend verbunden ist.

8. Optoelektronisches Bauelement nach Anspruch 7,
**dadurch gekennzeichnet, dass**
das Verbindungsleitermaterial (8) elektrisch von der zweiten Hauptfläche (13) des Halbleiterfunktionsbereichs (2) isoliert ist.

9. Optoelektronisches Bauelement nach einem der vorhergehenden Ansprüche, **dadurch gekennzeichnet, dass** eine laterale Abmessung des Durchbruchs (9, 27, 29) 100 µm, vorzugsweise 50 µm, oder weniger beträgt.

10. Optoelektronisches Bauelement nach einem der vorhergehenden Ansprüche,
**dadurch gekennzeichnet, dass**
der Halbleiterfunktionsbereich (2) zumindest teilweise von einer Umhüllung (4) umformt ist.

11. Optoelektronisches Bauelement nach Anspruch 10,
**dadurch gekennzeichnet, dass**
die Umhüllung (4) für eine von der aktiven Zone (400) zu erzeugende oder zu empfangende Strahlung durchlässig ist.

12. Optoelektronisches Bauelement nach einem der vorhergehenden Ansprüche,
**dadurch gekennzeichnet, dass**
die aktive Zone (400) von einer Verkapselung (16) umgeben ist, die im wesentlichen hermetisch dicht ist.

13. Optoelektronisches Bauelement nach einem der vorhergehenden Ansprüche,
**dadurch gekennzeichnet, dass** die Spiegelschicht (22) eine metallische Spiegelschicht ist, die Spiegelschicht (22) elektrisch leitend ausgeführt ist und die Spiegelschicht (22) an der Kontaktierung des Bauelements beteiligt ist.

14. Optoelektronisches Bauelement nach Anspruch 13,
**dadurch gekennzeichnet, dass**
sich das Verbindungsleitermaterial (8) bis zu einer dem Halbleiterfunktionsbereich (2) gegenüberliegenden Seite des Trägers erstreckt.

15. Optoelektronisches Bauelement nach einem der vorhergehenden Ansprüche,
**dadurch gekennzeichnet, dass**
das optoelektronische Bauelement oberflächenmontierbar als SMD-Bauelement ausgebildet ist.

16. Vorrichtung mit einer Mehrzahl von optoelektronischen Bauelementen nach einem der vorhergehenden Ansprüche,
**dadurch gekennzeichnet, dass**
die Halbleiterfunktionsbereiche (2) zumindest teilweise in lateraler Richtung nebeneinander angeordnet sind.

17. Vorrichtung nach Anspruch 16 unter mittelbarem oder unmittelbarem Rückbezug auf Anspruch 10,
**dadurch gekennzeichnet, dass**
die Umhüllung (4) einstückig ausgebildet ist und die Halbleiterfunktionsbereiche zumindest teilweise umformt.

18. Vorrichtung nach Anspruch 16 oder 17,
**dadurch gekennzeichnet, dass**
die Halbleiterfunktionsbereiche (2) von einer Stabilisationsschicht (4, 18) mechanisch stabilisiert werden.

19. Vorrichtung nach Anspruch 18,
**dadurch gekennzeichnet, dass**
die Umhüllung (4) als Stabilisationsschicht (500) ausgebildet ist oder Teil der Stabilisationsschicht (500) ist.

20. Vorrichtung nach einem der Ansprüche 16 bis 19,
**dadurch gekennzeichnet, dass**
Anschlüsse (11, 12) der in lateraler Richtung nebeneinander angeordneten optoelektronischen Bauelemente (1) jeweils mit externen Anschlüssen (23, 24) der Vorrichtung leitend verbunden sind.

21. Verfahren zur Herstellung eines optoelektronischen Bauelements nach einem der Ansprüche 1 bis 15, **gekennzeichnet durch** die Schritte,
a) Bereitstellen eines Waferverbunds, der eine auf einer Trägerschicht (300) angeordnete Halbleiterschichtenfolge (200) mit einer aktiven Zone (400) und einer lateralen Haupterstreckungsrichtung umfasst;
b) Strukturieren der Halbleiterschichtenfolge derart, dass zumindest ein Durchbruch (9, 27, 29) durch die aktive Zone entsteht;
c) Anordnen eines Verbindungsleitermaterials (8) im Bereich des Durchbruchs derart, dass die aktive Zone zumindest in einem Teilbereich des Durchbruchs elektrisch vom Verbindungsleitermaterial isoliert ist;
d) Vereinzeln in optoelektronische Bauelemente (1), deren elektrische Kontaktierung zumindest teilweise über das Verbindungsleitermaterial erfolgt.

22. Verfahren nach Anspruch 21,
**dadurch gekennzeichnet, dass**
die aktive Zone (400) über ein Isolationsmaterial (10) von dem Verbindungsleitermaterial (8) elektrisch isoliert wird.

23. Verfahren nach Anspruch 21 oder 22,
**dadurch gekennzeichnet, dass**
das Isolationsmaterial (10) im Bereich des Durchbruchs (9, 27, 29) angeordnet ist.

24. Verfahren nach einem der Ansprüche 21 bis 23,
**dadurch gekennzeichnet, dass**
zumindest eine Vertiefung (27), die die Halbleiterschichtenfolge (200) in lateraler Richtung aufweist, den Durchbruch zumindest teilweise umschließt bzw. der Durchbruch als Vertiefung der Halbleiterschichtenfolge (200) in lateraler Richtung ausgebildet ist.

25. Verfahren nach einem der Ansprüche 21 bis 24,
**dadurch gekennzeichnet, dass**
eine Wand des Durchbruchs (9, 27, 29) zumindest teilweise mit dem Isolationsmaterial ausgekleidet ist.

26. Verfahren nach einem der Ansprüche 21 bis 25,
**dadurch gekennzeichnet, dass**
sich der Durchbruch (9, 27, 29) in vertikaler Richtung durch die gesamte Halbleiterschichtenfolge (200) erstreckt.

27. Verfahren nach einem der Ansprüche 21 bis 26,
**dadurch gekennzeichnet, dass**
der Durchbruch als Aussparung (9) der Halbleiterschichtenfolge (200) ausgebildet ist.

28. Verfahren nach einem der vorhergehenden Ansprüche,
**dadurch gekennzeichnet, dass**
die Halbleiterschichtenfolge (200) derart strukturiert wird, dass eine Mehrzahl von Halbleiterfunktionsbereichen (2) entsteht.

29. Verfahren nach Anspruch 28,
**dadurch gekennzeichnet, dass**
die Halbleiterfunktionsbereiche (2) durch Zwischenräume (20) räumlich voneinander getrennt sind.

30. Verfahren nach Anspruch 28 oder 29,
**dadurch gekennzeichnet, dass**
eine Mehrzahl von Durchbrüchen (9, 27, 29) durch die aktive Zone (400) erzeugt wird und eine Mehrzahl von Halbleiterfunktionsbereichen (2) zumindest einen Durchbruch durch die aktive Zone aufweist.

31. Verfahren nach einem der Ansprüche 28 bis 30,
**dadurch gekennzeichnet, dass**
eine Mehrzahl von Halbleiterfunktionsbereichen (2) jeweils zumindest eine Vertiefung (27) in lateraler Richtung aufweist, die den Durchbruch zumindest teilweise umschließt bzw. bei einer Mehrzahl der Halbleiterfunktionsbereiche (2) der Durchbruch (9, 27, 29) als Vertiefung des jeweiligen Halbleiterfunktionsbereichs (2) in lateraler Richtung ausgebildet ist.

32. Verfahren nach einem der Ansprüche 28 bis 31,
**dadurch gekennzeichnet, dass**
eine Mehrzahl der Halbleiterfunktionsbereiche (2) jeweils zumindest eine laterale, die aktive Zone (400) des entsprechenden Halbleiterfunktionsbereichs begrenzende Seitenfläche (26) aufweist.

33. Verfahren nach Anspruch 32,
**dadurch gekennzeichnet, dass**
die Seitenfläche (26) den entsprechenden Halbleiterfunktionsbereich (2) in lateraler Richtung begrenzt.

34. Verfahren nach einem der Ansprüche 28 bis 33,
**dadurch gekennzeichnet, dass**
das Verbindungsleitermaterial (8) Au, Al, Ag, Ti, Pt, Sn oder eine Legierung mit mindestens einem dieser Materialien enthält.

35. Verfahren nach einem der Ansprüche 21 bis 34,
**dadurch gekennzeichnet, dass**
ein erster elektrischer Kontakt (7) auf die der Trägerschicht (300) abgewandte Seite der Halbleiterschichtenfolge (200) bzw. der Halbleiterfunktionsbereiche (2) aufgebracht wird.

36. Verfahren nach Anspruch 35,
**dadurch gekennzeichnet, dass**
das Verbindungsleitermaterial (8) im Bereich des Durchbruchs (9,27,29) derart angeordnet wird, dass eine elektrisch leitende Verbindung zwischen dem Verbindungsleitermaterial und dem ersten Kontakt (7) ausgebildet wird.

37. Verfahren nach einem der Ansprüche 35 oder 36,
**dadurch gekennzeichnet, dass**
der Durchbruch (9,27,29) derart ausgebildet wird, dass der erste Kontakt (7) von der dem ersten Kontakt gegenüberliegenden Seite der Halbleiterschichtenfolge (200) bzw. des Halbleiterfunktionsbereichs (2) her elektrisch anschließbar ist.

38. Verfahren nach einem der Ansprüche 21 bis 37,
**dadurch gekennzeichnet, dass**
der Halbleiterschichtenfolge (200) oder den Halbleiterfunktionsbereichen (2) auf der der Trägerschicht (300) abgewandten Seite eine Stabilisationsschicht (4, 170, 500) nachgeordnet wird.

39. Verfahren nach Anspruch 38,
**dadurch gekennzeichnet, dass**
die Stabilisationsschicht (4, 170, 500) auf die Halbleiterschichtenfolge (200) oder die Halbleiterfunktionsbereiche (2) aufgebracht wird.

40. Verfahren nach Anspruch 38 oder 39,
**dadurch gekennzeichnet, dass**
die Stabilisationsschicht (4,170,500) der Halbleiterschichtenfolge bzw. den Halbleiterfunktionsbereichen vor dem Ausbilden des Durchbruchs (9,27,29) nachgeordnet wird.

41. Verfahren nach einem der Ansprüche 38 bis 40,
**dadurch gekennzeichnet, dass**
der Durchbruch (9,27,29) von der der Stabilisationsschicht (4,170,500) gegenüberliegenden Seite her in der Halbleiterschichtenfolge bzw. den Halbleiterfunktionsbereichen (2) ausgebildet wird.

42. Verfahren nach einem der Ansprüche 21 bis 41,
**dadurch gekennzeichnet, dass**
der Durchbruch (9,27,29) von der der Trägerschicht gegenüberliegenden Seite her in der Halbleiterschichtenfolge (200) bzw. den Halbleiterfunktionsbereichen (2) ausgebildet wird.

43. Verfahren nach einem der Ansprüche 38, 39, 41 oder 42, **dadurch gekennzeichnet, dass**
die Stabilisationsschicht (4,170,500) der Halbleiterschichtenfolge (200) bzw. den Halbleiterfunktionsbereichen (2) nach dem Ausbilden des Durchbruchs (9,27,29) nachgeordnet wird.

44. Verfahren nach einem der Ansprüche 38 bis 43,
**dadurch gekennzeichnet, dass**
die Stabilisationsschicht (4, 170, 500) die Halbleiterfunktionsbereiche (2) zumindest teilweise umformt.

45. Verfahren nach einem der Ansprüche 38 bis 44,
**dadurch gekennzeichnet, dass**
die Stabilisationsschicht (4, 170, 500) freitragend ist.

46. Verfahren nach einem der Ansprüche 38 bis 45,
**dadurch gekennzeichnet, dass**
die Stabilisationsschicht (4, 170, 500) für eine von der aktiven Zone (400) zu erzeugende oder zu empfangende Strahlung durchlässig ist.

47. Verfahren nach einem der Ansprüche 38 bis 46,
**dadurch gekennzeichnet, dass**
die Stabilisationsschicht (4, 170, 500) zumindest teilweise durch Spincoating vorgesehen wird.

48. Verfahren nach einem der Ansprüche 38 bis 47,
**dadurch gekennzeichnet, dass**
die Stabilisationsschicht (4, 170, 500) zumindest teilweise durch Aufdampfen vorgesehen wird.

49. Verfahren nach einem der Ansprüche 38 bis 48,
**dadurch gekennzeichnet, dass**
die Stabilisationsschicht (4, 170, 500) der Halbleiterschichtenfolge (200) oder den Halbleiterfunktionsbereichen (2) über eine haftvermittelnde Schicht (4) nachgeordnet wird.

50. Verfahren nach einem der Ansprüche 38 bis 49,
**dadurch gekennzeichnet, dass**
die Stabilisationsschicht (4, 170, 500) die Halbleiterschichtenfolge (200) oder die Struktur mit den Halbleiterfunktionsbereichen (2) mechanisch stabilisiert.

51. Verfahren nach einem der Ansprüche 21 bis 50,
**dadurch gekennzeichnet, dass**
die Trägerschicht (300) zumindest teilweise abgedünnt oder entfernt wird.

52. Verfahren nach Anspruch 51,
**dadurch gekennzeichnet, dass**
die Halbleiterschichtenfolge nach dem Abdünnen oder dem Entfernen der Trägerschicht in eine Mehrzahl von Halbleiterfunktionsbereichen strukturiert wird.

53. Verfahren nach einem der Ansprüche 21 bis 52,
**dadurch gekennzeichnet, dass**
die Trägerschicht (300) entsprechend der Anordnung der Halbleiterfunktionsbereiche (2) strukturiert wird, so dass Trägerschichtbereiche entstehen, die zumindest teilweise einen Träger (3) des Halbleiterfunktionsbereichs (2) des optoelektronischen Bauelements (1) bilden.

54. Verfahren nach einem der Ansprüche 21 bis 53,
**dadurch gekennzeichnet, dass**
die Trägerschicht zumindest in einem Teilbereich entfernt wird und der Durchbruch von der der Stabilisationsschicht abgewandten Seite her in der Halbleiterschichtenfolge bzw. den Halbleiterfunktionsbereichen ausgebildet wird.

55. Verfahren nach einem der Ansprüche 21 bis 54,
**dadurch gekennzeichnet, dass**
das optoelektronische Bauelement (1) eine Verkapselung (16) aufweist, die den Halbleiterfunktionsbereich (2) im wesentlichen hermetisch dicht umgibt.

56. Verfahren nach einem der Ansprüche 38 bis 55,
**dadurch gekennzeichnet, dass**
das optoelektronische Bauelement eine Umhüllung (4) aufweist, die den Halbleiterfunktionsbereich (2) zumindest teilweise umhüllt oder umformt und die Umhüllung beim Vereinzeln zumindest teilweise aus der Stabilisationsschicht (4, 170, 500) hervorgeht.

57. Verfahren nach den Ansprüchen 55 und 56,
**dadurch gekennzeichnet, dass**
die Verkapselung (16) die Umhüllung (4) und zumindest ein weiteres Verkapselungselement (18) umfasst.

58. Verfahren nach einem der Ansprüche 21 bis 48,
**dadurch gekennzeichnet, dass**
das Verfahren im Waferverbund durchgeführt wird.

## Claims

1. An optoelectronic component (1) comprising a semiconductor function region (2) with an active zone (400) and a lateral main direction of extension,
wherein
the semiconductor function region (2) is provided with at least one opening (9, 27, 29) through the active zone, and disposed in the region of the opening (9, 27, 29) is a connecting conductor material (8) that is electrically isolated from the active zone (400) at least in a subregion of the opening (9, 27, 29),
the semiconductor function region (2) is arranged on a carrier (3),
a mirror layer (22) is disposed after the semiconductor function region (2), wherein the mirror layer (22) is embodied to be reflective with respect to a radiation to be received or to be generated by the active zone (400), and
the mirror layer (22) is arranged between the carrier (3) and the active zone (400),
**characterized in that**
the opening (9, 27, 29) penetrates the mirror layer (22).

2. The optoelectronic component according to claim 1,
**characterized in that** the semiconductor function region (2) is formed from an epitaxially growable layer structure.

3. The optoelectronic component according to claim 1 or 2,
**characterized in that**
the connecting conductor material (8) is at least partially electrically isolated from the active zone (400) by an isolation material (10).

4. The optoelectronic component according to one of the preceding claims,
**characterized in that**
the opening (9, 27, 29) is configured as a depression (27) in lateral direction.

5. The optoelectronic component according to one of the preceding claims,
**characterized in that**
the isolation material (10) at least partially lines the opening (9, 27, 29).

6. The optoelectronic component according to one of the preceding claims,
**characterized in that**
the opening (9, 27, 29) extends in the vertical direction all the way through the semiconductor function region (2).

7. The optoelectronic component according to one of the preceding claims,
**characterized in that**
the semiconductor function region (2) comprises a first main face (6) and a second main face (13) located oppositely from the first main face relative to the active zone (400), and the semiconductor function region (2) is connected electrically conductively to the connecting conductor material (8) on the side comprising the first main face.

8. The optoelectronic component according to claim 7,
**characterized in that**
the connecting conductor material (8) is electrically isolated from the second main face (13) of the semiconductor function region (2).

9. The optoelectronic component according to one of the preceding claims, **characterized in that**
a lateral dimension of the opening (9, 27, 29) is equal to 100 µm, preferably 50 µm, or less.

10. The optoelectronic component according to one of the preceding claims,
**characterized in that**
an envelope (4) forms at least partially around the semiconductor function region (2).

11. The optoelectronic component according to claim 10,
**characterized in that**
the envelope (4) is transparent to a radiation to be generated or received by the active zone (400).

12. The optoelectronic component according to one of the preceding claims,
**characterized in that**
the active zone (400) is surrounded by an encapsulation (16) that is substantially hermetically tight.

13. The optoelectronic component according to one of the preceding claims,
**characterized in that**
the mirror layer (22) is a metallic mirror layer, the mirror layer (22) is embodied to be electrically conductive and the mirror layer (22) participates in the electrical contacting of the component.

14. The optoelectronic component according to claim 13,
**characterized in that**
the connecting conductor material (8) extends to a side of the carrier that is opposite the semiconductor function region (2).

15. The optoelectronic component according to one of the preceding claims,
**characterized in that**
the optoelectronic component (1) is surface mountable as an SMD component.

16. A device comprising a plurality of optoelectronic components according to one of the preceding claims,
**characterized in that**
the semiconductor function regions (2) are disposed at least partially side by side in lateral direction.

17. The device according to claim 16, referring indirectly or directly to claim 10,
**characterized in that**
the envelope (4) is configured in one piece and at least partially forms around the semiconductor function regions.

18. The device according to claim 16 or 17,
**characterized in that**
the semiconductor function regions (2) are mechanically stabilized by a stabilization layer (4, 18).

19. The device according to claim 18,
**characterized in that**
the envelope (4) is configured as a stabilization layer (500) or part of the stabilization layer (500).

20. The device according to one of claims 16 to 19,
**characterized in that**
terminals (11, 12) of the optoelectronic components (1) arranged in lateral direction side by side are in each case conductively connected to external terminals (23, 24) of the device.

21. A method for producing an optoelectronic component according to one of claims 1 to 15,
**characterized by** the steps of
a) preparing a wafer composite comprising a semiconductor layer sequence (200) that is disposed on a carrier layer (300) and has an active zone (400) and a lateral main direction of extension;
b) structuring the semiconductor layer sequence such that at least one opening (9, 27, 29) through the active zone is produced;
c) disposing a connecting conductor material (8) in the region of the opening or the side face such that the active zone is electrically isolated from the connecting conductor material at least in a subregion of the opening;
d) singulation into optoelectronic components (1) whose electrical contacting is effected at least partially via the connecting conductor material.

22. The method according to claim 21,
**characterized in that**
the active zone (400) is electrically isolated from the connecting conductor material (8) via an isolation material (10).

23. The method according to claim 21 or 22,
**characterized in that**
the isolation material (10) is disposed in the region of the opening (9, 27, 29).

24. The method according to one of claims 21 to 23,
**characterized in that**
at least one depression (27) provided in the semiconductor layer sequence (200) in the lateral direction at least partially surrounds the opening or the opening is configured as a depression in the semiconductor layer sequence (200) in the lateral direction.

25. The method according to one of claims 21 to 24,
**characterized in that**
a wall of the opening (9, 27, 29) is at least partially covered with the isolation material.

26. The method according to one of claims 21 to 25,
**characterized in that**
the opening (9, 27, 29) extends in the vertical direction all the way through the semiconductor layer sequence (200).

27. The method according to one of claims 21 to 26,
**characterized in that**
the opening is configured as a cut-out (9) in the semiconductor layer sequence (200).

28. The method according to one of the preceding claims,
**characterized in that**
the semiconductor layer sequence (200) is structured such that a plurality of semiconductor function regions (2) is produced.

29. The method according to claim 28,
**characterized in that**
the semiconductor function regions (2) are spatially separated from one another by interspaces (20).

30. The method according to claim 28 or 29,
**characterized in that**
a plurality of openings (9, 27, 29) through the active zone (400) is produced and a plurality of semiconductor function regions (2) comprises at least one opening through the active zone.

31. The method according to one of claims 28 to 30,
**characterized in that**
a plurality of semiconductor function regions (2) each comprise at least one depression (27) in the lateral direction that at least partially surrounds the opening, or, if a plurality of semiconductor function regions (2) is present, the opening (9, 27, 29) is configured as a depression in the lateral direction in the semiconductor function region (2) concerned.

32. The method according to one of claims 28 to 31,
**characterized in that**
a plurality of the semiconductor function regions (2) each comprise at least one lateral side face (26) bounding the active zone (400) of the corresponding semiconductor function region.

33. The method according to claim 32,
**characterized in that**
the side face (26) bounds the corresponding semiconductor function region (2) in the lateral direction.

34. The method according to one of claims 28 to 33,
**characterized in that**
the connecting conductor material (8) comprises Au, Al, Ag, Ti, Pt, Sn or an alloy with at least one of the materials.

35. The method according to one of claims 21 to 34,
**characterized in that**
a first electrical contact (7) is applied to the side of the semiconductor layer sequence (200) facing away from the carrier layer (300), or to the semiconductor function regions (2).

36. The method according to claim 35,
**characterized in that**
the connecting conductor material (8) is disposed in the region of the opening (9, 27, 29) such that an electrically conductive connection is formed between the connecting conductor material and the first contact (7).

37. The method according to claim 35 or 36,
**characterized in that**
the opening (9, 27, 29) is configured such that the first contact (7) can be connected electrically from the side of the semiconductor layer sequence (200) or of the semiconductor function region (2) located oppositely from that comprising the first contact.

38. The method according to one of claims 21 to 37,
**characterized in that**
a stabilization layer (4, 170, 500) is disposed after the semiconductor layer sequence (200) or the semiconductor function regions (2) on the side facing away from the carrier layer (300).

39. The method according to claim 38,
**characterized in that**
the stabilization layer (4, 170, 500) is applied to the semiconductor layer sequence (200) or the semiconductor function regions (2).

40. The method according to claim 38 or 39,
**characterized in that**
the stabilization layer (4, 170, 500) is disposed after the semiconductor layer sequence or the semiconductor function regions prior to the formation of the opening (9, 27, 29).

41. The method according to one of claims 38 to 40,
**characterized in that**
the opening (9, 27, 29) is formed in the semiconductor layer sequence or the semiconductor function regions (2) from the side opposite that comprising the stabilization layer (4, 170, 500).

42. The method according to one of claims 21 to 41,
**characterized in that**
the opening (9, 27, 29) is formed in the semiconductor layer sequence (200) or the semiconductor function regions (2) from the side opposite that comprising the carrier layer.

43. The method according to one of claims 38, 39, 41 or 42,
**characterized in that**
the stabilization layer (4, 170, 500) is disposed after the semiconductor layer sequence (200) or the semiconductor function regions (2) after the creation of the opening (9, 27, 29).

44. The method according to one of claims 38 to 43,
**characterized in that**
the stabilization layer (4, 170, 500) forms at least partially around the semiconductor function regions (2).

45. The method according to one of claims 38 to 44,
**characterized in that**
the stabilization layer (4, 170, 500) is self-supporting.

46. The method according to one of claims 38 to 45,
**characterized in that**
the stabilization layer (4, 170, 500) is transparent to a radiation that is to be generated or received by the active zone (400).

47. The method according to one of claims 38 to 46,
**characterized in that**
the stabilization layer (4, 170, 500) is provided at least in part by spin coating.

48. The method according to one of claims 38 to 47,
**characterized in that**
the stabilization layer (4, 170, 500) is provided at least in part by vapor deposition.

49. The method according to one of claims 38 to 48,
**characterized in that**
the stabilization layer (4, 170, 500) is disposed after the semiconductor layer sequence (200) or the semiconductor function regions (2) via an adhesion-promoting layer (4).

50. The method according to one of claims 38 to 49,
**characterized in that**
the stabilization layer (4, 170, 500) mechanically stabilizes the semiconductor layer sequence (200) or the structure comprising the semiconductor function regions (2).

51. The method according to one of claims 21 to 50,
**characterized in that**
the carrier layer (300) is at least partially thinned or removed.

52. The method according to claim 51,
**characterized in that**
following the thinning or removal of the carrier layer, the semiconductor layer sequence is structured into a plurality of semiconductor function regions.

53. The method according to one of claims 21 to 52,
**characterized in that**
the carrier layer (300) is structured according to the arrangement of semiconductor function regions (2), so that carrier layer regions are formed, that form at least partly a carrier (3) of the semiconductor function region (2) of the optoelectronic component (1).

54. The method according to one of claims 21 to 53,
the carrier layer is removed at least in a subregion and the opening or the side face is formed in the semiconductor layer sequence or the semiconductor function regions from the side facing away from the stabilization layer.

55. The method according to one of claims 21 to 54,
**characterized in that**
the optoelectronic component (1) is provided with an encapsulation (16) that substantially hermetically tightly surrounds the semiconductor function region (2).

56. The method according to one of claims 38 to 55,
**characterized in that**
the optoelectronic component is provided with an envelope (4) that at least partially envelops or forms around the semiconductor function region (2), and on singulation the envelope derives at least in part from the stabilization layer (4, 170, 500).

57. The method according to claims 55 and 56,
**characterized in that**
the encapsulation (16) comprises the envelope (4) and at least one additional encapsulating element (18).

58. The method according to one of claims 21 to 48,
**characterized in that**
the method is performed in a wafer assembly.

## Revendications

1. Composant optoélectronique (1) comprenant une zone fonctionnelle à semi-conducteurs (2) avec une zone active (400) et d'une direction d'étendue principale latérale, la zone fonctionnelle à semi-conducteurs (2) présentant au moins un passage (9, 27, 29) à travers la zone active (400) et un matériau conducteur de liaison (8) étant disposé au niveau du passage (9, 27, 29), lequel est électriquement isolé de la zone active (400) au moins dans une zone partielle du passage (9, 27, 29),
la zone fonctionnelle à semi-conducteurs (2) étant disposée sur un support (3),
une couche réfléchissante (22) étant disposée en aval de la zone fonctionnelle à semi-conducteurs (2), la couche réfléchissante (22) étant conçue de manière réfléchissante en ce qui concerne un rayonnement à générer ou à recevoir par la zone active (400), et
la couche réfléchissante (22) étant disposée entre le support (3) et la zone active (400), **caractérisé en ce que**
le passage (9, 27, 29) traverse la couche réfléchissante (22).

2. Composant optoélectronique selon la revendication 1,
**caractérisé en ce que**
la zone fonctionnelle à semi-conducteurs (2) est formée par une structure en couches pouvant croître par épitaxie.

3. Composant optoélectronique selon la revendication 1 ou 2,
**caractérisé en ce que**
le matériau conducteur de liaison (8) est électriquement isolé de la zone active (400) au moins en partie au moyen d'un matériau isolant (10).

4. Composant optoélectronique selon l'une quelconque des revendications précédentes,
**caractérisé en ce que**
le passage (9, 27, 29) est réalisé comme un creux (27) en direction latérale.

5. Composant optoélectronique selon l'une quelconque des revendications précédentes,
**caractérisé en ce que**
le matériau isolant (10) revêtit le passage (9, 27, 29) au moins en partie.

6. Composant optoélectronique selon l'une quelconque des revendications précédentes,
**caractérisé en ce que**
le passage (9, 27, 29) s'étend à travers de toute la zone fonctionnelle à semi-conducteurs (2) en direction verticale.

7. Composant optoélectronique selon l'une quelconque des revendications précédentes,
**caractérisé en ce que**
la zone fonctionnelle à semi-conducteurs (2) présente une première surface principale (6) et une deuxième surface principale (13) opposée à la première surface principale par rapport à la zone active (400) et **en ce que** la zone fonctionnelle à semi-conducteurs (2) est reliée de manière électro-conductrice au matériau conducteur de liaison (8) du côté de la première surface principale.

8. Composant optoélectronique selon la revendication 7,
**caractérisé en ce que**
le matériau conducteur de liaison (8) est électriquement isolé de la deuxième surface (13) de la zone fonctionnelle à semi-conducteurs (2).

9. Composant optoélectronique selon l'une quelconque des revendications précédentes,
**caractérisé en ce qu'**
une dimension latérale du passage (9, 27, 29) est de 100 µm, de préférence de 50 µm, ou moins.

10. Composant optoélectronique selon l'une quelconque des revendications précédentes,
**caractérisé en ce que**
la zone fonctionnelle à semi-conducteurs (2) est enrobée au moins en partie par une enveloppe (4).

11. Composant optoélectronique selon la revendication 10,
**caractérisé en ce que**
l'enveloppe (4) est perméable à un rayonnement à recevoir ou à générer par la zone active (400).

12. Composant optoélectronique selon l'une quelconque des revendications précédentes,
**caractérisé en ce que**
la zone active (400) est entourée par un encapsulage (16) qui est essentiellement hermétiquement étanche.

13. Composant optoélectronique selon l'une quelconque des revendications précédentes,
**caractérisé en ce que**
la couche réfléchissante (22) est une couche réfléchissante métallique, **en ce que** la couche réfléchissante (22) est conçue de manière électro-conductrice et **en ce que** la couche réfléchissante (22) participe à la mise en contact du composant.

14. Composant optoélectronique selon la revendication 13,
**caractérisé en ce que**
le matériau composant à conducteur (8) s'étend jusqu'à un côté du support opposé à la zone fonctionnelle à semi-conducteurs (2).

15. Composant optoélectronique selon l'une quelconque des revendications précédentes,
**caractérisé en ce que**
le composant optoélectronique est conçu comme composant SMD de manière à pouvoir être monté en surface.

16. Dispositif comprenant une pluralité de composants optoélectroniques selon l'une quelconque des revendications précédentes,
**caractérisé en ce que**
les zones fonctionnelles à semi-conducteurs (2) sont disposées au moins en partie les unes à côté des autres en direction latérale.

17. Dispositif selon la revendication 16 avec référence indirect ou direct à la revendication 10,
**caractérisé en ce que**
l'enveloppe (4) est réalisée de façon monobloc et enrobe au moins en partie les zones fonctionnelles à semi-conducteurs.

18. Dispositif selon la revendication 16 ou 17,
**caractérisé en ce que**
les zones fonctionnelles à semi-conducteurs (2) sont mécaniquement stabilisées par une couche de stabilisation (4, 18).

19. Dispositif selon la revendication 18,
**caractérisé en ce que**
l'enveloppe (4) est conçue comme couche de stabilisation (500) ou fait partie de la couche de stabilisation (500).

20. Dispositif selon l'une quelconque des revendications 16 à 19,
**caractérisé en ce que**
des raccords (11, 12) des composants optoélectroniques (1) disposés les uns à côté des autres en direction latérale sont respectivement reliés de manière conductrice à des raccords externes (23, 24) du dispositif.

21. Procédé de fabrication d'un composant optoélectronique selon l'une quelconque des revendications 1 à 15,
**caractérisé par** les étapes
a) fourniture d'une tranche composite qui comprend une succession de couches à semi-conducteurs (200), disposée sur une couche de support (300) et ayant une zone active (400) et une direction d'étendue principale latérale ;
b) structuration de la succession de couches à semi-conducteurs de manière à ce qu'au moins un passage (9, 27, 29) soit obtenu à travers la zone active ;
c) disposition d'un matériau conducteur de liaison (8) au niveau du passage de manière à ce que la zone active soit électriquement isolée du matériau conducteur de liaison au moins dans une zone partielle du passage ;
d) individualisation en composants optoélectroniques (1) dont le contact électrique est réalisée au moins en partie par l'intermédiaire du matériau conducteur de liaison.

22. Procédé selon la revendication 21,
**caractérisé en ce que**
la zone active (400) est électriquement isolée du matériau conducteur de liaison (8) par l'intermédiaire du matériau isolant (10).

23. Procédé selon la revendication 21 ou 22,
**caractérisé en ce que**
le matériau isolant (10) est disposé dans la zone du passage (9, 27, 29).

24. Procédé selon l'une quelconque des revendications 21 à 23,
**caractérisé en ce qu'**
au moins un creux (27), présentant la succession de couches à semi-conducteurs (200) en direction latérale, entoure le passage au moins en partie ou **en ce que** le passage est réalisé comme creux de la succession de couches à semi-conducteurs (200) en direction latérale.

25. Procédé selon l'une quelconque des revendications 21 à 24,
**caractérisé en ce qu'**
une paroi du passage (9, 27, 29) est revêtue au moins en partie par le matériau isolant.

26. Procédé selon l'une quelconque des revendications 21 à 25,
**caractérisé en ce que**
le passage (9, 27, 29) s'étend à travers toute la succession de couches à semi-conducteurs (200) en direction verticale.

27. Procédé selon l'une quelconque des revendications 21 à 26,
**caractérisé en ce que**
le passage est réalisé comme évidement (9) de la succession de couches à semi-conducteurs (200).

28. Procédé selon l'une quelconque des revendications précédentes,
**caractérisé en ce que**
la succession de couches à semi-conducteurs (200) est structurée de manière à ce qu'une pluralité de zones fonctionnelles à semi-conducteurs (2) soit obtenue.

29. Procédé selon la revendication 28,
**caractérisé en ce que**
les zones fonctionnelles à semi-conducteurs (2) sont spatialement séparées les unes des autres par des espaces intermédiaires (20).

30. Procédé selon la revendication 28 ou 29,
**caractérisé en ce qu'**
une pluralité de passages (9, 27, 29) est générée à travers la zone active (400) et **en ce qu'**une pluralité de zones fonctionnelles à semi-conducteurs (2) présente au moins un passage à travers la zone active.

31. Procédé selon l'une quelconque des revendications 28 à 30,
**caractérisé en ce qu'**
une pluralité de zones fonctionnelles à semi-conducteurs (2) présente respectivement au moins un évidement (27) en direction latérale, lequel entoure le passage au moins en partie ou **en ce que** dans une pluralité des zones fonctionnelles à semi-conducteurs (2), le passage (9, 27, 29) est réalisé comme creux de la zone fonctionnelle à semi-conducteurs (2) respective en direction latérale.

32. Procédé selon l'une quelconque des revendications 28 à 31,
**caractérisé en ce qu'**
une pluralité de zones fonctionnelles à semi-conducteurs (2) présente respectivement au moins une surface latérale (26) délimitant la zone active (400) de la zone fonctionnelle à semi-conducteurs correspondante.

33. Procédé selon la revendication 32,
**caractérisé en ce que**
la surface latérale (26) délimite la zone fonctionnelle à semi-conducteurs (2) correspondante en direction latérale.

34. Procédé selon l'une quelconque des revendications 28 à 33,
**caractérisé en ce que**
le matériau conducteur de liaison (8) contient de l'Au, Al, Ag, Ti, Pt, Sn ou un alliage comprenant au moins un de ces matériaux.

35. Procédé selon l'une quelconque des revendications 21 à 34,
**caractérisé en ce qu'**
un premier contact électrique (7) est appliqué sur le côté, détourné de la couche de support (300), de la succession de couches à semi-conducteurs (200) ou des zones fonctionnelles à semi-conducteurs (2).

36. Procédé selon la revendication 35,
**caractérisé en ce que**
le matériau conducteur de liaison (8) est disposé au niveau du passage (9, 27, 29) de manière à ce qu'une liaison électroconductrice soit réalisée entre le matériau conducteur de liaison et le premier contact (7).

37. Procédé selon l'une quelconque des revendications 35 ou 36,
**caractérisé en ce que**
le passage (9, 27, 29) est conçu de manière à ce que le premier contact (7) puisse être électriquement connecté depuis le côté, opposé au premier contact, de la succession de couches à semi-conducteurs (200) ou de la zone fonctionnelle à semi-conducteurs (2).

38. Procédé selon l'une quelconque des revendications 21 à 37,
**caractérisé en ce qu'**
une couche de stabilisation (4, 170, 500) est disposée en aval de la succession de couches (200) à semi-conducteurs ou des zones fonctionnelles à semi-conducteurs (2) sur le côté détourné de la couche de support (300).

39. Procédé selon la revendication 38,
**caractérisé en ce que**
la couche de stabilisation (4, 170, 500) est appliquée sur la succession de couches à semi-conducteurs (200) ou sur les zones fonctionnelles à semi-conducteurs (2).

40. Procédé selon la revendication 38 ou 39,
**caractérisé en ce que**
la couche de stabilisation (4, 170, 500) est disposée en aval de la succession de couches à semi-conducteurs ou des zones fonctionnelles à semi-conducteurs avant la réalisation du passage (9, 27, 29).

41. Procédé selon l'une quelconque des revendications 38 à 40,
**caractérisé en ce que**
le passage (9, 27, 29) est réalisé dans la succession de couches à semi-conducteurs ou dans les zones fonctionnelles à semi-conducteurs (2) depuis le côté opposé à la couche de stabilisation (4, 170, 500).

42. Procédé selon l'une quelconque des revendications 21 à 41,
**caractérisé en ce que**
le passage (9, 27, 29) est réalisé dans la succession de couches à semi-conducteurs (200) ou dans les zones fonctionnelles à semi-conducteurs (2) depuis le côté opposé à la couche de support.

43. Procédé selon l'une quelconque des revendications 38, 39, 41 ou 42,
**caractérisé en ce que**
la couche de stabilisation (4, 170, 500) est disposée en aval de la succession de couches à semi-conducteurs (200) ou des zones fonctionnelles à semi-conducteurs (2) après la réalisation du passage (9, 27, 29).

44. Procédé selon l'une quelconque des revendications 38 à 43,
**caractérisé en ce que**
la couche de stabilisation (4, 170, 500) enrobe au moins en partie les zones fonctionnelles à semi-conducteurs (2).

45. Procédé selon l'une quelconque des revendications 38 à 44,
**caractérisé en ce que**
la couche de stabilisation (4, 170, 500) est autoportante.

46. Procédé selon l'une quelconque des revendications 38 à 45,
**caractérisé en ce que**
la couche de stabilisation (4, 170, 500) est perméable à un rayonnement à générer ou à recevoir par la zone active (400).

47. Procédé selon l'une quelconque des revendications 38 à 46,
**caractérisé en ce que**
la couche de stabilisation (4, 170, 500) est pourvue au moins en partie par moyen de revêtement par centrifugation.

48. Procédé selon l'une quelconque des revendications 38 à 47,
**caractérisé en ce que**
la couche de stabilisation (4, 170, 500) est pourvue au moins en partie par évaporation.

49. Procédé selon l'une quelconque des revendications 38 à 48,
**caractérisé en ce que**
la couche de stabilisation (4, 170, 500) est disposée en aval de la succession de couches à semi-conducteurs (200) ou des zones fonctionnelles à semi-conducteurs (2) par l'intermédiaire d'une couche adhésive (4).

50. Procédé selon l'une quelconque des revendications 38 à 49,
**caractérisé en ce que**
la couche de stabilisation (4, 170, 500) stabilise mécaniquement la succession de couches à semi-conducteurs (200) ou la structure comprenant les zones fonctionnelles à semi-conducteurs (2).

51. Procédé selon l'une quelconque des revendications 21 à 50,
**caractérisé en ce que**
la couche de support (300) est amincie au moins en partie ou est retirée.

52. Procédé selon la revendication 51,
**caractérisé en ce que**
la succession de couches à semi-conducteurs, après l'amincissement ou le retrait de la couche de support, est structurée en une pluralité des zones fonctionnelles à semi-conducteurs.

53. Procédé selon l'une quelconque des revendications 21 à 52,
**caractérisé en ce que**
la couche de support (300) est structurée de manière correspondant à la disposition des zones fonctionnelles à semi-conducteurs (2), de sorte que des zones de couche de support sont obtenues, lesquelles forment au moins en partie un support (3) de la zone fonctionnelle à semi-conducteurs (2) du composant optoélectronique (1).

54. Procédé selon l'une quelconque des revendications 21 à 53,
**caractérisé en ce que**
la couche de support est retirée au moins dans une zone partielle et **en ce que** le passage est réalisé dans la succession de couches à semi-conducteurs ou dans les zones fonctionnelles à semi-conducteurs depuis le côté détourné de la couche de stabilisation.

55. Procédé selon l'une quelconque des revendications 21 à 54,
**caractérisé en ce que**
le composant optoélectronique (1) présente un encapsulage (16) qui entoure la zone fonctionnelle à semi-conducteurs (2) essentiellement de manière hermétiquement étanche.

56. Procédé selon l'une quelconque des revendications 38 à 55,
**caractérisé en ce que**
le composant optoélectronique (1) présente une enveloppe (4) qui enveloppe ou enrobe au moins en partie la zone fonctionnelle à semi-conducteurs (2) et **en ce que** l'enveloppe fait saillie au moins en partie hors de la couche de stabilisation (4, 170, 500) lors de la séparation.

57. Procédé selon les revendications 55 et 56,
**caractérisé en ce que**
l'encapsulage (16) comprend l'enveloppe (4) et au moins un élément d'encapsulage (18) supplémentaire.

58. Procédé selon l'une quelconque des revendications 21 à 48,
**caractérisé en ce que**
le procédé est réalisé en tranches composites.
